(19) **Europäisches Patentamt / European Patent Office / Office européen des brevets**

(11) **EP 4 347 522 B1**

(12) **FASCICULE DE BREVET EUROPEEN**

(45) Date de publication et mention de la délivrance du brevet:
**22.07.2026 Bulletin 2026/30**

(21) Numéro de dépôt: **22730435.9**

(22) Date de dépôt: **23.05.2022**

(51) Classification Internationale des Brevets (IPC):
**C03C 17/34** *(2006.01)* **F25B 23/00** *(2006.01)*
**G02B 5/20** *(2006.01)* **G02B 5/26** *(2006.01)*

(52) Classification Coopérative des Brevets (CPC):
**F25B 23/003; C03C 17/3441;** C03C 2217/734;
G02B 5/208

(86) Numéro de dépôt international:
**PCT/EP2022/063924**

(87) Numéro de publication internationale:
**WO 2022/248413 (01.12.2022 Gazette 2022/48)**

(54) **DISPOSITIF RADIATIF DIURNE**

TAGSTRAHLUNGSVORRICHTUNG

DAYTIME RADIATIVE DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **24.05.2021 FR 2105377**

(43) Date de publication de la demande:
**10.04.2024 Bulletin 2024/15**

(73) Titulaires:
- **Centre National de la Recherche Scientifique**
  **75016 Paris (FR)**
- **Commissariat à l'Energie Atomique et aux Energies**
  **Alternatives**
  **75015 Paris (FR)**
- **Université de Caen Normandie**
  **14000 Caen (FR)**
- **Ecole Nationale Supérieure d'Ingénieurs de Caen**
  **14050 Caen (FR)**

(72) Inventeurs:
- **CARDIN, Julien**
  **14112 Biéville-Beuville (FR)**
- **DAOU, Ramzy**
  **14000 Caen (FR)**
- **FRILAY, Cédric**
  **14280 Authie (FR)**
- **GOURBILLEAU, Fabrice**
  **31400 Toulouse (FR)**
- **WEIMMERSKIRCH-AUBATIN, Jennifer**
  **26000 Valence (FR)**
- **HORCHOLLE, Bryan**
  **50590 Regnéville sur Mer (FR)**

(74) Mandataire: **Santarelli**
  **Tour Trinity**
  **1 bis Place de la Défense**
  **92400 Courbevoie (FR)**

(56) Documents cités:
WO-A1-2019/130199    CN-B- 110 274 326
US-A1- 2015 338 175

- ALIM NUSRAT ET AL: "Planar Structure with High Spectrally-Selective Emittance for Passive Radiative Cooling", 2020 IEEE PHOTONICS CONFERENCE (IPC), IEEE, 28 September 2020 (2020-09-28), pages 1 - 2, XP033857403, DOI: 10.1109/IPC47351.2020.9252380
- JEONG SHIN YOUNG ET AL: "Field investigation of a photonic multi-layered TiO2 passive radiative cooler in sub-tropical climate", RENEWABLE ENERGY, PERGAMON PRESS, OXFORD, GB, vol. 146, 26 June 2019 (2019-06-26), pages 44 - 55, XP085904431, ISSN: 0960-1481, [retrieved on 20190626], DOI: 10.1016/ J.RENENE.2019.06.119

- **EDEN REPHAELI ET AL: "Ultrabroadband Photonic Structures To Achieve High-Performance Daytime Radiative Cooling", NANO LETTERS, 11 March 2013 (2013-03-11), US, XP055414069, ISSN: 1530-6984, DOI: 10.1021/nl4004283**

**Description**

L'invention concerne un dispositif radiatif diurne. L'invention concerne également un procédé de détermination de la structure d'un dispositif radiatif diurne.

L'augmentation de la demande de climatisation et de réfrigération menace de briser les promesses et les objectifs pour endiguer le réchauffement climatique. En effet, le rafraîchissement de l'intérieur d'un bâtiment est aujourd'hui majoritairement réalisé par des échangeurs thermiques de type climatiseurs. La consommation mondiale d'énergie pour la climatisation des bâtiments devrait à elle seule augmenter de 33 fois d'ici 2100, à mesure de l'augmentation des revenus des pays en développement et de la progression de l'urbanisation. Au milieu du vingt-et-unième siècle, il sera utilisé plus d'énergie pour le refroidissement que pour le chauffage. Les climatiseurs fonctionnent avec de l'électricité qui est majoritairement produite dans le monde par la combustion de combustibles fossiles. Les solutions de refroidissement actuelles contreviennent donc aux objectifs de baisse d'émissions de gaz à effet de serre convenus lors du sommet international de Bonn (COP23).

En réponse à cette problématique, des refroidisseurs passifs radiatifs diurnes ont été développés. Les refroidisseurs passifs radiatifs diurnes se basent sur le principe d'un échange thermique avec l'espace, qui est un environnement extrêmement froid. Ces dispositifs représentent une solution de refroidissement qui ne consomme pas d'énergie et ont donc un impact positif sur les objectifs de baisse d'émissions de gaz à effet de serre.

Lorsque le rayonnement électromagnétique du soleil arrive sur terre, une partie des longueurs d'ondes du spectre est reflétée et une autre absorbée par l'atmosphère terrestre. Le rayonnement électromagnétique transporte à travers l'espace une certaine quantité d'énergie avec une certaine répartition spectrale. Aussi, l'objectif des refroidisseurs passifs radiatif diurne est de réfléchir les ondes les plus énergétiques traversant l'atmosphère terrestre et d'émettre un rayonnement qui traverse très bien l'atmosphère pour atteindre l'espace. Ainsi la chaleur provenant du soleil est renvoyée au maximum dans l'espace et en partie dans l'atmosphère, et la chaleur perçue depuis la terre est émise dans l'espace sous la forme d'un rayonnement.

La gamme de longueur d'ondes pour laquelle la réflexion doit être maximisée correspond ainsi à la plage spectrale du spectre solaire traversant l'atmosphère pour laquelle la luminance du soleil est la plus intense. Elle se situe de 260 à 2500 nm, notamment entre 260 nm et 2500 nm, et est représentée par le spectre de luminance solaire AM1,5. L'appellation AM1,5 désigne la masse d'air rencontrée par la lumière du soleil arrivant à 45° sur la surface du Terre, AM1 correspond à l'épaisseur de masse d'air de l'atmosphère. La gamme de longueurs d'ondes pour laquelle l'émission doit être maximisée correspond à la plage spectrale du spectre de transmission atmosphérique pour laquelle la transmission est la plus élevée et la plus large. Cette plage spectrale est nommée fenêtre de transparence atmosphérique (FTA) et se situe de 7500 à 13300 nm, notamment entre 7500 nm et 13300 nm.

Le document A.P. Raman et al, Nature, 2014, 515, 540-544, décrit un refroidisseur radiatif diurne comprenant de l'argent et de l'hafnium. Malgré les bonnes performances de réflexion et d'émissivité de ce dispositif, sa composition est à base de métaux rares et coûteux, ce qui empêche une production de masse telle qu'il y en besoin pour répondre aux besoins croissants de climatisation. Les matériaux sont également sensibles à l'oxydation.

Les documents Gentle et al, Nano Lett. 2010, 10, 373-379 et Zhai et al, Science, 2017, 355, 1062-1066 proposent des refroidisseurs radiatifs diurnes comprenant des matériaux polymères qui sont malheureusement sensibles à la photodestruction par la lumière UV lors d'expositions prolongées au soleil et à la photooxydation par réaction avec l'oxygène présent dans l'air.

Encore d'autres refroidisseurs radiatifs diurnes sont montrés par les documents CN 110 274 326 B, US 2015/338175 A1, et WO 2019/130199 A1.

Par ailleurs, les performances de refroidissement des dispositifs présentés ci-dessus sont limitées par un recouvrement partiel des longueurs d'ondes émises avec les longueurs d'ondes de la fenêtre de transparence atmosphérique. Cette fenêtre n'est donc pas exploitée à son plein potentiel.

L'invention a notamment pour objectif de pallier ces inconvénients de l'art antérieur.

Plus particulièrement, l'invention a pour objectif de fournir un dispositif radiatif réfrigérant diurne avec de bonnes performances de réflexion et d'émissivité, peu coûteux en production et qui dure dans le temps.

L'invention a également pour objectif de fournir un procédé de détermination de la structure d'un dispositif radiatif réfrigérant diurne.

L'invention a enfin pour objectif de fournir un procédé de fabrication d'un dispositif radiatif réfrigérant diurne.

A cet effet l'invention a pour objet un dispositif radiatif réfrigérant diurne comprenant toutes les caractéristiques définies par la revendication indépendante 1 annexée, entre autres une partie réflectrice constituée d'une superposition alternée de couches A et de couches B, lesdites couches A étant constituées d'au moins un matériau A choisi parmi $Nb_2O_5$, $TiO_2$ et $Ta_2O_5$, lesdites couches B étant constituées d'au moins un matériau B choisi parmi $SiO_2$ et $Al_2O_3$.

Par « partie réflectrice », il est entendu dans l'invention une partie ayant des propriétés de réflexion des longueurs d'ondes de 260 nm à 2500 nm.

Les inventeurs ont découvert de manière inattendue que la superposition alternée de couches A constituées d'au moins un matériau A choisi parmi $Nb_2O_5$, $TiO_2$ et $Ta_2O_5$ et de couches B constituées d'au moins un matériau B choisi parmi $SiO_2$ et $Al_2O_3$ permettait d'obtenir un dispositif radiatif réfrigérant diurne ayant de bonnes performances de réfrigération. Un tel dispositif présente une performance de réflexion des longueurs d'ondes de 260 nm à 2500 nm supérieure à 90% et présente une performance d'émissivité des longueurs d'ondes de 7500 à 13300 nm supérieure à 50%. Bien entendu, lors de son utilisation, le dispositif diurne selon l'invention doit avoir un accès au ciel libre. Plus particulièrement, lors de son utilisation la partie réflectrice est disposée

- selon un angle d'incidence normale (0°) pour le rayonnement solaire réflecteur pour obtenir la meilleure performance de réflexion, et
- selon un angle zénithal de 0° pour obtenir les meilleurs performances d'émissivité.

En outre, le dispositif de l'invention permet d'exploiter à 100% les longueurs d'ondes de la fenêtre de transparence atmosphérique, de 7500 à 13300 nm. Les matériaux utilisés dans le dispositif radiatif selon l'invention sont avantageusement peu coûteux, sont stables dans le temps et ne sont que peu ou pas sensibles à la photodestruction. Enfin, le dispositif radiatif selon l'invention présente avantageusement de mauvaises performances en termes de réflexion et d'émission respectivement en dehors de chaque gamme considérée ci-dessus. Ceci permet avantageusement d'éviter d'envoyer vers l'atmosphère des longueurs ondes qu'elle peut absorber, ce qui conduirait à participer à l'effet de serre et donc au réchauffement climatique.

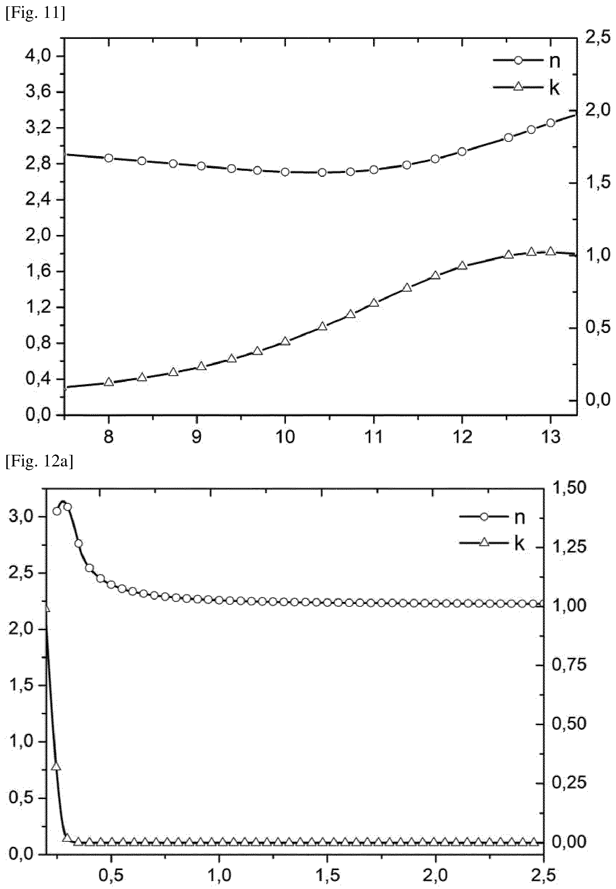

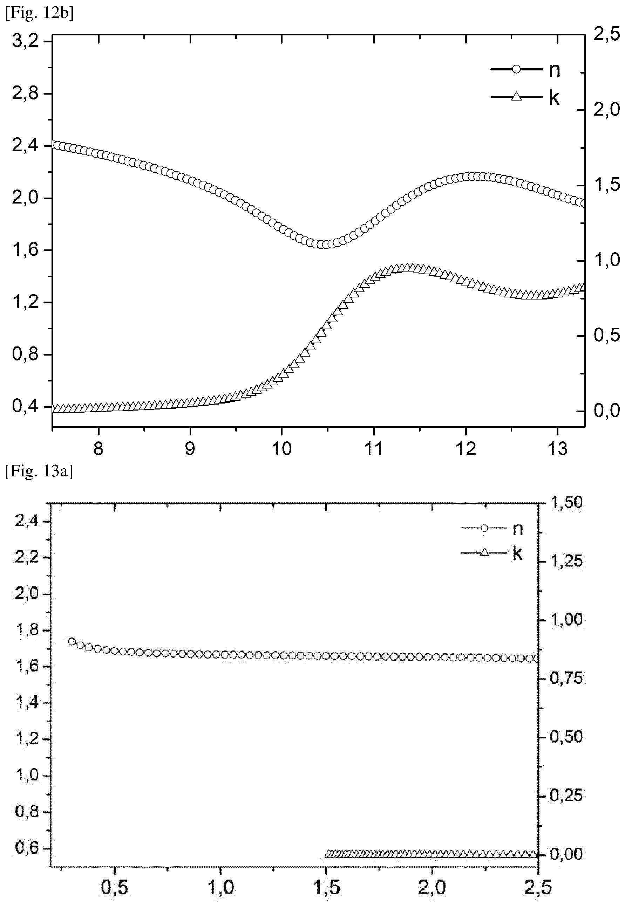

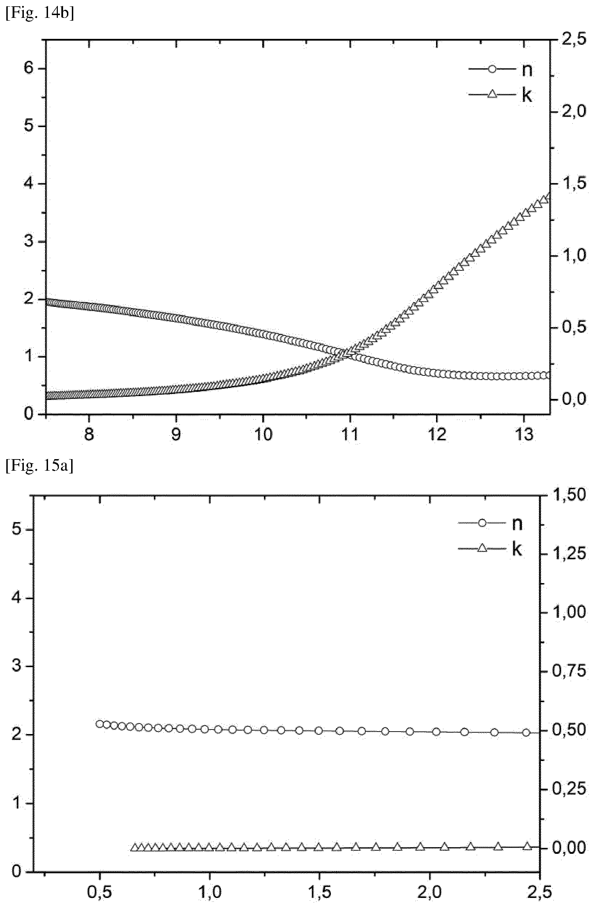

Le matériau A de l'invention correspond à un matériau ayant une valeur moyenne de l'indice de réfraction (n) pour les longueurs d'ondes de 260 nm à 2500 nm supérieure à 2, et une valeur moyenne du coefficient d'extinction (k) inférieure à 0,15, pour ces mêmes longueurs d'ondes. A ce titre, le matériau A peut être choisi parmi $Nb_2O_5$, $TiO_2$ et $Ta_2O_5$ (voir figures 12a, 14a et 15a).

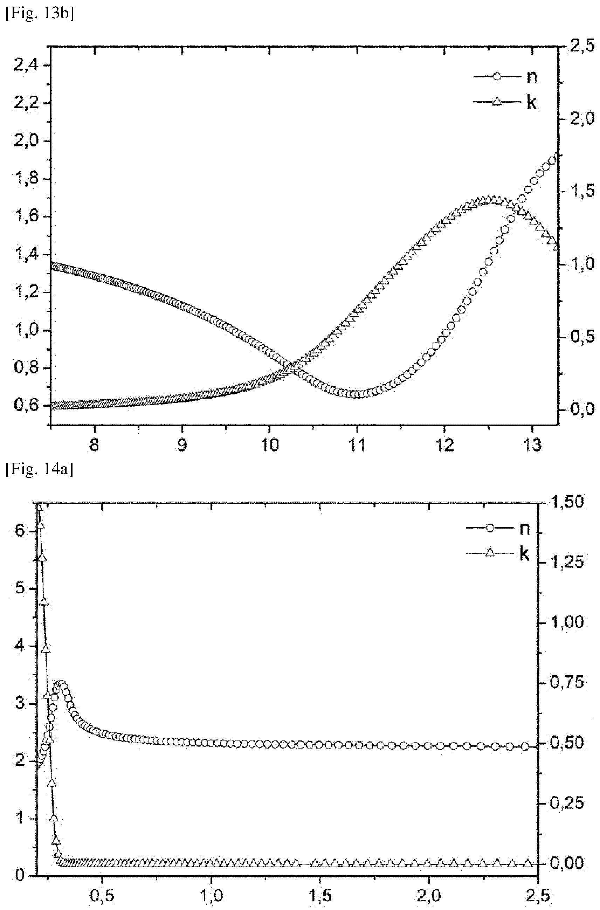

Le matériau B de l'invention correspond à un matériau ayant une valeur moyenne de l'indice de réfraction n pour les longueurs d'ondes de 260 nm à 2500 nm inférieure à 1,7 et une valeur moyenne du coefficient d'extinction k pour ces longueurs d'ondes inférieure à 0,15 et/ou un coefficient d'extinction k supérieur à 0,40 pour au moins une des longueurs d'ondes de la FTA. A ce titre, le matériau peut être choisi parmi $SiO_2$ et $Al_2O_3$ (voir [Fig.13a]).

C'est ainsi la combinaison spécifique de matériaux (A et B) ayant un fort contraste, c'est-à-dire une grande différence de leur indice de réfraction respectif sur la plage spectrale de 250 nm à 2500 nm qui permet d'obtenir les performances spectaculaires en termes de réflexion de la partie réflectrice du dispositif radiatif diurne selon l'invention.

En outre les capacités d'absorption du matériau B pour les longueurs d'ondes de la FTA permettent d'obtenir les performances d'émissivité du dispositif radiatif diurne selon l'invention.

La couche supérieure, c'est-à-dire celle destinée à être disposée en haut de la superposition de couches lors de l'utilisation du dispositif, et la couche basale, c'est-à-dire celle destinée à être en bas de la superposition de couches, peuvent être indifféremment une couche B ou une couche A.

La partie réflectrice peut comprendre un nombre pair ou impair de couches superposées.

Selon un mode de réalisation de l'invention, au moins deux matériaux A sont utilisés pour former les couches A, et au moins deux matériaux B sont utilisés pour former les couches B. Cet aspect de l'invention permet d'améliorer les performances de la partie réflectrice en termes d'émissivité des longueurs d'ondes dans la FTA. Dans ce mode de réalisation, chaque couche est constituée d'un seul matériau. En effet, des mélanges de matériaux pour former chaque couche A ou B entraineraient des problèmes de performance de réflexion.

Selon un mode de réalisation de l'invention, l'ensemble des couches A sont constituées du même matériau A et/ou l'ensemble des couches B sont constituées du même matériau B.

La partie réflectrice peut présenter des couches en matériau ayant une des 21 compositions listées dans le tableau suivant :

[Tableaux1]

| Comp. | Couches A | | | Couches B | |
|---|---|---|---|---|---|
| | $Nb_2O_5$ | $TiO_2$ | $Ta_2O_5$ | $SiO_2$ | $Al_2O_3$ |
| 1 | + | | | + | |
| 2 | | + | | + | |
| 3 | | | + | + | |
| 4 | + | + | | + | |
| 5 | + | | + | + | |
| 6 | | + | + | + | |

(suite)

| Comp. | Couches A | | | Couches B | |
|---|---|---|---|---|---|
| | $Nb_2O_5$ | $TiO_2$ | $Ta_2O_5$ | $SiO_2$ | $Al_2O_3$ |
| 7 | + | + | + | + | |
| 8 | + | | | | + |
| 9 | | + | | | + |
| 10 | | | + | | + |
| 11 | + | + | | | + |
| 12 | + | | + | | + |
| 13 | | + | + | | + |
| 14 | + | + | + | | + |
| 15 | + | | | + | + |
| 16 | | + | | + | + |
| 17 | | | + | + | + |
| 18 | + | + | | + | + |
| 19 | + | | + | + | + |
| 20 | | + | + | + | + |
| 21 | + | + | + | + | + |

Chaque couche de la partie réflectrice peut prendre n'importe quelle épaisseur. De préférence, les couches de la partie réflectrice présentent une variabilité d'épaisseur conduisant à des chemins optiques ($\delta$) variés comparables aux longueurs d'ondes dont la réflexion est souhaitée. Cet aspect de l'invention permet d'améliorer la performance de réflexion de la partie réflectrice.

La relation entre le chemin optique d'une onde ($\delta$) et l'épaisseur d'une couche (d) en fonction de l'indice de réfraction (n) du matériau constituant ladite couche est donnée par la formule suivante [Math 1] $\delta = n.d$

L'indice de réfraction maximum du matériau A variant de 3 à 4, avec une variabilité d'épaisseur de couches de 1 à 500 nm, on obtient des chemins optiques allant de 3 nm à 1500 nm jusqu'à 2000 nm, couvrant la majorité des longueurs d'ondes dont la réflexion est souhaitée.

Selon un mode de réalisation de l'invention, chaque couche A et chaque couche B présente une épaisseur respective et indépendante de 1 à 1750 nm. Cet intervalle d'épaisseur permet ainsi de couvrir l'ensemble des longueurs d'ondes de la plage du spectre dont on souhaite la réflexion (260 nm à 2500 nm). En outre, cet intervalle d'épaisseur permet d'obtenir des dispositifs radiatifs réfrigérants diurnes plus facilement réalisables et moins coûteux. En effet, une épaisseur de couche inférieure à 1 nm est difficile à obtenir, et une épaisseur au-delà de 1750 nm augmente les coûts de matières sans augmenter significativement les performances du dispositif (pour les raisons citées plus haut).

Selon l'invention, la partie réflectrice comprend au moins 71 couches. Un nombre accru de couches permet d'obtenir de meilleures performances de réfrigération. Notamment, un tel dispositif présente une performance de réflexion des longueurs d'ondes de 260 nm à 2500 nm supérieure à 90%. Ainsi, il est notamment inclus dans la portée de l'invention au moins 71 couches, au moins 72 couches, au moins 73 couches, au moins 74 couches, au moins 75 couches, au moins 76 couches, au moins 77 couches, au moins 78 couches, au moins 79 couches, au moins 80 couches, au moins 81 couches, au moins 82 couches, au moins 83 couches, au moins 84 couches, au moins 85 couches, au moins 86 couches, au moins 87 couches, au moins 88 couches, au moins 89 couches, au moins 90 couches, au moins 91 couches, au moins 92 couches, au moins 93 couches, au moins 94 couches, au moins 95 couches, au moins 96 couches, au moins 97 couches, au moins 98 couches, au moins 99 couches, au moins 100 couches, au moins 101 couches, au moins 102 couches, au moins 103 couches, au moins 104 couches, au moins 105 couches, au moins 106 couches, au moins 107 couches, au moins 108 couches, au moins 109 couches, au moins 110 couches, au moins 111 couches, au moins 112 couches, au moins 113 couches, au moins 114 couches, au moins 115 couches, au moins 116 couches, au moins 117 couches, au moins 118 couches, au moins 119 couches, au moins 120 couches, au moins 121 couches, au moins 122 couches, au moins 123 couches, au moins 124 couches, au moins 125 couches, au moins 126 couches, au moins 127 couches, au moins 128 couches, au moins 129 couches, au moins 130 couches, au moins 131 couches, au moins 132 couches, au moins 133 couches, au moins 134 couches, au moins 135 couches, au moins 136 couches, au moins 137 couches, au moins 138 couches, au moins 139 couches, au moins 140 couches, au moins 141 couches, au moins 142 couches, au moins 143 couches, au moins 144 couches, au moins 145 couches, au moins 146 couches, au moins 147 couches, au moins 148 couches, au moins 149 couches, au moins 150 couches, au moins 151 couches, au moins 152 couches, au moins 153 couches, au moins 154 couches, au moins 155 couches, au moins 156 couches, au moins 157 couches, au moins 158 couches, au moins 159 couches, au moins 160 couches, au moins 161 couches, au moins 162 couches, au moins 163 couches, au moins 164 couches, au moins 165 couches, au moins 166 couches, au moins 167 couches, au moins 168 couches, au moins 169 couches, au moins 170 couches, au moins 171 couches, au moins 172 couches, au moins 173 couches, au moins 174 couches, au moins 175 couches, au moins 176 couches, au moins 177 couches, au moins 178 couches, au moins 179 couches, au moins 180 couches, au moins 181 couches, au moins 182 couches, au moins 183 couches, au moins 184 couches, au moins 185 couches, au moins 186 couches, au moins 187 couches, au moins 188 couches, au moins 189 couches, au moins 190 couches, au moins 191 couches, au moins 192 couches, au moins 193 couches, au moins 194 couches, au moins 195 couches, au moins 196 couches, au moins 197 couches, au moins 198 couches, au moins 199 couches et au moins 200 couches.

Selon un mode de réalisation, la partie réflectrice est disposée sur un substrat. Ce substrat peut comprendre ou être constitué par du Si, SiO2 et/ou SiC. Le substrat peut également être en verre.

Selon un mode de réalisation de l'invention, le dispositif radiatif réfrigérant diurne comprend en outre une partie émettrice comprenant au moins une couche C constituée d'un matériau C choisi parmi $Nb_2O_5$, $SiO_2$, SiC, $TiO_2$, $Ta_2O_5$ et $Al_2O_3$, le matériau C étant différent du ou des matériaux A et du ou des matériaux B de la partie réflectrice, la partie réflectrice étant disposée sur la partie émettrice. La partie émettrice émet un rayonnement dans les longueurs d'ondes de 7500 à 13300 nm. Ainsi, la présence de cette partie émettrice permet d'augmenter les performances d'émission des longueurs d'ondes de la FTA du dispositif radiatif réfrigérant diurne selon l'invention. En outre, les matériaux utilisés dans cette partie émettrice sont avantageusement peu coûteux, sont stables dans le temps et ne sont pas ou peu sensibles à la photodestruction. Les parties réflectrice et émettrice sont superposées l'une sur l'autre, et non côte à côte. Ceci permet de combiner leur effet sur le rayonnement solaire et d'améliorer les performances de réfrigération. Lors de l'utilisation du dispositif de l'invention, la partie réflectrice forme la partie supérieure. Elle est disposée face au rayonnement solaire et se retrouve donc au-dessus de la partie émettrice, cette dernière formant ainsi la partie inférieure.

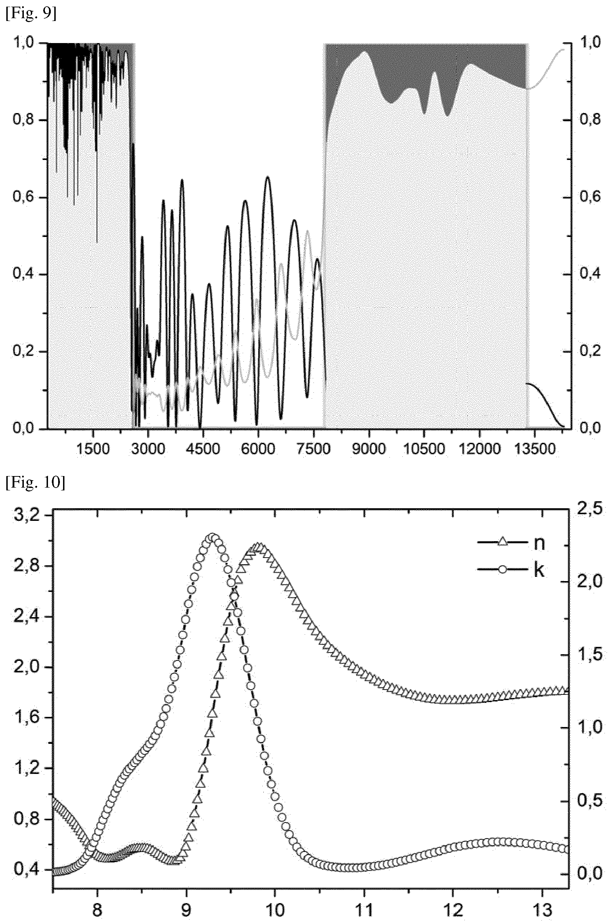

Le matériau C correspond à un matériau ayant une valeur moyenne de coefficient d'extinction k pour les longueurs d'ondes de la FTA supérieure à 0,40 (voir figures 10, 11, 12b, 13b, 14b et 15b). Les inventeurs ont découvert que contre toute attente que le matériau $Nb_2O_5$ présente une telle propriété, et donc qu'il peut également être utilisé dans la partie émettrice du dispositif radiatif diurne de l'invention.

Les performances d'émissivité de longueurs d'ondes dans la FTA du dispositif radiatif diurne sont obtenues pas la combinaison spécifique du matériau C de la partie émettrice et du ou des matériaux B de la partie réflectrice. Les couches B jouent donc un rôle à la fois pour la partie réflectrice dans le cadre des performances de réflexion des longueurs d'ondes de 260 nm à 2500 nm, et à la fois pour la partie émettrice dans le cadre des performances d'émissivité de longueurs d'ondes dans la FTA. De préférence, l'un des matériaux B et C est $SiO_2$.

Le dispositif radiatif réfrigérant diurne peut présenter des couches ayant une des 64 compositions listées dans le tableau suivant :

[Tableaux2]

| Com p. | PARTIE REFLECTRICE | | | | | PARTIE EMETTRICE | | | | | |
| | Couches A | | | Couches B | | Couche(s) C | | | | | |
| | $Nb_2Os$ | $TiO_2$ | $Ta_2O_5$ | $SiO_2$ | $Al_2O_3$ | SiC | $TiO_2$ | $Ta_2O_5$ | $SiO_2$ | $Al_2O_3$ | $Nb_2O_5$ |
|---|---|---|---|---|---|---|---|---|---|---|---|
| 1 | + | | | + | | + | | | | | |
| 2 | | + | | + | | + | | | | | |
| 3 | | | + | + | | + | | | | | |
| 4 | + | + | | + | | + | | | | | |
| 5 | + | | + | + | | + | | | | | |
| 6 | | + | + | + | | + | | | | | |
| 7 | + | + | + | + | | + | | | | | |
| 8 | + | | | | + | + | | | | | |
| 9 | | + | | | + | + | | | | | |
| 10 | | | + | | + | + | | | | | |

(suite)

| Com p. | PARTIE REFLECTRICE | | | | | PARTIE EMETTRICE | | | | | |
| | Couches A | | | Couches B | | Couche(s) C | | | | | |
| | $Nb_2O_5$ | $TiO_2$ | $Ta_2O_5$ | $SiO_2$ | $Al_2O_3$ | SiC | $TiO_2$ | $Ta_2O_5$ | $SiO_2$ | $Al_2O_3$ | $Nb_2O_5$ |
|---|---|---|---|---|---|---|---|---|---|---|---|
| 11 | + | + | | | + | + | | | | | |
| 12 | + | | + | | + | + | | | | | |
| 13 | | + | + | | + | + | | | | | |
| 14 | + | + | + | | + | + | | | | | |
| 15 | + | | | + | + | + | | | | | |
| 16 | | + | | + | + | + | | | | | |
| 17 | | | + | + | + | + | | | | | |
| 18 | + | + | | + | + | + | | | | | |
| 19 | + | | + | + | + | + | | | | | |
| 20 | | + | + | + | + | + | | | | | |
| 21 | + | + | + | + | + | + | | | | | |
| 22 | + | | | + | | | + | | | | |
| 23 | | | + | + | | | + | | | | |
| 24 | + | | + | + | | | + | | | | |
| 25 | + | | | | + | | + | | | | |
| 26 | | | + | | + | | + | | | | |
| 27 | + | | + | | + | | + | | | | |
| 28 | + | | | | + | | + | | | | |
| 29 | + | | | + | + | | + | | | | |
| 30 | | | + | + | + | | + | | | | |
| 31 | + | | + | + | + | | + | | | | |
| 32 | + | | | + | | | | + | | | |
| 33 | | + | | + | | | | + | | | |
| 34 | + | + | | + | | | | + | | | |
| 35 | + | | | + | | | | + | | | |
| 36 | + | | | | + | | | + | | | |
| 37 | | + | | | + | | | + | | | |
| 38 | + | + | | | + | | | + | | | |
| 39 | + | | | + | + | | | + | | | |
| 40 | | + | | + | + | | | + | | | |
| 41 | + | + | | + | + | | | + | | | |
| 42 | + | | | | + | | | | + | | |
| 43 | | + | | | + | | | | + | | |
| 44 | | | + | | + | | | | + | | |
| 45 | + | + | | | + | | | | + | | |
| 46 | + | | + | | + | | | | + | | |
| 47 | | + | + | | + | | | | + | | |

(suite)

| Com p. | PARTIE REFLECTRICE | | | | | PARTIE EMETTRICE | | | | | |
| | Couches A | | | Couches B | | Couche(s) C | | | | | |
| | $Nb_2Os$ | $TiO_2$ | $Ta_2O_5$ | $SiO_2$ | $Al_2O_3$ | SiC | $TiO_2$ | $Ta_2O_5$ | $SiO_2$ | $Al_2O_3$ | $Nb_2O_5$ |
|---|---|---|---|---|---|---|---|---|---|---|---|
| 48 | + | + | + | | + | | | | + | | |
| 49 | + | | | + | | | | | | + | |
| 50 | | + | | + | | | | | | + | |
| 51 | | | + | + | | | | | | + | |
| 52 | + | + | | + | | | | | | + | |
| 53 | + | | + | + | | | | | | + | |
| 54 | | + | + | + | | | | | | + | |
| 55 | + | + | + | + | | | | | | + | |
| 56 | | + | | + | | | | | | | + |
| 57 | | | + | + | | | | | | | + |
| 58 | | + | + | + | | | | | | | + |
| 59 | | + | | | + | | | | | | + |
| 60 | | | + | | + | | | | | | + |
| 61 | | + | + | | + | | | | | | + |
| 62 | | + | | + | + | | | | | | + |
| 63 | | | + | + | + | | | | | | + |
| 64 | | + | + | + | + | | | | | | + |

Selon un mode de réalisation, la partie réflectrice est disposée sur un substrat tel que défini ci-dessus.

Une ou plusieurs couches B peuvent également être présentes dans la partie émettrice, pour contribuer aux performances d'émissivité de longueurs d'ondes dans la FTA.

Selon un mode de réalisation de l'invention, la partie émettrice comprend au moins une superposition d'au moins une couche C et d'au moins une couche B, le matériau B et le matériau C choisis étant différents. De préférence, l'un des matériaux B et C de la partie émettrice est $SiO_2$.

Dans ce mode de réalisation, la partie réflectrice peut être constituée par seulement deux couches, une couche B et une couche C.

Selon un mode de réalisation, la ou les couches B de la partie émettrice et les couches B de la partie réflectrice sont constituées du même matériau B.

La partie émettrice peut comprendre un nombre pair ou impair de couches superposées.

Selon un mode de réalisation de l'invention, la ou l'ensemble des couches C présente une épaisseur totale d'au moins 1 $\mu$m. Une augmentation de l'épaisseur totale de la ou de l'ensemble des couches C permet d'améliorer les performances d'émissivité de longueurs d'ondes dans la FTA de la partie émettrice. Ainsi, il est notamment inclus dans la portée de l'invention au moins 1 $\mu$m, au moins 1,1 $\mu$m, au moins 1,2 $\mu$m, au moins 1,3 $\mu$m, au moins 1,4 $\mu$m, au moins 1,5 $\mu$m, au moins 1,6 $\mu$m, au moins 1,7 $\mu$m, au moins 1,8 $\mu$m, au moins 1,9 $\mu$m, au moins 2 $\mu$m, au moins 2,1 $\mu$m, au moins 2,2 $\mu$m, au moins 2,3 $\mu$m, au moins 2,4 $\mu$m, au moins 2,5 $\mu$m, au moins 2,6 $\mu$m, au moins 2,7 $\mu$m, au moins 2,8 $\mu$m, au moins 2,9 $\mu$m, au moins 3 $\mu$m, au moins 3,1 $\mu$m, au moins 3,2 $\mu$m, au moins 3,3 $\mu$m, au moins 3,4 $\mu$m, au moins 3,5 $\mu$m, au moins 3,6 $\mu$m, au moins 3,7 $\mu$m, au moins 3,8 $\mu$m, au moins 3,9 $\mu$m, au moins 4 $\mu$m, au moins 4,1 $\mu$m, au moins 4,2 $\mu$m, au moins 4,3 $\mu$m, au moins 4,4 $\mu$m, au moins 4,5 $\mu$m, au moins 4,6 $\mu$m, au moins 4,7 $\mu$m, au moins 4,8 $\mu$m, au moins 4,9 $\mu$m, au moins 5 $\mu$m, au moins 5,1 $\mu$m, au moins 5,2 $\mu$m, au moins 5,3 $\mu$m, au moins 5,4 $\mu$m, au moins 5,5 $\mu$m, au moins 5,6 $\mu$m, au moins 5,7 $\mu$m, au moins 5,8 $\mu$m, au moins 5,9 $\mu$m, au moins 6 $\mu$m, au moins 6,1 $\mu$m, au moins 6,2 $\mu$m, au moins 6,3 $\mu$m, au moins 6,4 $\mu$m, au moins 6,5 $\mu$m, au moins 6,6 $\mu$m, au moins 6,7 $\mu$m, au moins 6,8 $\mu$m, au moins 6,9 $\mu$m, au moins 7 $\mu$m, au moins 7,1 $\mu$m, au moins 7,2 $\mu$m, au moins 7,3 $\mu$m, au moins 7,4 $\mu$m, au moins 7,5 $\mu$m, au moins 7,6 $\mu$m, au moins 7,7 $\mu$m, au moins 7,8 $\mu$m, au moins 7,9 $\mu$m, au moins 8 $\mu$m, au moins 8,1 $\mu$m, au moins 8,2 $\mu$m, au moins 8,3 $\mu$m, au moins 8,4 $\mu$m, au moins 8,5 $\mu$m, au moins 8,6 $\mu$m, au moins 8,7 $\mu$m, au moins 8,8 $\mu$m, au moins 8,9 $\mu$m, au moins 9 $\mu$m, au moins 9,1 $\mu$m, au moins 9,2 $\mu$m, au moins 9,3 $\mu$m, au moins 9,4 $\mu$m, au moins 9,5 $\mu$m, au moins 9,6 $\mu$m, au moins 9,7 $\mu$m, au moins 9,8 µm, au moins 9,9 µm ou au moins 10 µm.

Selon un mode de réalisation de l'invention, la structure de la partie réflectrice est déterminée par des moyens automatisés mettant en œuvre les étapes suivantes :

a) fourniture d'une structure de réflexion de base, ladite structure ayant une épaisseur et étant constituée d'au moins une couche A et/ou d'au moins d'une couche B, ladite couche A étant constituée d'un matériau A choisi parmi $Nb_2O_5$, $TiO_2$ et $Ta_2O_5$ et ladite couche B étant constituée d'un matériau B choisi parmi $SiO_2$ et $Al_2O_3$,

b) détermination d'une structure de réflexion améliorée au moyen des sous-étapes suivantes :

i. sélection d'une longueur onde dont la réflexion est à améliorer, ladite longueur d'onde étant sélectionnée parmi une gamme de longueurs d'ondes de réflexion de 260 nm à 2500 nm,

ii. sélection d'un matériau à insérer selon les critères suivants :

- ledit matériau à insérer est choisi parmi ceux du matériau B si la structure de réflexion de base est constituée d'une couche A,
- ledit matériau à insérer est choisi parmi ceux du matériau A si la structure de réflexion de base est constituée d'une couche B,
- ledit matériau à insérer est choisi parmi ceux du matériau A ou parmi ceux du matériau B dans tous les autres cas,

iii. détermination du nombre de nouvelles couches à insérer dans la structure de réflexion de base et de leur position au sein de la structure de réflexion de base, une nouvelle couche étant constituée dudit matériau à insérer et insérée selon l'épaisseur de la structure de réflexion de base,
ledit nombre et ladite position étant déterminés en fonction de la longueur d'onde sélectionnée et du matériau à insérer sélectionné,

iv. détermination de l'épaisseur de la ou de chaque nouvelle couche et obtention d'une structure de réflexion améliorée dans laquelle sont incorporées la ou les nouvelles couches,

c) détermination d'une valeur de performance de réflexion $\chi_R$ de la structure améliorée à l'aide la formule suivante [Math 2] :

$$\chi_R = \frac{1}{\sqrt{N}} \sqrt{\sum_{i=1}^{N} \frac{(R_{SRA}(\lambda_i) - R_{FM}(\lambda_i))^2}{tol^2}}$$

où

$\lambda_i$ est une longueur d'onde (en nanomètre) dans la gamme de longueurs d'ondes de réflexion,
N est le nombre de longueurs d'ondes spectrales dans la gamme de longueurs d'ondes de réflexion,
$R_{SRA}(\lambda_i)$ est le coefficient de réflexion obtenu pour la structure de réflexion améliorée à la longueur d'onde spectrale $\lambda_i$,
$R_{FM}(\lambda_i)$ est le coefficient de réflexion à atteindre à la longueur d'onde $\lambda_i$, et tol a une valeur de 0,1,

d) si $\chi_R$ a une valeur inférieure ou égale à une valeur de référence $\chi_{Rref}$, détermination de la structure de réflexion améliorée comme correspondant à la partie réflectrice du dispositif radiatif diurne ; ou

si $\chi_R$ à une valeur supérieure à la valeur de référence $\chi_{Rref}$, répétition des étapes b) à d) en choisissant la structure de réflexion de base comme étant la structure de réflexion améliorée déterminée à l'étape b).

Les inventeurs ont ainsi réussi à mettre au point une méthode inédite de détermination de la structure de la partie réflectrice d'un dispositif radiatif diurne selon l'invention. Cette méthode est basée sur des simulations d'insertions répétées de nouvelles couches dans une structure de base et de détermination des performances théoriques des structures obtenues jusqu'à atteindre la structure présentant les performances voulues. La position et l'épaisseur de chaque nouvelle couche sont déterminées de sorte à améliorer les performances de la structure. Cette méthode permet donc avantageusement de déterminer une grande variété de structures pour la partie réflectrice sans avoir à fabriquer chaque prototype, ce qui réduit considérablement les coûts de développement de dispositif radiatif diurne réfrigérant. Pour la suite de l'exposé, le terme « performance » sera compris comme correspondant à une « performance théorique ». Nonobstant, les méthodes de calcul des performances théoriques citées ci-après ont été éprouvées depuis longtemps par l'état de l'art, de sorte que les performances théoriques obtenues correspondent aux performances réellement obtenues du dispositif fabriqué.

Par « moyens automatisés », il est entendu dans l'invention un ou plusieurs organes de traitement de données, par exemple un ou plusieurs ordinateurs, qui réalisent le procédé visant à atteindre le but mentionné. Dans la suite, il sera désigné par « moyens » ou « moyens automatisés » tout type de moyens automatisés tels que ceux précédemment cités, qui permettent de réaliser des étapes de procédé de manière automatique et numérique, au moyen d'une puissance de calcul fourni par quelque processeur que ce soit, éventuellement également au moyen de réseaux de télécommunications. Ces moyens comprennent ou s'adjoignent les services de bases de données visant à enregistrer ou à obtenir tout type de données nécessaires à la réalisation des étapes présentées, telles que des valeurs calculées, la position des couches, etc. Les étapes présentées dans la suite peuvent donc être écrites sous la forme d'un ou plusieurs programmes d'ordinateur, lequel peut être exécuté automatiquement au choix d'un utilisateur de l'invention.

### Étape a

Cette étape définie la structure de réflexion de base en termes de composition et d'épaisseur.

La composition de la structure de réflexion de base peut être monocouche ou multicouches. Elle peut notamment déjà présenter une alternance de couches A et B, ou simplement une seule de ces couches.

Avantageusement, la structure de réflexion de base peut présenter n'importe quelle épaisseur. En effet, l'épaisseur de la ou des couches la constituant sera adaptée au cours de l'étape b) par insertion d'une ou de plusieurs couches, voire au cours de la ou des itérations suivantes. De préférence, la structure de réflexion de base peut présenter une épaisseur d'au moins 100 nm, de préférence encore d'au moins 300 nm, avantageusement d'au moins 500 nm.

### Etape b

Cette étape permet d'obtenir une structure de réflexion améliorée ayant une meilleure réflexion des ondes de la gamme de longueurs d'onde de réflexion que la structure de réflexion de base, en cherchant à améliorer la réflexion de l'une de ces longueurs ondes. Il résulte de cette opération que la réflexion des longueurs d'ondes proches est également améliorée.

Selon un mode de réalisation particulier de l'invention, pour réaliser la sous-étape i. de l'étape b) les moyens automatisés mettent en œuvre les sous- étapes suivantes :

- détermination des coefficients de réflexion $R_{SRB}(\lambda)$ de la structure de réflexion de base pour chacune des longueurs d'ondes de la gamme de longueur d'ondes de réflexion, et
- sélection de la ou de l'une des longueurs d'ondes ayant le coefficient de réflexion $R_{SRB}$ le plus éloigné de $R_{FM}(\lambda_i)$.

Selon l'invention, le coefficient de réflexion correspond au coefficient de réflexion en intensité R et ces termes seront utilisés comme synonyme et de manière interchangeable. Le coefficient de réflexion d'une onde de longueur d'onde représente la fraction de l'onde qui est réfléchie par le système considéré (ici la structure de réflexion de base) et a une valeur comprise de 0 à 1, notamment entre 0 et 1. Une valeur de 0 indique qu'aucune réflexion de l'onde n'est obtenue par le système et une valeur de 1 indique que la totalité de l'onde est réfléchie par le système. Ainsi, dans ce mode de réalisation, la longueur d'onde sélectionnée correspond à celle parmi les longueurs d'onde de la gamme de réflexion pour laquelle la réflexion par la structure de réflexion de base est la plus mauvaise.

Le coefficient de réflexion d'une onde par un système donné est obtenu par différentes méthodes connues de l'homme du métier. En particulier, sa valeur peut être obtenue selon la méthode de matrice de transfert, par exemple décrite dans le document Pochi Yeh, Optical Waves in Layered Media, Wiley, 2005. Brièvement, le principe de cette méthode est d'associer à chaque couche de matériau (correspondant à une lame de matière séparée de deux autres lames de matière par deux dioptres) une matrice 2x2 spécifique. Cette méthode permet ainsi de déterminer les caractéristiques liées à la propagation d'une onde dans un système composé de plusieurs dioptres par simple multiplication des matrices spécifiques.

Pour déterminer la valeur du coefficient en intensité R, il est notamment considéré un système formé par l'air, la structure de base et un substrat tel que défini plus haut.

Les couples de matériaux A et B à partir de celui de la structure de base sont classés dans le tableau ci-dessous selon les performances de réflexion obtenues (de la meilleure à la moins bonne) :

[Tableaux3]

| Structure de base | | Matériau à insérer |
|---|---|---|
| COUCHE A | $TiO_2$ | $SiO_2$ |
| | $Nb_2O_5$ | $SiO_2$ |
| | $TiO_2$ | $Al_2O_3$ |
| | $Nb_2O_5$ | $Al_2O_3$ |
| | $Ta_2O_5$ | $SiO_2$ |
| | $Ta_2O_5$ | $Al_2O_3$ |
| COUCHE B | $SiO_2$ | $TiO_2$ |
| | $SiO_2$ | $Nb_2O_5$ |
| | $Al_2O_3$ | $TiO_2$ |
| | $Al_2O_3$ | $Nb_2O_5$ |
| | $SiO_2$ | $Ta_2O_5$ |
| | $Al_2O_3$ | $Ta_2O_5$ |

Selon un mode particulier de réalisation de l'invention, pour réaliser la sous-étape ii. de l'étape b) lorsque la structure de réflexion de base est constituée d'une couche A, le matériau à insérer sélectionné est $SiO_2$. En effet, quel que soit le matériau A constituant la couche de la structure de base, $SiO_2$ correspond au matériau B ayant un indice de réfraction des longueurs d'onde de 260 à 2500 nm ayant le plus grand contraste avec l'indice de réfraction de ces longueurs d'ondes du matériau A de la couche A. Par plus grand contraste, on entend dans l'invention la différence la plus élevée.

Selon un mode particulier de réalisation de l'invention, pour réaliser la sous-étape ii. de l'étape b) lorsque la structure de réflexion de base est constituée d'une couche B, le matériau à insérer sélectionné est $TiO_2$. En effet, quel que soit le matériau B constituant la couche de la structure de base, $TiO_2$ correspond au matériau A ayant un indice de réfraction des longueurs d'onde de 260 à 2500 nm ayant le plus grand contraste avec l'indice de réfraction de ces longueurs d'ondes du matériau B de la couche B.

Selon un mode particulier de réalisation de l'invention, pour réaliser la sous-étape ii. de l'étape b) dans tous les autres cas, le matériau à insérer correspond à celui de la ou d'au moins une des couches A ou à celui de la ou d'au moins une des couches B. Alternativement, le matériau à insérer est choisi parmi ceux du matériau A et est différent de celui de la couche A ou de ceux des couches A ou est choisi parmi ceux du matériau B et est différent de celui de la couche B ou de ceux des couches B.

Selon un mode particulier de réalisation de l'invention, pour réaliser la sous-étape iii. de l'étape b) les moyens automatisés mettent en œuvre les sous étapes suivantes :

- détermination de la dérivée du coefficient de réflexion $R_{SRB}(\lambda)$ de la structure de réflexion de base pour la longueur d'onde sélectionnée en fonction de l'épaisseur (p) de ladite structure de réflexion de base,
- détermination du nombre de nouvelles couches à insérer dans la structure de réflexion de base comme correspondant au nombre de fois où la dérivée s'annule en passant d'un extremum négatif à un extremum positif, et
- détermination de la position de la ou des nouvelles couches à insérer dans la structure de réflexion de base comme correspondant à chacune des valeurs de p pour lesquelles la dérivée s'annule en passant d'un extremum négatif à un extremum positif.

Alternativement, pour réaliser la sous-étape iii. de l'étape b) les moyens automatisés mettent en œuvre les sous étapes suivantes :

- détermination de la dérivée et de la dérivée seconde du coefficient de réflexion $R_{SRB}(\lambda)$ de la structure de réflexion de base pour la longueur d'onde sélectionnée en fonction de l'épaisseur (p) de ladite structure de réflexion de base,
- détermination du nombre de nouvelles couches à insérer dans la structure de réflexion de base comme correspondant au nombre de fois où la dérivée est égale à 0 avec une dérivée seconde négative, et
- détermination de la position de la ou des nouvelles couches à insérer dans la structure de réflexion de base comme correspondant à chacune des valeurs de p pour lesquelles la dérivée est égale à 0 avec une dérivée seconde négative.

La première des sous-étapes de détermination de la dérivée du coefficient de réflexion $R_{SRB}(\lambda)$ peut être réalisée à partir d'une méthode connue de l'état de l'art nommée « aiguille » (« Needle » en anglais), notamment décrite dans le document A. V. Tikhonravov, Vestn. Mosk. Univ. Fiz. Astronomiya 23, 91-93, 1982. Brièvement, cette méthode simule la présence d'une nouvelle couche ayant une épaisseur infinitésimale (inférieure à 1nm) à une position nanométrique donnée de l'épaisseur de la structure de réflexion de base. A partir de cette simulation, il est obtenu la dérivée et de la dérivée seconde de la valeur du coefficient de réflexion de la structure de réflexion de base pour la longueur d'onde sélectionnée à la valeur de l'épaisseur considérée de la structure de réflexion de base. Pour obtenir l'ensemble des valeurs de dérivée et de dérivée seconde, la couche d'épaisseur infinitésimale est déplacée virtuellement à toutes les positions nanométriques de l'épaisseur d'une structure considérée. Les inventeurs ont pu établir que ce déplacement virtuel pouvait être réalisé sur la base de la méthode des matrices de transfert.

En effet, en utilisant le formalisme de P. Yeh, (cité ci-dessus), on peut relier l'amplitude d'une onde plane entrante

$$[\text{Math 4}] \quad \begin{pmatrix} A_e \\ B_e \end{pmatrix}$$

à l'amplitude sortante [Math 5] $\begin{pmatrix} A_s \\ B_s \end{pmatrix}$ d'un système optique constitué de N couches empilées comprises entre deux milieux semi-infinis, les milieux d'entré $e$ et de sortie s [Math 6] :

$$\begin{pmatrix} A_e \\ B_e \end{pmatrix} = D_e^{-1} \left[ \prod_{i=1}^{N} D_i P_i D_i^{-1} \right] D_s \cdot \begin{pmatrix} A_s \\ B_s \end{pmatrix} = \begin{pmatrix} m_{11} & m_{12} \\ m_{21} & m_{22} \end{pmatrix} \cdot \begin{pmatrix} A_s \\ B_s \end{pmatrix} \quad (1)$$

La matrice

$$[\text{Math 7}] \quad \begin{pmatrix} m_{11} & m_{12} \\ m_{21} & m_{22} \end{pmatrix}$$

est la matrice résultante issue du produit des matrices 2*2 dynamique $D_1$, $D_1^{-1}$ et de phase $P_1$ de chaque couche considérée dans l'empilement.

Par définition, les coefficients de réflexion r et de transmission t en amplitude sont

$$[\text{Math 8}] : r = \begin{pmatrix} B_e \\ A_e \end{pmatrix}$$

et [Math 9]

$$t = \begin{pmatrix} A_s \\ A_e \end{pmatrix} \quad (2)$$

Donc, il vient que

$$[\text{Math 10}] : r = \begin{pmatrix} m_{21} \\ m_{11} \end{pmatrix}$$

et [Math 11]

$$t = \begin{pmatrix} 1 \\ m_{11} \end{pmatrix} \quad (3)$$

Et les coefficients de réflexion r et de transmission t en intensité sont [Math 12] : $R = \left| r \right|^2 = \left| \left( \frac{m_{21}}{m_{11}} \right) \right|^2$ et [Math 13]

$$T = \left| t \right|^2 = \frac{\mathcal{R}(\kappa_s)}{\mathcal{R}(\kappa_e)} \left| \left( \frac{1}{m_{11}} \right) \right|^2 \quad (4)$$

Le coefficient d'absorption en intensité est donné par la relation suivante [Math 14] :

$$A = 1 - R - T \quad (5)$$

Pour un empilement la relation entre les amplitudes dans le milieu i est donnée

$$\begin{pmatrix} A_i \\ B_i \end{pmatrix} = \begin{pmatrix} m_{11} & m_{12} \\ m_{21} & m_{22} \end{pmatrix} \cdot \begin{pmatrix} A_s \\ B_s \end{pmatrix} \quad (6)$$

La variation des coefficients r et t en fonction d'un paramètre p (peut-être l'épaisseur, angle, longueur d'onde) quelconque est donnée par [Math 16] :

$$\frac{dr}{dp} = \frac{1}{A_i}\frac{dB_i}{dp} - \frac{B_i}{A_i^2}\cdot\frac{dA_i}{dp} = \frac{1}{m_{11}}\frac{dm_{21}}{dp} - \frac{m_{21}}{m_{11}^2}\cdot\frac{dm_{11}}{dp} \quad (7)$$

[Math 17]

$$\frac{dt}{dp} = \frac{1}{A_i}\frac{dA_s}{dp} - \frac{A_s}{A_i^2}\cdot\frac{dA_i}{dp} = -\frac{1}{m_{11}^2}\cdot\frac{dm_{11}}{dp} \quad (8)$$

La variation induite par l'ajout d'une matrice infinitésimalement fine d'épaisseur dz dans l'empilement pourra s'écrire [Math 18] :

$$\begin{pmatrix} \frac{dA_i}{dz} \\ \frac{dB_i}{dz} \end{pmatrix} = \begin{pmatrix} \frac{dm_{11}}{dz} & \frac{dm_{12}}{dz} \\ \frac{dm_{21}}{dz} & \frac{dm_{22}}{dz} \end{pmatrix} \cdot \begin{pmatrix} A_s \\ B_s \end{pmatrix} = D_e^{-1} \dots D_i \frac{dP_i}{dz} D_i^{-1} \dots D_s \cdot \begin{pmatrix} A_s \\ B_s \end{pmatrix} \quad (9)$$

Les expressions de

[Math 19] $\frac{dR}{dz}$ ,

[Math 20] $\frac{dT}{dz}$

et

[Math 21] $\frac{dA}{dz}$

deviennent [Math 22] :

$$\frac{dR}{dz} = 2.r^*\cdot\frac{dr}{dz} \quad (10)$$

[Math 23]

$$\frac{dT}{dz} = 2.\frac{\mathcal{R}(\kappa_s)}{\mathcal{R}(\kappa_e)}.t^*.\frac{dt}{dz} \quad (11)$$

[Math 24]

$$\frac{dA}{dz} = -2.r^*.\frac{dr}{dz} - 2.\frac{\mathcal{R}(\kappa_s)}{\mathcal{R}(\kappa_e)}.t^*.\frac{dt}{dz} \quad (12)$$

La fonction $\chi_m$ à minimiser pour optimiser une grandeur R(i), T(i) ou A(i) est une fonction de la figure de mérite $F_m$ suivant [Math 25] :

$$\chi_m = \frac{1}{\sqrt{N}}\sqrt{\frac{\sum_i^N (X(i) - F_m(i))^2}{tol^2}} \quad (13)$$

Le dérivé de cette équation par rapport à z donne [Math 26] :

$$\frac{d\chi_m}{dz} = \frac{1}{2N}\left(\frac{\sum_i^N (X(i) - F_m(i))^2}{tol^2}\right)^{-\frac{1}{2}}.\frac{dX(i)}{dz} \quad (14)$$

Donc, il vient que la dérivée de la fonction $\chi_m$ est une fonction de la dérivée d'une grandeur spectroscopique R, T ou A. Donc rechercher des extremums de la figure $\chi_m$ reviens à chercher des extremums de la fonction spectroscopique R, T ou A.

Donc en résumé pour établir

$$[\text{Math 27}] \quad \frac{dR}{dz}$$

il faut [Math 28]

$$\left|\frac{dR}{dz} = 2.r^*.\frac{dr}{dz} \quad (15)\right.$$

avec [Math 29]

$$\frac{dr}{dz} = \frac{1}{m_{11}}\frac{dm_{21}}{dz} - \frac{m_{21}}{m_{11}^2}.\frac{dm_{11}}{dz} \quad (16)$$

et les éléments de matrices dérivée par rapport à e sont obtenus par [Math 30] :

$$\begin{pmatrix} \dfrac{dm_{11}}{dz} & \dfrac{dm_{12}}{dz} \\ \dfrac{dm_{21}}{dz} & \dfrac{dm_{22}}{dz} \end{pmatrix} = D_e^{-1} \dots D_i \frac{dP_i}{dz}D_i^{-1} \dots D_s \quad (17)$$

Il vient alors les expressions suivantes [Math 31] :

$$\frac{dR}{dz} = 2.r^*.\frac{1}{m_{11}}\frac{dm_{21}}{dz} - \frac{m_{21}}{m_{11}^2}.\frac{dm_{11}}{dz} \quad (18)$$

[Math 32]

$$\frac{dT}{dz} = 2 . \frac{\mathcal{R}(\kappa_s)}{\mathcal{R}(\kappa_e)} . t^* . - \frac{1}{m_{11}^2} . \frac{dm_{11}}{dz} \quad (19)$$

[Math 33]

$$[\text{Math 33}] \quad \frac{dA}{dz} = - 2 . r^* . \frac{1}{m_{11}} \frac{dm_{21}}{dz} - \frac{m_{21}}{m_{11}^2} . \frac{dm_{11}}{dz} - 2 . \frac{\mathcal{R}(\kappa_s)}{\mathcal{R}(\kappa_e)} . t^* . - \frac{1}{m_{11}^2} . \frac{dm_{11}}{dz}$$

$$(20)$$

Pour établir un spectre de

$$[\text{Math 34}] \quad \frac{dR}{dz}(z),$$

$$[\text{Math 35}] \quad \frac{dT}{dz}(z)$$

ou

$$[\text{Math 36}] \quad \frac{dA}{dz}(z)$$

en fonction de l'épaisseur il convient de répéter ces calculs pour une variation d'épaisseur infinitésimale dz variant de 0 à l'épaisseur total considéré $d_{tot}$.

Selon un mode de réalisation, pour réaliser la sous-étape iv. de l'étape b) les moyens automatisés mettent en œuvre les étapes suivantes :

1. prédétermination de l'épaisseur de la au moins une nouvelle couche au moyen d'un algorithme génétique, de préférence couplé à un algorithme simplexe, appliqué à la ou les nouvelles couches,
2. obtention d'une structure de réflexion pré-améliorée dans laquelle sont incorporées la ou les nouvelles couches,
3. ajustement de l'épaisseur de la ou des nouvelles couches au moyen d'un algorithme génétique, de préférence couplé à un algorithme simplexe, appliqué sur l'ensemble de la structure de réflexion pré-améliorée, et
4. obtention d'une structure d'émissivité améliorée dans laquelle sont incorporées la ou les nouvelles couches dont l'épaisseur est ainsi ajustée.

Notamment, suite à l'étape 2. et/ou à l'étape 3., les moyens automatisés mettent en œuvre les sous-étapes suivantes :

- fusion des couches contiguës constituées du même matériau, et/ou
- élimination de la ou des couches ayant une valeur inférieure à $z_{ref}$.

La sous-étape d'élimination a pour but de ne pas conserver les couches qui seraient d'une épaisseur faible, plus difficiles à déposer et qui engendreraient des coûts de production plus élevés. Notamment $z_{ref}$ a une valeur de 4 nm, de 3 nm, de 2 nm ou encore de 1 nm.

Les algorithmes génétiques sont largement connus de l'état de l'art. L'intérêt de ces algorithmes est qu'ils permettent d'obtenir des solutions diverses à un même problème, et donc dans le cadre de l'invention, d'obtenir différentes structures de réflexion ayant des épaisseurs différentes, mais montrant les performances de réfrigérations souhaitées.

Brièvement, les algorithmes génétiques tentent de simuler le processus d'évolution naturelle suivant le modèle darwinien dans un environnement donné. Ils utilisent un vocabulaire similaire à celui de la génétique naturelle. On parlera ainsi d'individus dans une population. Les principes de sélection, de croisement, de mutation s'inspirent des processus naturels de même nom. Pour un problème d'optimisation donné, un algorithme évolutionnaire optimise une fonction dite fonction objectif (ici $\chi_R$ et/ou $\chi_A$) sur un espace de recherche comportant la fonction objectif et un ensemble d'individus de l'espace des états. Pour cela, une population d'individus évolue selon un darwinisme artificiel (reproduction, mutation, sélection naturelle) basé sur la minimisation (atteinte de la valeur la plus faible) de la fonction objectif déterminée à partir de ces mêmes individus. La fonction objective peut être déterminée pour chaque individu ou par une combinaison d'individus. Des opérateurs appliqués à la population permettent de créer de nouveaux individus (croisement et mutation) et de sélectionner les individus de la population qui vont survivre (sélection et remplacement). La sélection a pour but de favoriser les meilleurs éléments de la population pour le critère considéré (avec les meilleures performances de réfrigération), le croisement et la mutation assurent l'exploration de l'espace d'états, c'est-à-dire d'exploiter ici le maximum de valeurs d'épaisseurs possibles.

Notamment, pour réaliser l'algorithme génétique de l'étape 1. de la sous-étape iv., les moyens automatisés mettent en œuvre les sous-étapes suivantes :

aa) obtention d'une population$_n$ constituée d'au moins 10 individus parents , chaque individu parent correspondant à une structure de réflexion comprenant la ou les couches de la structure de réflexion de base ainsi qu'une ou plusieurs nouvelles couches selon le résultat obtenu à la sous étape iii. de l'étape b), ladite ou lesdites nouvelles couches ayant une épaisseur générée stochastiquement, ladite ou lesdites nouvelles couches étant insérées dans chaque individu aux positions déterminées à la sous étape iii. de l'étape b),

bb) détermination de la valeur de performance de réflexion $\chi_R$ de chaque individu parent,

cc) obtention de la valeur prédéterminée de l'épaisseur de la ou de chaque nouvelle couche à insérer comme correspondant à celle de la ou des nouvelles couches du meilleur individu parent (*i.e.* l'individu parent ayant la valeur $\chi_R$ la plus basse) si sa valeur $\chi_R$ est inférieure à $\chi_{Rref}$, ou

poursuite vers l'étape dd),

dd) obtention d'individus enfants par croisements des individus parents entre eux, ledit croisement des individus parents étant réalisé en ne considérant pour chaque individu parent que l'épaisseur de la seule ou de chacune des seules nouvelles couches (sans les couches de la structure de base), de sorte que chaque individu enfant comprend le même nombre de couches à la même position que les individus parents avec une valeur d'épaisseur de la ou de chaque nouvelle couche résultant du croisement de deux individus parents, le nombre d'individus enfants correspondant au nombre d'individus parents,

et mutations des individus enfants, ladite mutation des individus enfants étant réalisée par la mutation de la valeur d'épaisseur de la seule ou des seules nouvelles couches (sans les couches de la structure de base), l'ensemble des individus enfants ainsi obtenus après mutation étant appelé progéniture,

ee) détermination de la valeur de performance de réflexion $\chi_R$ de chaque individu enfants de la progéniture,

ff) conclusion :

- obtention de la valeur prédéterminée de l'épaisseur de la ou de chaque nouvelle couche à insérer comme correspondant à celle de la nouvelle ou à celles des nouvelles couches du meilleur individu enfant de la progéniture (c'est-à-dire ayant la valeur $\chi_R$ la plus basse) si sa valeur $\chi_R$ est inférieure à $\chi_{R\,ref}$ ou

- répétition des sous étapes dd) à ff) en considérant une population$_{n+1}$ constituée d'individus parents correspondant aux individus enfants de la progéniture présentement obtenue (population$_n$). Lorsque ledit meilleur individu enfant de la présente progéniture a une valeur $\chi_R$ supérieure à la valeur $\chi_R$ du meilleur individu parent (population$_{n-1}$), ladite répétition des sous étapes dd) à ff) peut être réalisée en considérant comme individus parents de la population$_{n+1}$ les individus parents de la population$_{n-1}$.

Notamment, lors de l'étape aa), la génération stochastique génère des couches ayant une épaisseur de 1 nm à 1750 nm.

Notamment lors de l'étape aa), si le nombre y de couches de chaque individu parent est supérieur ou égal à 10, alors au moins y+1 individus parents sont générés. Cet aspect est nécessaire lorsqu'un algorithme simplexe est couplé à l'algorithme génétique. En effet, un nombre d'individus supérieurs au nombre de couches est nécessaire pour réaliser l'algorithme simplexe.

Notamment pour le calcul de la valeur de performance $\chi_R$, il est considéré un système formé par l'air, l'individu considéré et un substrat tel que défini précédemment.

Comme opérations de croisement des individus, on donnera l'exemple de croisements barycentrique, barycentrique aléatoire, multi-points et sbx (« simulated binary crossover »). De préférence, chaque opération de croisement est un croisement sbx. De préférence encore, ledit croisement sbx est réalisé suivant la probabilité d'appliquer un croisement à un individu parent pc=0.6. Les différentes opérations mathématiques relevant de chaque type de croisement font partie des connaissances générales de l'homme du métier. Notamment, pour le croisement de type sbx on se réfèrera au document K. Deb and R. B. Agrawal, Academic,1995, pp. 115-148. Pour les différents types de croisement barycentrique, on se réfèrera au document Mourad Sefrioui, PhD thesis, Université Pierre et Marie Curie, Avril 1998.

Comme opérations de mutations des individus, on donnera l'exemple de mutations gaussiennes et non uniformes. De préférence, chaque opération de mutation est une mutation non uniforme. Notamment, une mutation non-uniforme pilotée par le paramètre b=1 (exploratoire) ou b=25 (recherche locale) et la probabilité d'appliquer une mutation à un individu enfant est $p_m$=0.005. Les opérations mathématiques relevant de chaque type de mutation font partie des connaissances générales de l'homme du métier. Notamment, pour les mutations non-uniforme on se référera au document R. Numico, A. Keller, and O. Atabek, Phys. Rev. A 52, 1298 (1995). Pour les mutations gaussiennes on se réfèrera au document Z. Michalewicz, Springer (1999).

Selon un mode de réalisation, après au moins 10000, notamment au moins 100000, en particulier au moins 150000 répétitions des étapes dd) à ff), on peut considérer les conclusions suivantes à l'étape ff) :

- obtention de la valeur prédéterminée de l'épaisseur de la ou de chaque nouvelle couche à insérer comme correspondant à celle de la ou des nouvelles couches du meilleur individu enfant de la progéniture. Dans cet aspect de l'invention, lorsque ledit meilleur individu enfant de la progéniture a une valeur $\chi_R$ supérieure à la valeur $\chi_R$ du meilleur individu parent (population$_{n-1}$), il peut être considéré l'obtention de la valeur prédéterminée de l'épaisseur de la ou de chaque nouvelle couche à insérer comme correspondant à celle de la ou des nouvelles couches dudit meilleur individu parent ; ou
- récupération des individus enfants de la progéniture et application d'un algorithme simplexe à cette progéniture. Lorsque le meilleur individu enfant de la progéniture (population$_n$) a une valeur $\chi_R$ supérieure à la valeur $\chi_R$ du meilleur individu parent (population$_{n-1}$), il peut être considéré la récupération des individus parents de la population$_{n-1}$ et l'application d'un algorithme simplexe auxdits individus parents.

Dans ce mode de réalisation, il est considéré une poursuite du procédé de détermination de la partie réflectrice malgré l'absence d'atteinte de la valeur de performance $\chi_{Ref}$ par le meilleur individu enfant de la progéniture. En effet, c'est la répétition des étapes b) à d) et l'ajout successif de nouvelles couches avec une épaisseur optimisée qui permet *in fine* d'atteindre la valeur de performance souhaitée.

Lors de l'obtention de la valeur prédéterminée de l'épaisseur de la ou de chaque nouvelle couche à insérer lors de l'étape ff), les moyens automatisés mettent en œuvre les sous étapes suivantes :

- fusion des couches contigües constituées du même matériau, et
- élimination de la ou des couches ayant une valeur inférieure à $z_{ref}$.

Notamment, pour réaliser l'algorithme génétique de l'étape 3. de la sous étape iv. les moyens automatisés mettent en œuvre les mêmes étapes que celles mentionnées ci-dessus pour l'étape 1., en considérant

- qu'à l'étape aa) chaque individu parent correspond à une structure de réflexion comprenant toutes les couches de la structure de réflexion pré-améliorée, la valeur d'épaisseur de chaque couche d'un individu parent étant générée stochastiquement avec une variabilité positive ou négative d'au maximum 50%, avec la valeur d'épaisseur de la couche correspondante dans la structure d'émissivité pré-améliorée,
- qu'à l'étape dd), le croisement des individus parents est réalisé en considérant l'ensemble des couches formant chaque individu parent, de sorte que l'épaisseur de l'ensemble des couches est variable entre les individus parents et les individus enfants et
- qu'à l'étape dd) la mutation des individus enfants est réalisée sur l'ensemble des couches formant chaque individu enfant.

Notamment, la variabilité positive ou négative avec la valeur d'épaisseur de la couche correspondante dans la structure pré-améliorée est d'au maximum 40%, en particulier d'au maximum 30%, par exemple d'au maximum 10%.

Dans l'invention, l'algorithme simplexe correspond à la méthode de Nelder-Mead et ces termes seront pris comme synonymes et interchangeables. La méthode de Nelder-Mead est très connue de l'état de l'art. On citera notamment le document Numerical Recipes in Fortran 77 W.H. Press (chapitre 10.4 pages 402-406).

Brièvement, l'algorithme simplexe est une méthode numérique heuristique qui cherche à minimiser une fonction continue dans un espace à plusieurs dimensions. Ici, la fonction à minimiser est la valeur $\chi_R$. Le terme « simplexe » renvoie à une généralisation du triangle à une dimension quelconque. Ainsi, un simplexe, ou n-simplexe, est l'analogue à *n* dimensions du triangle formant un polytope à *n*+1 sommets (un triangle pour 2 dimensions, un tétraèdre pour 3 dimensions, etc.). Partant initialement d'un tel simplexe, celui-ci subit des transformations simples au cours des itérations : il se déforme, se déplace dans l'espace et se réduit progressivement jusqu'à ce que ses sommets se rapprochent d'un point où la fonction est localement minimale.

L'algorithme simplexe débute par la définition d'une fonction *f* sur un espace de dimension *N*. Dans le cadre de la présente invention la fonction *f* est la valeur de performance de réflexion $\chi_R$, et/ou la valeur de performance d'absorption $\chi_A$

comme il sera vu plus loin. Dans les N dimensions, N-1 dimensions correspondent aux différentes couches des individus récupérés pour l'algorithme simplexe (enfants ou parents) et la dernière dimension représente les valeurs $\chi_R$ de ces individus. Dans le présent mode de réalisation, les différentes couches de l'individu correspondent à celles de la structure de réflexion de base et la ou les nouvelles. Les différentes couches peuvent également correspondre à celles de la structure d'émissivité de base et la ou les nouvelles ou encore à celles de la partie de réflexion et à celles de la partie d'émissivité, dans le cadre de mode de réalisation décrits plus loin. Il est ensuite défini dans cet espace un simplexe non dégénéré (polytope à N sommets dont les sommets ne sont pas alignés). Le polytope comprend donc 1 sommet de plus qu'il n'y a de couches formant la structure de chaque individu récupéré. Chaque sommet du simplexe est disposé aux coordonnées des épaisseurs des différentes couches formant la structure d'un individu récupéré. Par itérations successives, le processus consiste à déterminer le point du simplexe où la fonction est maximale afin de le remplacer par la réflexion (c'est-à-dire le symétrique) de ce point par rapport au centre de gravité des *N-1* points restants. Si la valeur de la fonction en ce nouveau point est inférieure à toutes les autres valeurs prises sur les autres points, le simplexe est étiré dans cette direction. Si la valeur de la fonction en ce nouveau point est comprise entre la deuxième et la première moins bonne valeur, on garde cette valeur et on recommence. Dans tous les autres cas, il est supposé que l'allure locale de la fonction est une vallée, et le simplexe est contracté sur lui-même. Dans le cas où cette contraction ne permet pas d'aboutir à un meilleur point, le simplexe est réduit par une homothétie centrée sur le point du simplexe où la fonction est minimale.

### Etape c

Cette étape permet de déterminer la performance de réflexion des longueurs d'ondes de la gamme de réflexion par la structure de réflexion améliorée.

Notamment pour le calcul de la valeur de performance $\chi_R$, il est considéré un système formé par l'air, la structure améliorée et un substrat tel que défini ci-dessus.

Selon un mode de réalisation de l'invention, la valeur $R_{FM}(\lambda_i)$ vaut 1 pour toute longueur d'onde de la gamme de longueurs d'ondes de réflexion.

### Etape d

Cette étape permet de déterminer si les performances de réflexion obtenues pour la structure de réflexion améliorée sont satisfaisantes. Dans le cas où ces performances ne sont pas satisfaisantes, il est procédé à une nouvelle itération des étapes b) à d) de manière à améliorer ces performances.

Selon un mode de réalisation de l'invention, la valeur $\chi_{Rref}$ est égale ou inférieure à 1, de préférence inférieure ou égale à 0,5, de préférence encore inférieure ou égale à 0,3, avantageusement inférieure ou égale à 0,1. Plus la valeur $\chi_{Rref}$ est faible, plus les performances de réfrigération sont grandes. L'effet de réfrigération est obtenu à partir d'une valeur $\chi_{Rref}$ de 1, notamment lorsque le dispositif radiatif diurne comprend une partie émettrice telle que définie ci-dessus.

Selon un mode de réalisation de l'invention, la structure de la partie émettrice est déterminée par des moyens automatisés mettant en œuvre les étapes suivantes :

a) fourniture d'une structure d'émissivité de base, ladite structure ayant une épaisseur et étant constituée d'au moins une couche C et/ou d'au moins une couche B, ladite couche C étant constituée d'un matériau C choisi parmi $Nb_2O_5$, $SiO_2$, SiC, $TiO_2$, $Ta_2O_3$ et $Al_2O_3$ et ladite couche B étant constituée d'un matériau B choisi parmi $SiO_2$ et $Al_2O_3$, le matériau C étant différent du matériau B et différent du ou des matériaux A de la partie réflectrice, de préférence l'un des matériaux B et C est $SiO_2$,

b) détermination d'une structure d'émissivité améliorée au moyen des sous-étapes suivantes :

  i. sélection d'une longueur onde dont l'émissivité est à améliorer, ladite longueur d'onde étant sélectionnée parmi une gamme de longueurs d'ondes de réflexion de 7500 nm à 13300 nm,
  ii. sélection d'un matériau à insérer selon les critères suivants :

  - ledit matériau à insérer est choisi parmi ceux du matériau B si la structure d'émissivité de base est constituée d'une couche C,
  - ledit matériau à insérer est choisi parmi ceux du matériau C si la structure d'émissivité de base est constituée d'une couche B,
  - ledit matériau à insérer est choisi parmi ceux du matériau C ou parmi ceux du matériau B dans tous les autres cas,

  iii. détermination du nombre de nouvelles couches à insérer dans la structure d'émission de base et de leur position au sein de la structure d'émissivité de base, une nouvelle couche étant constituée dudit matériau à insérer et insérée selon l'épaisseur de la structure d'émissivité de base,

ledit nombre et ladite position étant déterminés en fonction de la longueur d'onde sélectionnée et du matériau à insérer sélectionné,

iv. détermination de l'épaisseur de la ou de chaque nouvelle couche, et obtention d'une structure d'émissivité améliorée dans laquelle sont incorporées la ou les nouvelles couches,

c) détermination d'une valeur de performance d'absorption $\chi_A$ de la structure améliorée à l'aide la formule suivante [Math 37] :

$$\chi_A = \frac{1}{\sqrt{N}} \sqrt{\sum_{i=1}^{N} \frac{(A_{SEA}(\lambda_i) - A_{FM}(\lambda_i))^2}{tol^2}}$$

où

$\lambda_i$ est une longueur d'onde (en nanomètre) dans la gamme de longueurs d'ondes d'émission,

N est le nombre de longueurs d'ondes dans la gamme de longueurs d'ondes d'émission,

$A_{SRA}(\lambda_i)$ est le coefficient d'absorption obtenu pour la structure améliorée à la longueur d'onde spectrale $\lambda_i$,

$A_{FM}(\lambda_i)$ est la valeur d'absorption à atteindre à la longueur d'onde spectrale $\lambda_i$, et tol a une valeur de 0,1,

d) si $\chi_A$ a une valeur inférieure ou égale à une valeur de référence $\chi_{Aref}$, détermination de la structure d'émissivité améliorée comme correspondant à la partie émettrice du dispositif radiatif diurne ; ou

si $\chi_A$ a une valeur supérieure à la valeur de référence $\chi_{Aref}$, répétition des étapes b) à d) en choisissant la structure d'émissivité de base comme étant la structure d'émissivité améliorée déterminée à l'étape b).

Dans cet aspect de l'invention, les inventeurs ont réussi à mettre au point une méthode de détermination de la structure de la partie émettrice selon un procédé équivalent à celui permettant de déterminer la structure de la partie réflectrice décrit plus haut, mais tenant compte des paramètres propres à la partie émettrice (matériaux à utiliser, longueurs d'ondes à considérer et performances à tester). Ici encore, cette méthode permet avantageusement de déterminer une grande variété de structures pour la partie émettrice sans avoir à fabriquer chaque prototype, ce qui réduit considérablement les coûts de développement de dispositifs radiatifs diurnes réfrigérants.

Etape a

La composition de la structure d'émissivité de base peut être monocouche ou multicouches. Elle peut notamment déjà présenter une alternance de couches C et B, ou simplement une seule de ces couches.

Avantageusement, la structure d'émissivité de base peut présenter n'importe quelle épaisseur. En effet, l'épaisseur de la ou des couches la constituant sera adaptée au cours de l'étape b) par insertion d'une ou de plusieurs couches, voire au cours de la ou des itérations suivantes. De préférence, la structure d'émissivité de base peut présenter une épaisseur d'au moins 1 nm, notamment de 1 à 50000 nm, de préférence d'au moins 100 nm, de préférence encore d'au moins 300 nm, avantageusement d'au moins 500 nm, par exemple d'au moins 1000 nm, notamment d'au moins 5000 nm.

Etape b

Cette étape permet d'obtenir une structure d'émissivité améliorée ayant une meilleure émission des ondes de la gamme de longueurs d'ondes d'émission que la structure d'émissivité de base, en cherchant à améliorer l'absorption de l'une de ces longueurs ondes.

En effet, avec l'approximation de Kirchhoff à l'équilibre thermique : $\alpha$ (absorptivité) = $\varepsilon$ (émissivité). Le coefficient d'absorption A est déterminé au moyen des matrices de transfert vues précédemment et est une fonction de l'absorptivité A=f($\alpha$) et donc de l'émissivité f($\varepsilon$). Ainsi, il est optimisé la valeur de A dans la méthode de l'invention, car c'est une grandeur directement calculable, mais c'est $\varepsilon$ l'émissivité qui est optimisée indirectement.

Comme c'était le cas pour la réflexion, en améliorant l'émissivité de l'une des longueurs d'ondes de la gamme de longueurs d'ondes d'émission, l'émissivité des longueurs d'ondes proches est également améliorée.

Selon un mode de réalisation particulier de l'invention, pour réaliser la sous étape i. de l'étape b) les moyens automatisés mettent en œuvre les sous étapes suivantes :

-    détermination des coefficients d'absorption $A_{SEB}(\lambda)$ de la structure d'émissivité de base pour chacune des longueurs d'ondes de la gamme de longueurs d'ondes d'émission, et

- sélection de la ou de l'une des longueurs d'ondes ayant le coefficient d'absorption $A_{SEB}$ le plus éloigné de 1.

Dans l'invention, le coefficient d'absorption correspond au coefficient d'absorption en intensité A et ces termes seront utilisés comme synonyme et de manière interchangeable. Le coefficient d'absorption d'une longueur d'onde représente la fraction de l'onde qui est absorbée par le système considéré (ici la structure d'émissivité de base) et a une valeur comprise de 0 à 1, notamment entre 0 et 1. Une valeur de 0 indique qu'aucune absorption de l'onde n'est obtenue par le système et une valeur de 1 indique que la totalité de l'onde est absorbé par le système. Ainsi, dans ce mode de réalisation, la longueur d'onde sélectionnée correspond à celle parmi les longueurs d'onde de la gamme d'émission pour laquelle l'absorption par la structure d'émissivité de base est la plus mauvaise.

Selon un mode particulier de réalisation de l'invention, pour réaliser la sous étape ii. de l'étape b) dans tous les autres cas, le matériau à insérer correspond à celui de la ou d'au moins une des couches C ou à celui de la ou d'au moins une des couches B. Alternativement, le matériau à insérer

- est choisi parmi ceux du matériau C et est différent de celui de la couche C ou de ceux des couches C et est différent de celui de la couche B ou de ceux des couches B, ou
- est choisi parmi ceux du matériau B et est différent de celui de la couche C ou de ceux des couches C et est différent de celui de la couche B ou de ceux des couches B.

De préférence, l'un des matériaux B et C de la partie émettrice est $SiO_2$.

Selon un mode particulier de réalisation de l'invention, pour réaliser la sous étape iii. de l'étape b) les moyens automatisés mettent en œuvre les sous étapes suivantes :

- détermination de la dérivée du coefficient d'absorption $A_{SEB}(\lambda)$ de la structure d'émissivité de base pour la longueur d'onde sélectionnée en fonction de l'épaisseur (p) de ladite structure d'émissivité de base,
- détermination du nombre de nouvelles couches à insérer dans la structure d'émissivité de base comme correspondant au nombre de fois où la dérivée s'annule en passant d'un extremum négatif à un extremum positif, et
- détermination de la position de la ou des nouvelles couches à insérer dans la structure d'émissivité de base comme correspondant à chacune des valeurs de p pour lesquelles la dérivée s'annule en passant d'un extremum négatif à un extremum positif.

La première des sous-étapes de détermination de la dérivée du coefficient de réflexion $R_{SRB}(\lambda)$ peut être réalisée par la méthode dérivée de la méthode « Needle » décrite plus haut.

Selon un mode de réalisation, pour réaliser la sous étape iv. de l'étape b) les moyens automatisés mettent en œuvre les étapes suivantes :

1. prédétermination de l'épaisseur de la au moins une nouvelle couche au moyen d'un algorithme génétique, de préférence couplé à un algorithme simplexe, appliqué sur la ou chaque nouvelle couche,
2. obtention d'une structure d'émissivité pré-améliorée par insertion dans la structure d'émissivité de base de la ou des nouvelles couches prédéterminées,
3. ajustement de l'épaisseur de la ou des nouvelles couches au moyen d'un algorithme génétique, de préférence couplé à un algorithme simplexe, appliqué sur l'ensemble de la structure d'émissivité pré-améliorée, et
4. obtention d'une structure d'émissivité améliorée dans laquelle sont incorporées la ou les nouvelles couches dont l'épaisseur est ainsi ajustée.

Notamment, suite à l'étape 2. et/ou à l'étape 3. les moyens automatisés mettent en œuvre les sous étapes suivantes :

- fusion des couches contigües constituées du même matériau, et/ou
- élimination de la ou des couches ayant une valeur inférieure à $z_{ref}$, notamment $z_{ref}$ vaut 4 nm.

Notamment, l'algorithme génétique présenté ci-dessus pour l'étape 1. de la sous étape iv. dans le cadre de la partie réflectrice s'applique *mutatis mutandis* à l'étape 1. de la sous étape iv. dans le cadre de la partie d'émissivité, nonobstant qu'à l'étape aa) chaque individu parent correspond à une structure d'émissivité comprenant la ou les couches de la structure d'émissivité de base ainsi qu'une ou plusieurs nouvelles couches selon le résultat obtenu à la sous étape iii. de l'étape b), ladite ou lesdites nouvelles couches ayant une épaisseur générée stochastiquement, ladite ou lesdites nouvelles couches étant insérées dans chaque individu aux positions déterminées à la sous étape iii. de l'étape b),

- qu'aux étapes bb) et ee), il est déterminé pour chaque individu (parent ou enfant) la valeur de performance d'absorption $\chi_A$, ladite valeur de performance étant comparée à la valeur de référence $\chi_{Aref}$ lors des étapes cc) et ff).

Notamment, la génération stochastique à l'étape a) génère des couches ayant une épaisseur de 1 à 50000 nm, en particulier de 1 à 30000 nm, par exemple de 1 à 10000 nm.

Notamment, l'algorithme génétique présenté ci-dessus pour l'étape 3. de la sous étape iv. dans le cadre de la partie réflectrice s'applique *mutatis mutandis* à l'étape 3. de la sous étape iv. dans le cadre de la partie d'émissivité, nonobstant

- qu'à l'étape aa) chaque individu parent correspond à une structure d'émissivité comprenant toutes les couches de la structure d'émissivité pré-améliorée, la valeur d'épaisseur de chaque couche d'un individu parent étant générée stochastiquement avec une variabilité positive ou négative d'au maximum 50%, avec la valeur d'épaisseur de la couche correspondante dans la structure d'émissivité pré-améliorée,
- qu'à l'étape dd), le croisement des individus parents est réalisé en considérant l'ensemble des couches formant chaque individu parent, de sorte que l'épaisseur de l'ensemble des couches est variable entre les individus parents et les individus enfants et
- qu'à l'étape dd) la mutation des individus enfants est réalisée sur l'ensemble des couches formant chaque individu enfant, et
- qu'aux étapes bb) et ee), il est déterminé pour chaque individu (parent ou enfant) la valeur de performance d'absorption $\chi_A$, ladite valeur de performance étant comparée à la valeur de référence $\chi_{Aref}$ lors des étapes cc) et ff).

Notamment, la variabilité positive ou négative avec la valeur d'épaisseur de la couche correspondante dans la structure d'émissivité pré-améliorée est d'au maximum 40%, en particulier d'au maximum 30%, par exemple d'au maximum 10%.

Notamment, l'algorithme simplexe présenté ci-dessus pour l'étape 1. Et l'étape 3. de la sous étape iv. dans le cadre de la partie réflectrice s'applique *mutatis mutandis* à l'étape 1. de la sous étape iv. dans le cadre de la partie d'émissivité, nonobstant que la dernière dimension représente $\chi_A$.

Etape c

Selon un mode de réalisation de l'invention, la valeur $A_{FM}(\lambda_i)$ vaut 0,5 pour toute longueur d'onde de la gamme de longueurs d'ondes de réflexion.

Notamment pour le calcul de la valeur de performance $\chi_A$, il est considéré un système formé par l'air, la structure améliorée et un substrat tel que défini précédemment.

Etape d

Selon un mode de réalisation de l'invention, la valeur $\chi_{Aref}$ est égale ou inférieure à 5. Plus la valeur $\chi_{Aref}$ est faible, plus les performances de réfrigération sont grandes. L'effet de réfrigération est obtenu à partir d'une valeur $\chi_{Aref}$ de 5.

Selon un mode de réalisation de l'invention, lorsque la valeur $\chi_A$ a une valeur inférieure ou égale à une valeur de référence $\chi_{Aref}$, les moyens automatisés mettent en œuvre les sous étapes suivantes pour obtenir la partie émettrice du dispositif radiatif diurne :

- rassemblement des couches B et C entre elles pour obtenir une superposition d'une couche B compilée et d'une couche C compilée, notamment suppression de la couche B compilée,
- obtention de la partie émettrice du dispositif radiatif diurne.

En effet, les inventeurs ont découvert de manière inattendue que les performances d'émissivité de la partie émettrice était liée à la quantité de matière représentée par chaque couche. Même si la détermination de l'épaisseur de chaque couche B et C nécessite l'insertion de nouvelles couches, l'alternance qui en résulte a un impact faible contrairement à la quantité de matière totale de chaque couche qui est déterminée. En ce sens, rassembler les couches de même matière (B et C) pour obtenir des couches compilées B et C lors de la détermination de la structure permet par la suite une fabrication plus aisée et moins couteuses de la partie émettrice. En outre, comme il l'a déjà été mentionné plus haut, les couches B de la partie réflectrice combinée aux couches C de la partie émettrice apportent performances nécessaires en termes d'émissivité. Les couches B de la partie émettrice, qui sont nécessaires pour déterminer la structure de la partie émettrice, ne sont pas nécessaire pour obtenir les performances d'émissivité et peuvent être supprimées de la structure déterminée. Ainsi, les coûts de fabrication de la partie émettrice sont donc encore réduits.

Selon un autre aspect, l'invention concerne un procédé de détermination de la structure de la partie réflectrice d'un dispositif radiatif réfrigérant diurne tel que décrit précédemment, dans lequel des moyens automatisés mettent en œuvre les étapes suivantes :

a) fourniture d'une structure de réflexion de base, ladite structure ayant une épaisseur et étant constituée d'au moins une couche A et/ou d'au moins d'une couche B, ladite couche A étant constituée d'un matériau A choisi parmi $Nb_2O_5$, $TiO_2$ et $Ta_2O_5$ et ladite couche B étant constituée d'un matériau B choisi parmi $SiO_2$ et $Al_2O_3$,
b) détermination d'une structure de réflexion améliorée au moyen des sous-étapes suivantes :

i. sélection d'une longueur onde dont la réflexion est à améliorer, ladite longueur d'onde étant sélectionnée parmi une gamme de longueurs d'ondes de réflexion de 260 nm à 2500 nm,
ii. sélection d'un matériau à insérer selon les critères suivants :

- ledit matériau à insérer est choisi parmi ceux du matériau B si la structure de réflexion de base est constituée d'une couche A,
- ledit matériau à insérer est choisi parmi ceux du matériau A si la structure de réflexion de base est constituée d'une couche B,
- ledit matériau à insérer est choisi parmi ceux du matériau A ou parmi ceux du matériau B dans tous les autres cas,

iii. détermination du nombre de nouvelles couches à insérer dans la structure de réflexion de base et de leur position au sein de la structure de réflexion de base, une nouvelle couche étant constituée dudit matériau à insérer et insérée selon l'épaisseur de la structure de réflexion de base,
ledit nombre et ladite position étant déterminés en fonction de la longueur d'onde sélectionnée et du matériau à insérer sélectionné,
iv. détermination de l'épaisseur de la ou de chaque nouvelle couche et obtention d'une structure de réflexion améliorée dans laquelle sont incorporées la ou les nouvelles couches,

c) détermination d'une valeur de performance de réflexion $\chi_R$ de la structure améliorée à l'aide la formule suivante [Math 2] :

$$\chi_R = \frac{1}{\sqrt{N}} \sqrt{\sum_{i=1}^{N} \frac{(R_{SRA}(\lambda_i) - R_{FM}(\lambda_i))^2}{tol^2}}$$

où

$\lambda_i$ est une longueur d'onde (en nanomètre) dans la gamme de longueurs d'ondes de réflexion,
N est le nombre de longueurs d'ondes dans la gamme de longueurs d'ondes de réflexion,
$R_{SRA}(\lambda_i)$ est le coefficient de réflexion obtenu pour la structure de réflexion améliorée à la longueur d'onde $\lambda_i$,
$R_{FM}(\lambda_i)$ est le coefficient de réflexion à atteindre à la longueur d'onde $\lambda_i$, et
tol a une valeur de 0,1,

d) si $\chi_R$ a une valeur inférieure ou égale à une valeur de référence $\chi_{Rref}$, détermination de la structure de réflexion améliorée comme correspondant à la partie réflectrice du dispositif radiatif diurne ; ou

si $\chi_R$ a une valeur supérieure à la valeur de référence $\chi_{Rref}$, répétition des étapes b) à d) en choisissant la structure de réflexion de base comme étant la structure de réflexion améliorée déterminée à l'étape b).

Les modes de réalisations décrits précédemment en relation avec la détermination de la partie réflectrice s'appliquent *mutatis mutandis* à cet aspect de l'invention.

Selon un autre aspect, l'invention concerne un procédé de détermination de la partie émettrice d'un dispositif radiatif diurne tel que décrit précédemment, dans lequel des moyens automatisés mettant en œuvre les étapes suivantes :

a) fourniture d'une structure d'émissivité de base, ladite structure ayant une épaisseur et étant constituée d'au moins une couche C et/ou d'au moins une couche B, ladite couche C étant constituée d'un matériau C choisi parmi $Nb_2O_5$, $SiO_2$, SiC, $TiO_2$, $Ta_2O_3$ et $Al_2O_3$ et ladite couche B étant constituée d'un matériau B choisi parmi $SiO_2$ et $Al_2O_3$, le matériau C étant différents du matériau B, de préférence l'un des matériaux B et C est $SiO_2$,

b) détermination d'une structure d'émissivité améliorée au moyen des sous-étapes suivantes :

   i. sélection d'une longueur onde dont l'émissivité est à améliorer, ladite longueur d'onde étant sélectionnée parmi une gamme de longueurs d'ondes de réflexion de 7500 nm à 13300 nm,
   ii. sélection d'un matériau à insérer selon les critères suivants :

   - ledit matériau à insérer est choisi parmi ceux du matériau B si la structure d'émissivité de base est constituée d'une couche C,
   - ledit matériau à insérer est choisi parmi ceux du matériau C si la structure d'émissivité de base est constituée d'une couche B,
   - ledit matériau à insérer est choisi parmi ceux du matériau C ou parmi ceux du matériau B dans tous les autres cas,

   iii. détermination du nombre de nouvelles couches à insérer dans la structure d'émissivité de base et de leur position au sein de la structure d'émissivité de base, une nouvelle couche étant constituée dudit matériau à insérer et insérée selon l'épaisseur de la structure d'émissivité de base,
   ledit nombre et ladite position étant déterminés en fonction de la longueur d'onde sélectionnée et du matériau à insérer sélectionné,
   iv. détermination de l'épaisseur de la ou de chaque nouvelle couche, et obtention d'une structure d'émissivité améliorée dans laquelle sont incorporées la ou les nouvelles couches,

c) détermination d'une valeur de performance d'absorption $\chi_A$ de la structure améliorée à l'aide la formule suivante [Math 37] :

$$\chi_A = \frac{1}{\sqrt{N}} \sqrt{\sum_{i=1}^{N} \frac{(A_{SEA}(\lambda_i) - A_{FM}(\lambda_i))^2}{tol^2}}$$

où

   $\lambda_i$ est une longueur d'onde (en nanomètre) dans la gamme de longueurs d'ondes d'émission,
   N est le nombre de longueurs d'ondes dans la gamme de longueurs d'ondes d'émission,
   $A_{SRA}(\lambda_i)$ est le coefficient d'absorption obtenu pour la structure améliorée à la longueur d'onde spectrale $\lambda_i$,
   $A_{FM}(\lambda_i)$ est le coefficient d'absorption à atteindre à la longueur d'onde spectrale $\lambda_i$, et tol a une valeur de 0,1,

d) si $\chi_A$ a une valeur inférieure ou égale à une valeur de référence $\chi_{Aref}$, détermination de la structure d'émissivité améliorée comme correspondant à la partie émettrice du dispositif radiatif diurne ; ou

si $\chi_A$ a une valeur supérieure à la valeur de référence $\chi_{Aref}$, répétition des étapes b) à d) en choisissant la structure d'émissivité de base comme étant la structure d'émissivité améliorée déterminée à l'étape b).
Les modes de réalisations décrits précédemment en relation avec la détermination de la partie émettrice s'appliquent *mutatis mutandis* à cet aspect de l'invention.
L'invention concerne également un procédé de détermination de la structure d'un dispositif radiatif réfrigérant diurne tel que défini précédemment, ledit dispositif radiatif diurne comprenant une partie émettrice et une partie réflectrice, dans lequel des moyens automatisés mettent en œuvre les étapes suivantes :

- détermination de la structure de la partie réflectrice au moyen du procédé défini précédemment,
- détermination de la structure de la partie émettrice au moyen du procédé défini précédemment,
- superposition de la partie réflectrice sur la partie émettrice et obtention du dispositif radiatif diurne, et notamment ajustement de l'épaisseur totale du dispositif radiatif diurne, en particulier au moyen d'un algorithme génétique, notamment couplé à un algorithme simplexe, appliqué sur l'ensemble de la structure du dispositif radiatif réfrigérant diurne,
- obtention de la structure du dispositif radiatif diurne.

Notamment, l'algorithme génétique utilisé dans cet aspect de l'invention peut correspondre à celui décrit pour l'étape 1. de la sous étape iv. dans le cadre de la partie réflectrice, nonobstant que

- qu'à l'étape aa) chaque individu parent correspond à un dispositif radiatif diurne comprenant toutes les couches du dispositif radiatif diurne obtenu ci-avant, la valeur d'épaisseur de chaque couche d'un individu étant générée stochastiquement avec une variabilité positive ou négative d'au maximum 50%, avec la valeur d'épaisseur de la couche correspondante dudit dispositif radiatif diurne,

- qu'à l'étape dd), le croisement des individus parents est réalisé en considérant l'ensemble des couches formant chaque individu parent, de sorte que l'épaisseur de l'ensemble des couches est variable entre les individus parents et les individus enfants, et
- qu'à l'étape dd) la mutation des individus enfants est réalisée sur l'ensemble des couches formant chaque individu enfant,
- qu'aux étapes bb) et ee), il est déterminé pour chaque individu (parent ou enfant) à la fois la valeur de performance d'absorption $\chi_A$ et la valeur de performance de réflexion $\chi_R$, lesdites valeurs de performance étant comparées aux valeurs de référence $\chi_{Aref}$ et $\chi_{Rref}$ respectivement lors des étapes cc) et ff).

Notamment, la variabilité positive ou négative avec la valeur d'épaisseur de la couche correspondante dans le dispositif radiatif diurne est d'au maximum 40%, en particulier d'au maximum 30%, par exemple d'au maximum 10%.

Notamment, l'algorithme simplexe utilisé dans cet aspect de la l'invention peut correspondre à celui décrit pour l'étape 1. de la sous étape iv. dans le cadre de la partie réflectrice, nonobstant que dans les N dimensions est compris une dimension pour les valeurs de $\chi_A$, une dimension pour les valeurs de $\chi_R$, et une dimension pour chaque couche du dispositif radiatif diurne.

Selon un autre aspect, l'invention concerne un procédé de fabrication d'un dispositif radiatif réfrigérant diurne tel que défini précédemment, ledit dispositif radiatif diurne comprenant une partie réflectrice, ledit procédé comprenant les étapes suivantes :

a) fourniture d'une structure de la partie réflectrice ou détermination d'une structure de la partie réflectrice selon le procédé décrit précédemment,
b) dépôt successif de chaque couche A et B suivant la structure de la partie réflectrice.

Notamment, lors de l'étape b) le dépôt peut être réalisé sur un substrat tel que décrit précédemment.

Notamment, le dépôt des couches A et B lors de l'étapes b) peut être réalisé par pulvérisation cathodique magnétron.

Selon un autre aspect, l'invention concerne un procédé de fabrication d'un dispositif radiatif réfrigérant diurne tel que défini précédemment, ledit dispositif radiatif diurne comprenant en sus une partie émettrice, ledit procédé comprenant les étapes suivantes :

a) fourniture de la structure de la partie réflectrice ou détermination de la structure de la partie émettrice selon le procédé décrit précédemment,
b) fourniture de la structure de la partie émettrice ou détermination de la structure de la partie émettrice selon le procédé décrit précédemment,
c) dépôts successifs de chaque couche C et B suivant la structure de la partie émettrice, et
d) dépôts successifs de chaque couche A et B suivant la structure de la partie réflectrice.

Notamment, lors de l'étape c), en fonction de la structure de la partie émettrice, une couche C compilée sera déposée ou une couche C compilée et une couche B compilée seront déposées ou une alternance de plusieurs couches C et de plusieurs couches B seront déposées.

Notamment, lors de l'étape c) le dépôt peut être réalisé sur un substrat tel que décrit précédemment.

Notamment, le dépôt des couches A et B lors de l'étapes d) et C et D lors de l'étape c) peut être réalisé par pulvérisation cathodique magnétron.

Le dépôt des couches A, B et C lors des étapes c) et d) peut être réalisé par pulvérisation cathodique magnétron. Dans ce mode de réalisation, une étape de préparation du substrat par voie chimique peut être réalisée. Ce traitement chimique peut notamment être à base d'acide fluorhydrique de concentration 5% et réalisé durant 30 secondes. Le substrat peut ensuite être rincé dans 3 bains d'eau ultra pure durant 1 minute chacun. Puis le substrat peut être séché sous un flux d'azote pur pour éliminer toute trace d'eau. En sus, le substrat peut être rincé sous un flux de propan-1-ol, pour éliminer toute trace de molécule organique et d'eau. Le substrat est placé sur un porte-substrat adapté. Il est introduit une chambre de dépôt sous-vide, c'est-à-dire avec une pression de 2 mTorr (1 mTorr = 0,133322 pascal). La chambre comprend au moins une cathode et une seule anode. La pression est ensuite montée une valeur de 2 à 50 mTorr, de préférence à 20 mTorr, la température est établie de 25°C à 200°C et un flux d'argon de 1 à 40 sccm (« centimètre cubique standard par minute »), de préférence de 10 sccm, de préférence encore de 20 sccm, est appliqué dans la chambre sur le substrat qui est en rotation de 10 à 50 tours par minutes, de préférence à 20 tours par minutes. Cette étape permet d'obtenir une température uniforme dans l'ensemble de la chambre (y compris le substrat). Elle peut durer une heure. L'initialisation d'un plasma froid est ensuite réalisée en injectant une puissance de travail d'au moins 30 pourcents (par exemple de 10W à 400W) de la puissance maximale sur la cathode avec une pression d'argon de 10 à 50 mTorr, de préférence de 20 mTorr. La puissance maximale peut notamment être de 300W. La pression est ensuite diminuée à une valeur de 2 à 10 mTorr par paliers successifs. Notamment la pression est diminuée par paliers successifs de 5 mTorr. Chaque pallier est atteint par exemple en moins de 10 secondes, en particulier en moins de 5 secondes. Il est ainsi atteint la stabilisation du plasma.

Pour chaque matériau A, B ou C, il est ensuite procédé au dépôt d'une couche de matériau correspondant sous un flux de plasma froid de 100% d'argon ou d'un mélange d'argon et d'oxygène. Le dépôt est réalisé à une pression proche de celle du vide, de 1 à 5 mTorr. Le matériau A, B ou C est disposé sur la ou une des cathodes formant ainsi une cible qui est pulvérisée par le plasma. Lorsque plusieurs matériaux sont à déposer à tour de rôle, chacun est disposé sur une cathode différente et chaque cible est soumise au plasma à tour de rôle. Les atomes de matériau A, B ou C arrachés à la cible par le plasma sont transportés puis déposés sur le substrat, ou sur une couche précédemment formée. La durée du dépôt (et donc la durée pendant laquelle le matériau est soumis au plasma) dépend de l'épaisseur de la couche de A, B ou C et du matériau A, B ou C utilisé. La vitesse de dépôt, c'est-à-dire la vitesse à laquelle l'épaisseur de la couche en formation augmente, est notamment comprise de 0,01 à 0,1 nm/s. La température du substrat lors du dépôt est notamment de 25°C à 250°C, en particulier de 200°C. Le plasma peut changer en fonction du matériau A, B ou C utilisé. Le mélange de gaz formant le plasma peut également changer au cours du processus de dépôt en fonction du matériau à déposer. Le ratio entre l'argon et l'oxygène dans le flux de plasma va notamment de 1:1 à 8:1, en particulier il est de 5:1. Le flux de plasma de 100% argon est notamment appliqué avec un débit massique de 30 à 50 sccm, notamment de 40 sccm. Concernant le flux de mélange argon et oxygène, chaque gaz peut être appliqué avec un débit massique particulier. Ce débit massique est dépendant du matériau A, B ou C utilisé. Notamment pour l'oxygène, le débit massique peut être de 5 à 15 sccm, par exemple de 7 sccm pour une couche de $SiO_2$ et de 12 sccm pour une couche de $Nb_2O_5$. Pour l'argon, le débit massique peut être de 30 à 50 sccm, notamment de 40 pour une couche de $SiO_2$ ou de $Nb_2O_5$. La puissance appliquée sur chaque cible va de 10 W à 400W. Elle peut être par exemple de 100 W pour le $SiO_2$ et de 325W pour le $Nb_2O_3$.

L'invention sera mieux comprise à la lumière des figures et des exemples suivants.

## Brève description des figures

La [Fig.1] est un logigramme représentant les étapes du procédé de détermination de la structure d'une partie réflectrice ou d'une partie émettrice d'un dispositif radiatif diurne selon l'invention.

La [Fig.2] est un logigramme représentant les étapes permettant de déterminer les valeurs de performance $\chi_R$ et $\chi_A$ dans le cadre du procédé de détermination de la structure d'une partie réflectrice ou d'une partie émettrice d'un dispositif radiatif diurne selon l'invention.

La [Fig.3] est un logigramme représentant les étapes de détermination de la sélection d'une longueur d'onde dans le cadre du procédé de détermination de la structure d'une partie réflectrice ou d'une partie émettrice d'un dispositif radiatif diurne selon l'invention.

La [Fig.4] est un logigramme représentant les étapes de détermination des positions optimales pour insérer la ou les nouvelles couches dans le cadre du procédé de détermination de la structure d'une partie réflectrice ou d'une partie émettrice d'un dispositif radiatif diurne selon l'invention.

La [Fig.5] est un logigramme représentant les étapes d'exécution d'un algorithme génétique dans le cadre du procédé de détermination de la structure d'une partie réflectrice ou d'une partie émettrice d'un dispositif radiatif diurne selon l'invention.

La [Fig.6] est un logigramme représentant les étapes d'exécution d'un algorithme simplexe dans le cadre du procédé de détermination de la structure d'une partie réflectrice ou d'une partie émettrice d'un dispositif radiatif diurne selon l'invention.

La [Fig.7] est un graphique représentant le spectre de réflexion des ondes de longueur 260 nm à 2500 nm par un dispositif radiatif réfrigérant diurne selon l'invention. Est également représentée la luminance énergétique du spectre solaire AM1,5. L'axe x correspond aux longueurs d'ondes. L'axe Y gauche correspond au coefficient de réflexion (1 correspond à 100% de réflexion). L'axe Y droit correspond à la luminance énergétique du spectre solaire AM1,5 en $W.m^{-2}.nm^{-1}$.

La [Fig.8] est un graphique représentant le spectre d'absorption des ondes de longueur 7500 à 13500 nm par un dispositif radiatif réfrigérant diurne selon l'invention. Est également représentée la transmittance atmosphérique. L'axe x correspond aux longueurs d'ondes. L'axe Y gauche correspond à l'absorption (1 correspond à 100% d'absorption). L'axe Y droit correspond à la transmittance (coefficient de transmission en intensité) atmosphérique.

La [Fig.9] est un graphique représentant les spectres de réflexion et d'absorption des ondes de longueur 1 à 14000 nm par un dispositif radiatif réfrigérant diurne selon l'invention. L'axe x correspond aux longueurs d'ondes. L'axe Y gauche correspond au coefficient de réflexion. L'axe Y droit correspond à l'absorption.

La [Fig.10] est un graphique représentant l'indice de réfraction n (axe y de gauche) et le coefficient d'extinction k (axe y de droite) en fonction des longueurs d'ondes de la gamme 7500 à 13300 nm (axe x) pour SiO$_2$.

La [Fig.11] est un graphique représentant l'indice de réfraction n (axe y de gauche) et le coefficient d'extinction k (axe y de droite) en fonction des longueurs d'ondes de la gamme 7500 à 13300 nm (axe x) pour SiC.

La [Fig.12a] est un graphique représentant l'indice de réfraction (axe y de gauche) et le coefficient d'extinction (axe y de droite) en fonction des longueurs d'ondes de la gamme 250 nm à 2500 nm (axe x) pour Nb$_2$O$_3$.

La [Fig.12b] est un graphique représentant l'indice de réfraction n (axe y de gauche) et le coefficient d'extinction k (axe y de droite) en fonction des longueurs d'ondes de la gamme 7500 à 13300 nm (axe x) pour Nb$_2$O$_3$.

La [Fig.13a] est un graphique représentant l'indice de réfraction n (axe y de gauche) et le coefficient d'extinction k (axe y de droite) en fonction des longueurs d'ondes de la gamme 250 nm à 2500 nm (axe x) pour Al$_2$O$_3$.

La [Fig.13b] est un graphique représentant l'indice de réfraction n (axe y de gauche) et le coefficient d'extinction k (axe y de droite) en fonction des longueurs d'ondes de la gamme 7500 à 13300 nm (axe x) pour Al$_2$O$_3$.

La [Fig.14a] est un graphique représentant l'indice de réfraction n (axe y de gauche) et le coefficient d'extinction k (axe y de droite) en fonction des longueurs d'ondes de la gamme 250 nm à 2500 nm (axe x) pour TiO$_2$.

La [Fig.14b] est un graphique représentant l'indice de réfraction n (axe y de gauche) et le coefficient d'extinction k (axe y de droite) en fonction des longueurs d'ondes de la gamme 7500 à 13300 nm (axe x) pour TiO$_2$.

La [Fig.15a] est un graphique représentant l'indice de réfraction n (axe y de gauche) et le coefficient d'extinction k (axe y de droite) en fonction des longueurs d'ondes de la gamme 250 nm à 2500 nm (axe x) pour Ta$_2$O$_5$.

La [Fig.15b] est un graphique représentant l'indice de réfraction n (axe y de gauche) et le coefficient d'extinction k (axe y de droite) en fonction des longueurs d'ondes de la gamme 7500 à 13300 nm (axe x) pour Ta$_2$O$_3$.

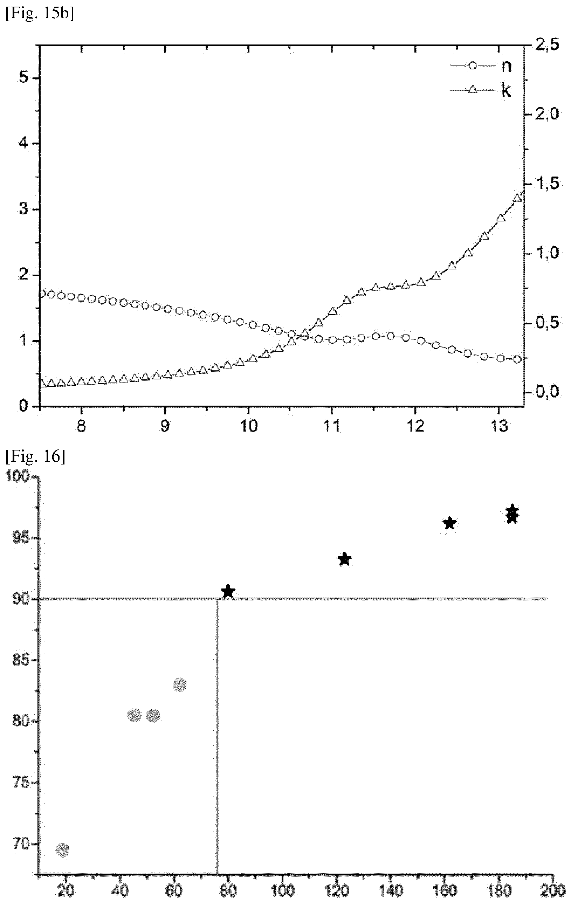

La [Fig.16] est un graphique représentant la performance totale R$_{AM1,5}$ en pourcentage pour la réflexion des longueurs d'ondes de 260 nm à 2500 nm en fonction du nombre de couches d'un dispositif radiatif réfrigérant selon l'invention constitué d'une partie réflectrice (alternance de couches Nb$_2$O$_5$ et SiO$_2$) et d'une partie émettrice. Dans le dispositif utilisé, le nombre de couche de la partie réflectrice était variable et la partie émettrice était constituée d'une couche unique de SiC d'une épaisseur de 4,995$\mu$m. On peut voir qu'à partir de 70 couches de la partie réflectrice, on obtient une performance totale d'au moins 90%. Chaque dispositif radiatif réfrigérant pour lequel la performance totale est inférieure à 90 % est représenté par un point, et chaque dispositif pour lequel la performance totale est supérieure à 90 % est représenté par une étoile.

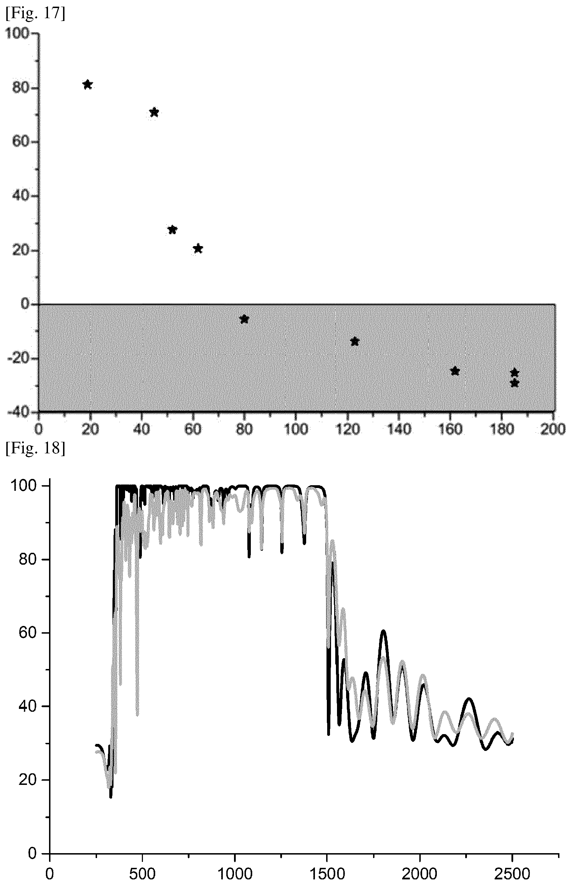

La [Fig.17] est un graphique représentant la température bilan en Celsius (°C) en fonction du nombre de couches du nombre de couches d'un dispositif radiatif réfrigérant selon l'invention constitué d'une partie réflectrice (alternance de couches Nb$_2$O$_5$ et SiO$_2$) et d'une partie émettrice. Dans le dispositif utilisé, le nombre de couche de la partie réflectrice était variable et la partie émettrice était constituée d'une couche unique de SiC d'une épaisseur de 4,995$\mu$m. La température bilan représente la différence entre la température d'équilibre du dispositif et la température externe. Ici, la température externe considérée était de 300K. On peut voir qu'à partir de 70 couches de la partie réflectrice, on obtient une température bilan de 0 ou moins, et donc un effet de réfrigération.

La [Fig.18] est un graphique représentant deux spectres de réflexion des ondes de longueurs de 260 nm à 2500 nm : un spectre de réflexion cible (courbe en trait noir), appelé figure de mérite, et un spectre de réflexion (courbe en trait gris clair) obtenu par mesures expérimentales l'aide d'un module « Universal Reflectance Accessy » (URA) d'un spectrophotomètre Lambda 1050 (Perkin Elmer®) sur une partie réflectrice d'un dispositif radiatif diurne selon l'invention de 72 couches. L'axe X correspond aux longueurs d'ondes de 0 à 3000 nm. L'axe Y correspond au pourcentage de réflexion.

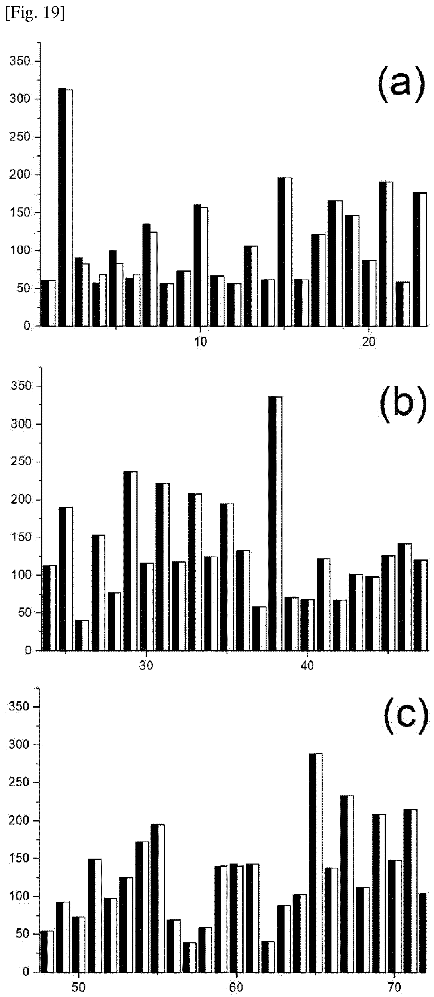

La [Fig.19] représente trois histogrammes (a, b et c) représentant l'épaisseur théorique (barre noire) et l'épaisseur obtenue (barre blanche) pour chaque couche d'une partie réflectrice d'un dispositif radiatif diurne selon l'invention constituée de 72 couches (histogramme (a) : couches 1 à 23 ; histogramme (b) : couches 24 à 47 ; histogramme (c) : couches 48 à 72). Sur chaque histogramme, l'axe des Y représente l'épaisseur des couches (en nm) et l'axe des X représente le numéro de la couche. La couche portant le numéro 1 est la couche la plus basse de la partie réflectrice, à savoir la première couche déposée, et la couche portant le numéro 72 est la couche la plus haute, à savoir la dernière couche déposée.

## Exemples

Exemple 1 : Détermination de le partie réflectrice et de la partie émettrice d'un dispositif radiative réfrigérant

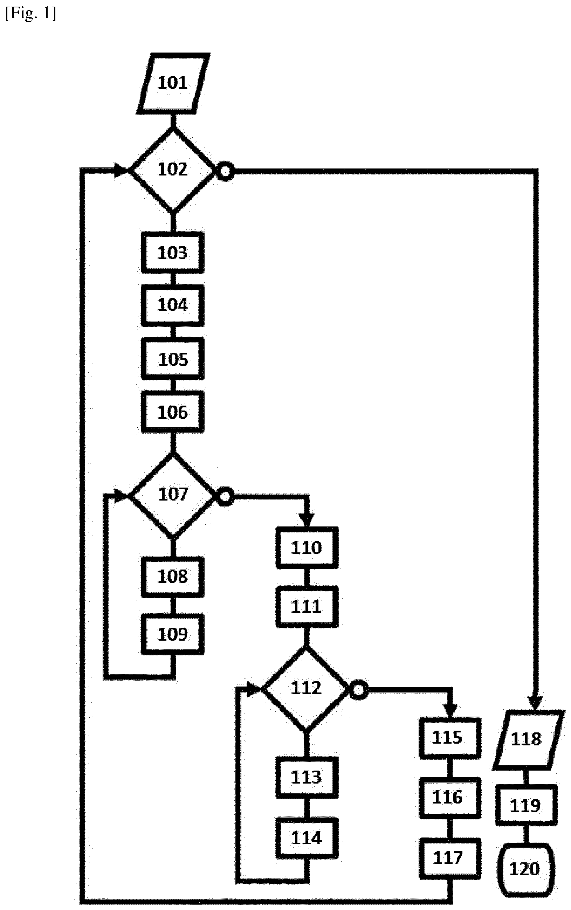

Les inventeurs ont mis en place un procédé permettant de déterminer les parties réflectrice et émettrice d'un dispositif radiatif réfrigérant. Ce procédé commun est illustré aux figures 1 à 7. Les paramètres d'entrée du procédé sont modifiés en fonction de la partie, réflectrice ou émettrice, dont la structure est déterminée.

La première étape 101 illustrée à la [Fig.1] correspond à l'initialisation des paramètres propres à chaque partie dont la structure est déterminée (matériaux A/B/C de la structure de base et épaisseur(s)). Pour la partie réflectrice, la structure de base correspondait à une couche de SiO₂ d'une épaisseur de 500nm. Pour la partie émettrice, la structure de base correspondait à une couche de SiO₂ d'une épaisseur de 500nm.

La seconde étape 102 est une boucle principale avec test de condition de passage à l'étape 118. Dans le cadre de la partie réflectrice, il s'agit de présenter des performances de réflexion $\chi_R$ inférieure à $\chi_{Rref}$ = 1. Pour la partie émettrice, il s'agit de présenter des performances de réflexion $\chi_A$ inférieure à $\chi_{Aref}$ =5.

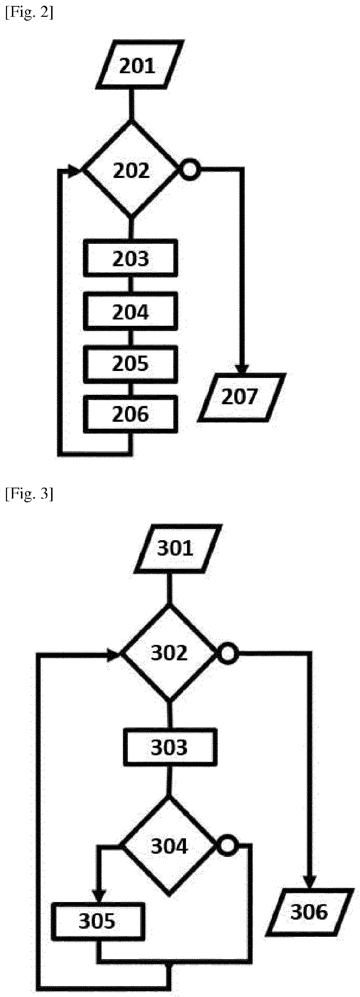

Les valeurs $\chi_R$ et $\chi_A$ sont établies à l'aide d'un procédé décrit à la figure 2. L'étape 201 correspond à l'entrée des paramètres de la structure testée : épaisseur et indice de réfraction du matériau de chaque couche formant la structure testée. L'indice de réfraction de l'air et d'un substrat de Si également considérés. L'étape 202 correspond à une boucle de test de l'ensemble des longueurs d'ondes de la gamme considérée : de 260 nm à 2500 nm pour la partie réflectrice et 7500 à 13300 pour la partie émettrice. L'étape 203 correspond à l'affection du nombre de matrices de transfert nécessaire pour décrire la structure considérée (une matrice 2x2 pour chaque couche mince). L'étape 204 correspond au produit de matrices de transfert pour obtenir la matrice résultante de l'ensemble substrat, structure testée et air. L'étape 205 correspond au calcul des grandeurs observables de réflexion R, de transmission T et d'absorption A à partir de la matrice résultante. L'étape 206 correspond au calcul des valeurs $\chi_R$ et $\chi_A$ suivant les équations mentionnaient plus haut dans la description. Pour ces calculs, la figure de mérite présente une grandeur spectrale de réflexion R de 1 pour chaque longueur d'onde de 260 nm à 2500 nm, et une grandeur spectrale A d'absorption de 1 pour chaque longueur d'onde de 7500 nm à 13000 nm. L'étape 207 correspond à l'enregistrement des valeurs R, T et A pour chaque structure et des valeurs $\chi_R$ et $\chi_A$.

L'étape 103 correspond au calcul des grandeurs optiques de réflexion R, de transmission T et d'absorption A de la structure testée. Ces grandeurs sont obtenues par l'exécution des étapes 201 à 205 décrites précédemment.

L'étape 104 correspond à la sélection de la longueur utilisée à l'étape 106 lors de la méthode d'insertion du Needle. Cette étape est détaillée à la [Fig.3]. Sur la [Fig.3], l'étape 301 correspond à la récupération de l'ensemble des données spectrales de la structure testée (R, T et A) et celles d'une figure de mérite. La figure de mérite présente une grandeur spectrale de réflexion R de 1 pour chaque longueur d'onde de 260 nm à 2500 nm, et une grandeur spectrale A d'absorption de 1 pour chaque longueur d'onde de 7500 nm à 13000 nm. L'étape 302 correspond à une boucle de test de l'ensemble des longueurs d'ondes de la gamme considérée : de 260 nm à 2500 nm pour la partie réflectrice et 7500 à 13300 pour la partie émettrice. Pour chaque longueur d'onde les étapes 303 et 304, et optionnellement 305, sont réalisées. L'étape 303 correspond au calcul de la différence entre la donnée spectrale et la figure de mérite à la longueur d'onde donnée. L'étape 304 correspond à la comparaison de cette valeur à la valeur de différence maximum trouvée précédemment. Par défaut la valeur de différence maximum vaut 0. L'étape 305 est exécutée si la comparaison donne une différence supérieure à la différence maximum. Cette valeur devient alors la nouvelle différence maximum pour les prochaines itérations. Lorsque toutes les longueurs d'ondes ont été testées, l'étape 306 est exécutée et correspond à la sélection de la longueur d'onde pour laquelle la différence maximum a été conservée.

L'étape 105 correspond à la sélection du matériau qui constituera les nouvelles couches insérées dans la structure de base. Pour la partie réflectrice, ce matériau correspond à celui ayant une valeur d'' indice de réfraction la plus éloigné de celle du matériau hôte de la structure de base. Comme le matériau hôte est SiO₂, le matériau sélectionné et Nb₂O₃. Pour la partie émettrice, c'est SiC qui a été sélectionné.

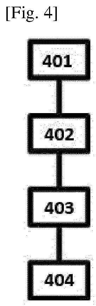

L'étape 106 correspond à la recherche des positions optimales dans l'épaisseur de la structure de base où insérer les nouvelles couches. Cette étape est détaillée à la [Fig.4]. L'étape 401 correspond au calcul de la dérivée spatiale de la gradeur spectrale R par rapport à l'épaisseur de la structure de base en considérant l'indice de réfraction du matériau des nouvelles couches et la longueur d'onde sélectionnée. L'étape 402 correspond à la détermination du nombre de nouvelles couches à insérer dans la structure de réflexion de base comme correspondant au nombre de fois où la dérivée s'annule en passant d'un extremum négatif à un extremum positif. L'étape 403 correspond à la détermination de la position de la ou des nouvelles couches à insérer dans la structure de réflexion de base comme correspondant à chacune des valeurs de z pour lesquelles la dérivée s'annule en passant d'un extremum négatif à un extremum positif. L'étape 404 correspondant à l'enregistrement des valeurs des épaisseurs déterminées et à la redistribution des épaisseurs en fonction de la position où seront insérées les nouvelles couches.

L'étape 107 est une boucle conditionnelle au passage à l'étape 110. Dans le cadre de la partie réflectrice, il s'agit de présenter des performances de réflexion $\chi_R$ inférieure à $\chi_{Rref}$ ($\chi_{Rref}$ valait 1). Pour la partie émettrice, il s'agit de présenter des performances de réflexion $\chi_A$ inférieure à $\chi_{Aref}$ ($\chi_{Aref}$ valait 5).

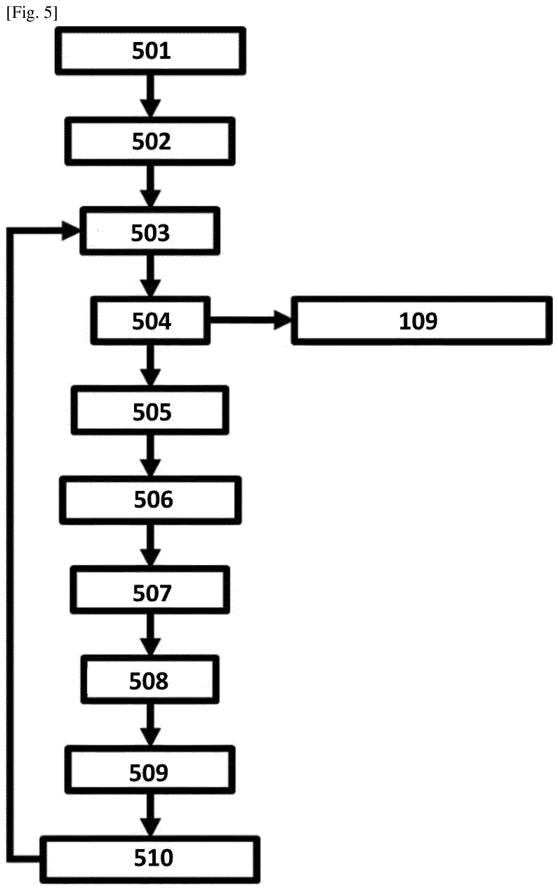

L'étape 108 correspond à l'application d'un algorithme génétique pour minimiser la valeur $\chi_R$ ou $\chi_A$ ou de la structure considérée, en ne considérant que les nouvelles couches. Le détail de cette étape est donné à la figure 5. L'étape 501 correspond à l'initialisation de la population initiale d'individus parents correspondant chacun à une génération d'épaisseurs aléatoires pour la ou chaque nouvelle couche. Chaque épaisseur est comprise entre 1 et 1750 nm. A l'étape 502 est calculée la valeur $\chi_R$ ou $\chi_A$ des individus parents à l'aide du procédé décrit à la figure 2. L'étape 503 est un classement des individus parents en fonction de leur valeur $\chi_R$ ou $\chi_A$. L'étape 504 est une étape conditionnelle au passage à l'étape 109. La première condition pour passer à l'étape 109 est si la valeur du l'individu parent ayant la valeur $\chi_R$ ou $\chi_A$ la plus faible est inférieure à la valeur $\chi_{Rref}$ ou $\chi_{Aref}$ respectivement. La seconde condition pour passer à l'étape 109 est si 150000 itérations des étapes 505 à 507 ont été réalisées. L'étape 505 correspond à la sélection par roulette stochastique des individus parents. Lors de cette étape, il est utilisé un algorithme « scaling » qui est une technique de mise à l'échelle imposée par le mode sélection par roulette. Il s'agit d'un sigma scaling tronqué avec le type les coefficients scal=1, scalvarp=0.5, scalvarp1=1, scalvarp2=2. L'étape 506 correspond au croisement de ces individus en fonction de la sélection précédente afin d'obtenir des individus enfants. Ces croisements sont des croisements sbx suivant la probabilité d'appliquer un croisement à un parent pc=0.6. L'étape 507 correspond à la mutation des individus enfants par mutation et l'obtention d'une progéniture d'individus enfants. La mutation appliquée à chaque enfant est une mutation non-uniforme pilotée par le paramètre b=1 (b=1 exploratoire sinon recherche Locale b=25) et la probabilité d'appliquer une mutation à un individu pm=0.005. A l'étape 508 est calculée la valeur $\chi_R$ ou $\chi_A$ des individus enfants de la progéniture à l'aide du procédé décrit à la [Fig.2]. L'étape 509 est un classement des individus enfants de la progéniture en fonction de leur valeur $\chi_R$ ou $\chi_A$. L'étape 510 permet de conserver les meilleurs individus enfants de la génération précédente si le meilleur individu de la progéniture a une valeur $\chi_R$ ou $\chi_A$ inférieur au meilleur individu de la génération précédente.

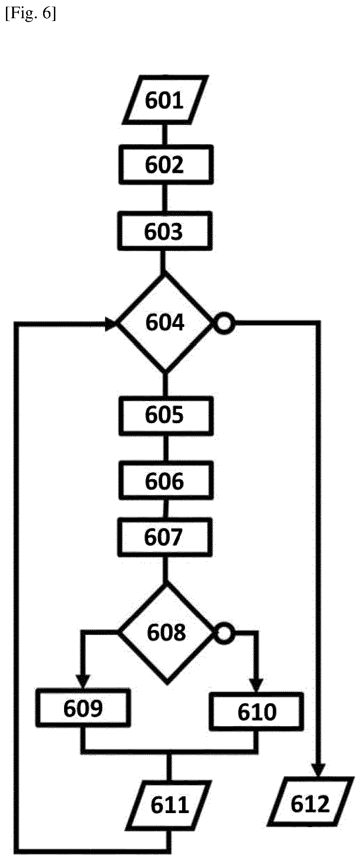

L'étape 109 correspond à l'application d'un algorithme simplexe pour minimiser la valeur $\chi_R$ ou $\chi_A$ des individus enfants de la meilleure progéniture obtenue à l'étape 108. Cette étape est décrite en détail à la figure 6. L'étape 601 correspond au recueil des données des individus enfants de la meilleure progéniture. L'étape 602 correspond au classement des individus enfants en fonction de leur valeur $\chi_R$ ou $\chi_A$ par la subroutine PIKSRT d'après le document « Numerical recipes in fortran 77 ».

L'étape 603 correspond à la définition des sommets simplexes à partir des données des individus. L'étape 604 est une boucle conditionnelle avec test de la valeur $\chi_R$ ou $\chi_A$, en fonction de la structure considérée, ou de 55000 itérations des étapes 605 à 610 pour passer à l'étape 611. L'étape 606 correspond au classement des hauteurs des sommets des simplexes. L'étape 607 correspond au calcul de la valeur $\chi_R$ ou $\chi_A$, en fonction de la structure considérée, pour chaque simplexe. L'étape 608 correspond à la réflexion depuis le point le plus élevé pour chaque simplexe, amenant en fonction du résultat obtenu à l'étape 609 d'extrapolation du simplexe par un facteur 2 ou à l'étape 610 de contraction du simplexe par un facteur 0,5. L'étape 611 correspond à l'obtention suite au étapes 609 ou 610 à une amélioration de sommets simplexes. L'étape 612 correspond à l'enregistrement des données d'épaisseur d'individu retenu pour la suite.

L'étape 110 est optionnelle et correspond à la fusion des couches de même matériau contigües.

L'étape 111 est optionnelle et correspond à l'élimination des couches d'épaisseur trop fine.

L'étape 112 est une boucle conditionnelle au passage à l'étape 115. Dans le cadre de la partie réflectrice, il s'agit de présenter des performances de réflexion $\chi_R$ inférieure à $\chi_{Ref}$ =1. Pour la partie émettrice, il s'agit de présenter des performances de réflexion $\chi_A$ inférieure à $\chi_{Aref}$ =5.

Les étapes 113 et 114 sont basées sur les étapes 108 et 109. Dans ces étapes, les individus considérés correspondent aux structures entières, incluant les nouvelles couches et les couches hôtes.

Les étapes 115 et 116 correspondent aux étapes 110 et 111 respectivement.

L'étape 117 correspond à l'étape 103.

L'étape 118 correspond à l'enregistrement des données (couches, matériaux, épaisseurs) relatives à la structure de la partie réflectrice ou de la structure de la partie émettrice. Concernant la partie émettrice, les moyens automatisés ont mis en œuvre à l'étape 119 la compilation des couches de matériau B et C, et la suppression de la couche B compilée.

L'étape 120 est une étape d'arrêt des moyens automatisés.

Un dispositif radiatif réfrigérant diurne déterminé par le procédé susmentionné présentait les valeurs $\chi_R$ et $\chi_A$ suivantes : $\chi_R$ = 0,275 et $\chi_A$ = 1,095. Les différentes couches de ce dispositif sont décrites dans le tableau suivant :

[Tableaux4]

| Numéro de la couche | Épaisseur (en nm) | Matériau | Numéro de la couche | Épaisseur (en nm) | Matériau |
|---|---|---|---|---|---|
| 1 | 247,0 | $Nb_2O_5$ | 94 | 57,3 | $SiO_2$ |
| 2 | 267,0 | $SiO_2$ | 95 | 4,2 | $Nb_2O_5$ |
| 3 | 271,5 | $Nb_2O_5$ | 96 | 9,4 | $SiO_2$ |
| 4 | 30,8 | $SiO_2$ | 97 | 13,7 | $Nb_2O_5$ |
| 5 | 27,5 | $Nb_2O_5$ | 98 | 143,3 | $SiO_2$ |
| 6 | 57,1 | $SiO_2$ | 99 | 23,8 | $Nb_2O_5$ |
| 7 | 70,2 | $Nb_2O_5$ | 100 | 8,7 | $SiO_2$ |
| 8 | 22,0 | $SiO_2$ | 101 | 113,8 | $Nb_2O_5$ |
| 9 | 25,5 | $Nb_2O_5$ | 102 | 107,3 | $SiO_2$ |
| 10 | 251,2 | $SiO_2$ | 103 | 150,5 | $Nb_2O_5$ |

(suite)

| Numéro de la couche | Épaisseur (en nm) | Matériau | Numéro de la couche | Épaisseur (en nm) | Matériau |
|---|---|---|---|---|---|
| 11 | 78,7 | $Nb_2O_5$ | 104 | 19,5 | $SiO_2$ |
| 12 | 118,3 | $SiO_2$ | 105 | 11,2 | $Nb_2O_5$ |
| 13 | 61,0 | $Nb_2O_5$ | 106 | 76,3 | $SiO_2$ |
| 14 | 325,6 | $SiO_2$ | 107 | 106,8 | $Nb_2O_5$ |
| 15 | 591,3 | $Nb_2O_5$ | 108 | 258,5 | $SiO_2$ |
| 16 | 117,1 | $SiO_2$ | 109 | 133,2 | $Nb_2O_5$ |
| 17 | 201,7 | $Nb_2O_5$ | 110 | 119,3 | $SiO_2$ |
| 18 | 301,3 | $SiO_2$ | 111 | 1,3 | $Nb_2O_5$ |
| 19 | 53,3 | $Nb_2O_5$ | 112 | 6,3 | $SiO_2$ |
| 20 | 4,6 | $SiO_2$ | 113 | 8,8 | $Nb_2O_5$ |
| 21 | 274,3 | $Nb_2O_5$ | 114 | 12,9 | $SiO_2$ |
| 22 | 70,1 | $SiO_2$ | 115 | 7,7 | $Nb_2O_5$ |
| 23 | 3,2 | $Nb_2O_5$ | 116 | 50,3 | $SiO_2$ |
| 24 | 131,1 | $SiO_2$ | 117 | 89,4 | $Nb_2O_5$ |
| 25 | 94,9 | $Nb_2O_5$ | 118 | 222,3 | $SiO_2$ |
| 26 | 139,7 | $SiO_2$ | 119 | 106,0 | $Nb_2O_5$ |
| 27 | 125,6 | $Nb_2O_5$ | 120 | 52,7 | $SiO_2$ |
| 28 | 166,4 | $SiO_2$ | 121 | 47,3 | $Nb_2O_5$ |
| 29 | 55,2 | $Nb_2O_5$ | 122 | 172,2 | $SiO_2$ |
| 30 | 64,6 | $SiO_2$ | 123 | 38,3 | $Nb_2O_5$ |
| 31 | 3,8 | $Nb_2O_5$ | 124 | 26,9 | $SiO_2$ |
| 32 | 84,5 | $SiO_2$ | 125 | 2,8 | $Nb_2O_5$ |
| 33 | 76,3 | $Nb_2O_5$ | 126 | 3,1 | $SiO_2$ |
| 34 | 20,9 | $SiO_2$ | 127 | 139,8 | $Nb_2O_5$ |
| 35 | 8,6 | $Nb_2O_5$ | 128 | 232,8 | $SiO_2$ |
| 36 | 96,1 | $SiO_2$ | 129 | 48,5 | $Nb_2O_5$ |
| 37 | 91,6 | $Nb_2O_5$ | 130 | 19,5 | $SiO_2$ |
| 38 | 35,7 | $SiO_2$ | 131 | 94,8 | $Nb_2O_5$ |
| 39 | 31,7 | $Nb_2O_5$ | 132 | 98,2 | $SiO_2$ |
| 40 | 24,6 | $SiO_2$ | 133 | 24,1 | $Nb_2O_5$ |
| 41 | 22,3 | $Nb_2O_5$ | 134 | 131,8 | $SiO_2$ |
| 42 | 2,7 | $SiO_2$ | 135 | 101,5 | $Nb_2O_5$ |
| 43 | 32,2 | $Nb_2O_5$ | 136 | 168,8 | $SiO_2$ |
| 44 | 13,5 | $SiO_2$ | 137 | 88,5 | $Nb_2O_5$ |
| 45 | 25,8 | $Nb_2O_5$ | 138 | 43,7 | $SiO_2$ |
| 46 | 215,4 | $SiO_2$ | 139 | 42,6 | $Nb_2O_5$ |
| 47 | 99,3 | $Nb_2O_5$ | 140 | 76,4 | $SiO_2$ |
| 48 | 36,4 | $SiO_2$ | 141 | 33,0 | $Nb_2O_5$ |
| 49 | 65,8 | $Nb_2O_5$ | 142 | 76,5 | $SiO_2$ |

(suite)

| Numéro de la couche | Épaisseur (en nm) | Matériau | Numéro de la couche | Épaisseur (en nm) | Matériau |
|---|---|---|---|---|---|
| 50 | 65,2 | $SiO_2$ | 143 | 64,0 | $Nb_2O_5$ |
| 51 | 42,4 | $Nb_2O_5$ | 144 | 5,7 | $SiO_2$ |
| 52 | 135,3 | $SiO_2$ | 145 | 25,0 | $Nb_2O_5$ |
| 53 | 1,3 | $Nb_2O_5$ | 146 | 115,2 | $SiO_2$ |
| 54 | 204,5 | $SiO_2$ | 147 | 74,6 | $Nb_2O_5$ |
| 55 | 6,6 | $Nb_2O_5$ | 148 | 34,3 | $SiO_2$ |
| 56 | 5,1 | $SiO_2$ | 149 | 129,5 | $Nb_2O_5$ |
| 57 | 22,6 | $Nb_2O_5$ | 150 | 33,1 | $SiO_2$ |
| 58 | 2,8 | $SiO_2$ | 151 | 41,0 | $Nb_2O_5$ |
| 59 | 1,8 | $Nb_2O_5$ | 152 | 24,1 | $SiO_2$ |
| 60 | 72,6 | $SiO_2$ | 153 | 80,8 | $Nb_2O_5$ |
| 61 | 195,5 | $Nb_2O_5$ | 154 | 59,1 | $SiO_2$ |
| 62 | 290,1 | $SiO_2$ | 155 | 80,6 | $Nb_2O_5$ |
| 63 | 166,3 | $Nb_2O_5$ | 156 | 332,1 | $SiO_2$ |
| 64 | 7,0 | $SiO_2$ | 157 | 22,2 | $Nb_2O_5$ |
| 65 | 60,6 | $Nb_2O_5$ | 158 | 54,9 | $SiO_2$ |
| 66 | 140,8 | $SiO_2$ | 159 | 166,0 | $Nb_2O_5$ |
| 67 | 17,6 | $Nb_2O_5$ | 160 | 245,9 | $SiO_2$ |
| 68 | 36,8 | $SiO_2$ | 161 | 168,5 | $Nb_2O_5$ |
| 69 | 2,2 | $Nb_2O_5$ | 162 | 182,7 | $SiO_2$ |
| 70 | 6,1 | $SiO_2$ | 163 | 44,9 | $Nb_2O_5$ |
| 71 | 25,2 | $Nb_2O_5$ | 164 | 13,6 | $SiO_2$ |
| 72 | 135,3 | $SiO_2$ | 165 | 5,5 | $Nb_2O_5$ |
| 73 | 149,4 | $Nb_2O_5$ | 166 | 114,5 | $SiO_2$ |
| 74 | 133,4 | $SiO_2$ | 167 | 48,0 | $Nb_2O_5$ |
| 75 | 115,6 | $Nb_2O_5$ | 168 | 1,8 | $SiO_2$ |
| 76 | 239,8 | $SiO_2$ | 169 | 178,0 | $Nb_2O_5$ |
| 77 | 74,0 | $Nb_2O_5$ | 170 | 12,3 | $SiO_2$ |
| 78 | 1,2 | $SiO_2$ | 171 | 40,0 | $Nb_2O_5$ |
| 79 | 115,6 | $Nb_2O_5$ | 172 | 151,2 | $SiO_2$ |
| 80 | 213,3 | $SiO_2$ | 173 | 149,9 | $Nb_2O_5$ |
| 81 | 81,9 | $Nb_2O_5$ | 174 | 23,5 | $SiO_2$ |
| 82 | 28,2 | $SiO_2$ | 175 | 6,7 | $Nb_2O_5$ |
| 83 | 112,8 | $Nb_2O_5$ | 176 | 258,3 | $SiO_2$ |
| 84 | 341,4 | $SiO_2$ | 177 | 51,8 | $Nb_2O_5$ |
| 85 | 19,3 | $Nb_2O_5$ | 178 | 102,8 | $SiO_2$ |
| 86 | 1,6 | $SiO_2$ | 179 | 14,1 | $Nb_2O_5$ |
| 87 | 259,9 | $Nb_2O_5$ | 180 | 3,8 | $SiO_2$ |
| 88 | 270,3 | $SiO_2$ | 181 | 70,3 | $Nb_2O_5$ |

(suite)

| Numéro de la couche | Épaisseur (en nm) | Matériau | Numéro de la couche | Épaisseur (en nm) | Matériau |
|---|---|---|---|---|---|
| 89 | 29,3 | $Nb_2O_5$ | 182 | 109,1 | $SiO_2$ |
| 90 | 4,2 | $SiO_2$ | 183 | 16,2 | $Nb_2O_5$ |
| 91 | 39,8 | $Nb_2O_5$ | 184 | 5,3 | $SiO_2$ |
| 92 | 14,1 | $SiO_2$ | 185 | 5220.3 | SiC |
| 93 | 139,1 | $Nb_2O_5$ | | | |

Un autre dispositif radiatif réfrigérant diurne déterminé par le procédé susmentionné avec comme valeur $\chi_{Rref} = 1$ et $\chi_{Aref} = 5$ présentait les valeurs $\chi_R$ et $\chi_A$ suivantes : $\chi_R = 0,265$ et $\chi_A = 2,814$. Les différentes couches de ce dispositif sont décrites dans le tableau suivant :

[Tableaux5]

| Numéro de la couche | Épaisseur (en nm) | Matériau | Numéro de la couche | Épaisseur (en nm) | Matériau |
|---|---|---|---|---|---|
| 1 | 201,3 | $Nb_2O_5$ | 94 | 46,5 | $SiO_2$ |
| 2 | 317,8 | $SiO_2$ | 95 | 4,5 | $Nb_2O_5$ |
| 3 | 219,3 | $Nb_2O_5$ | 96 | 7,7 | $SiO_2$ |
| 4 | 32,7 | $SiO_2$ | 97 | 13,3 | $Nb_2O_5$ |
| 5 | 25,2 | $Nb_2O_5$ | 98 | 166,3 | $SiO_2$ |
| 6 | 65,0 | $SiO_2$ | 99 | 19,9 | $Nb_2O_5$ |
| 7 | 77,5 | $Nb_2O_5$ | 100 | 10,3 | $SiO_2$ |
| 8 | 20,2 | $SiO_2$ | 101 | 91,1 | $Nb_2O_5$ |
| 9 | 24,0 | $Nb_2O_5$ | 102 | 118,3 | $SiO_2$ |
| 10 | 246,7 | $SiO_2$ | 103 | 125,6 | $Nb_2O_5$ |
| 11 | 92,4 | $Nb_2O_5$ | 104 | 22,2 | $SiO_2$ |
| 12 | 100,6 | $SiO_2$ | 105 | 10,9 | $Nb_2O_5$ |
| 13 | 72,5 | $Nb_2O_5$ | 106 | 66,9 | $SiO_2$ |
| 14 | 263,1 | $SiO_2$ | 107 | 121,9 | $Nb_2O_5$ |
| 15 | 565,8 | $Nb_2O_5$ | 108 | 276,1 | $SiO_2$ |
| 16 | 130,0 | $SiO_2$ | 109 | 127,3 | $Nb_2O_5$ |
| 17 | 227,3 | $Nb_2O_5$ | 110 | 122,6 | $SiO_2$ |
| 18 | 242,4 | $SiO_2$ | 111 | 1,6 | $Nb_2O_5$ |
| 19 | 51,6 | $Nb_2O_5$ | 112 | 5,6 | $SiO_2$ |
| 20 | 5,3 | $SiO_2$ | 113 | 10,5 | $Nb_2O_5$ |
| 21 | 238,5 | $Nb_2O_5$ | 114 | 12,0 | $SiO_2$ |
| 22 | 60,1 | $SiO_2$ | 115 | 9,1 | $Nb_2O_5$ |
| 23 | 3,0 | $Nb_2O_5$ | 116 | 40,6 | $SiO_2$ |
| 24 | 130,1 | $SiO_2$ | 117 | 76,0 | $Nb_2O_5$ |
| 25 | 78,0 | $Nb_2O_5$ | 118 | 250,5 | $SiO_2$ |
| 26 | 142,3 | $SiO_2$ | 119 | 102,7 | $Nb_2O_5$ |
| 27 | 127,9 | $Nb_2O_5$ | 120 | 55,3 | $SiO_2$ |
| 28 | 164,8 | $SiO_2$ | 121 | 38,9 | $Nb_2O_5$ |
| 29 | 44,7 | $Nb_2O_5$ | 122 | 146,6 | $SiO_2$ |

(suite)

| Numéro de la couche | Épaisseur (en nm) | Matériau | Numéro de la couche | Épaisseur (en nm) | Matériau |
|---|---|---|---|---|---|
| 30 | 64,6 | $SiO_2$ | 123 | 36,6 | $Nb_2O_5$ |
| 31 | 4,0 | $Nb_2O_5$ | 124 | 22,5 | $SiO_2$ |
| 32 | 81,3 | $SiO_2$ | 125 | 2,3 | $Nb_2O_5$ |
| 33 | 82,2 | $Nb_2O_5$ | 126 | 2,8 | $SiO_2$ |
| 34 | 20,5 | $SiO_2$ | 127 | 119,7 | $Nb_2O_5$ |
| 35 | 7,0 | $Nb_2O_5$ | 128 | 255,3 | $SiO_2$ |
| 36 | 98,8 | $SiO_2$ | 129 | 56,6 | $Nb_2O_5$ |
| 37 | 74,6 | $Nb_2O_5$ | 130 | 22,0 | $SiO_2$ |
| 38 | 38,1 | $SiO_2$ | 131 | 103,3 | $Nb_2O_5$ |
| 39 | 25,8 | $Nb_2O_5$ | 132 | 112,9 | $SiO_2$ |
| 40 | 28,7 | $SiO_2$ | 133 | 27,2 | $Nb_2O_5$ |
| 41 | 18,9 | $Nb_2O_5$ | 134 | 107,4 | $SiO_2$ |
| 42 | 2,4 | $SiO_2$ | 135 | 86,3 | $Nb_2O_5$ |
| 43 | 33,6 | $Nb_2O_5$ | 136 | 174,6 | $SiO_2$ |
| 44 | 13,5 | $SiO_2$ | 137 | 85,5 | $Nb_2O_5$ |
| 45 | 21,2 | $Nb_2O_5$ | 138 | 44,4 | $SiO_2$ |
| 46 | 248,7 | $SiO_2$ | 139 | 39,0 | $Nb_2O_5$ |
| 47 | 100,8 | $Nb_2O_5$ | 140 | 62,0 | $SiO_2$ |
| 48 | 40,7 | $SiO_2$ | 141 | 33,6 | $Nb_2O_5$ |
| 49 | 60,4 | $Nb_2O_5$ | 142 | 74,9 | $SiO_2$ |
| 50 | 55,1 | $SiO_2$ | 143 | 68,5 | $Nb_2O_5$ |
| 51 | 50,9 | $Nb_2O_5$ | 144 | 6,6 | $SiO_2$ |
| 52 | 113,3 | $SiO_2$ | 145 | 29,3 | $Nb_2O_5$ |
| 53 | 1,5 | $Nb_2O_5$ | 146 | 113,9 | $SiO_2$ |
| 54 | 196,5 | $SiO_2$ | 147 | 80,9 | $Nb_2O_5$ |
| 55 | 7,5 | $Nb_2O_5$ | 148 | 40,8 | $SiO_2$ |
| 56 | 4,2 | $SiO_2$ | 149 | 106,8 | $Nb_2O_5$ |
| 57 | 19,2 | $Nb_2O_5$ | 150 | 39,2 | $SiO_2$ |
| 58 | 3,2 | $SiO_2$ | 151 | 35,8 | $Nb_2O_5$ |
| 59 | 1,7 | $Nb_2O_5$ | 152 | 26,0 | $SiO_2$ |
| 60 | 59,4 | $SiO_2$ | 153 | 69,8 | $Nb_2O_5$ |
| 61 | 224,4 | $Nb_2O_5$ | 154 | 63,1 | $SiO_2$ |
| 62 | 306,3 | $SiO_2$ | 155 | 92,9 | $Nb_2O_5$ |
| 63 | 195,9 | $Nb_2O_5$ | 156 | 268,2 | $SiO_2$ |
| 64 | 6,0 | $SiO_2$ | 157 | 18,8 | $Nb_2O_5$ |
| 65 | 65,0 | $Nb_2O_5$ | 158 | 48,8 | $SiO_2$ |
| 66 | 160,5 | $SiO_2$ | 159 | 173,5 | $Nb_2O_5$ |
| 67 | 14,9 | $Nb_2O_5$ | 160 | 233,4 | $SiO_2$ |
| 68 | 32,4 | $SiO_2$ | 161 | 139,1 | $Nb_2O_5$ |

(suite)

| Numéro de la couche | Épaisseur (en nm) | Matériau | Numéro de la couche | Épaisseur (en nm) | Matériau |
|---|---|---|---|---|---|
| **69** | 1,8 | $Nb_2O_5$ | **162** | 192,4 | $SiO_2$ |
| **70** | 5,8 | $SiO_2$ | **163** | 38,4 | $Nb_2O_5$ |
| **71** | 20,7 | $Nb_2O_5$ | **164** | 15,0 | $SiO_2$ |
| **72** | 120,9 | $SiO_2$ | **165** | 4,5 | $Nb_2O_5$ |
| **73** | 159,4 | $Nb_2O_5$ | **166** | 116,3 | $SiO_2$ |
| **74** | 132,8 | $SiO_2$ | **167** | 40,0 | $Nb_2O_5$ |
| **75** | 119,2 | $Nb_2O_5$ | **168** | 2,1 | $SiO_2$ |
| **76** | 212,3 | $SiO_2$ | **169** | 142,4 | $Nb_2O_5$ |
| **77** | 60,5 | $Nb_2O_5$ | **170** | 13,1 | $SiO_2$ |
| **78** | 1,3 | $SiO_2$ | **171** | 36,2 | $Nb_2O_5$ |
| **79** | 103,9 | $Nb_2O_5$ | **172** | 180,4 | $SiO_2$ |
| **80** | 186,9 | $SiO_2$ | **173** | 132,2 | $Nb_2O_5$ |
| **81** | 68,1 | $Nb_2O_5$ | **174** | 19,8 | $SiO_2$ |
| **82** | 25,5 | $SiO_2$ | **175** | 7,4 | $Nb_2O_5$ |
| **83** | 134,8 | $Nb_2O_5$ | **176** | 207,1 | $SiO_2$ |
| **84** | 295,7 | $SiO_2$ | **177** | 61,4 | $Nb_2O_5$ |
| **85** | 15,6 | $Nb_2O_5$ | **178** | 82,7 | $SiO_2$ |
| **86** | 1,9 | $SiO_2$ | **179** | 11,5 | $Nb_2O_5$ |
| **87** | 253,5 | $Nb_2O_5$ | **180** | 3,6 | $SiO_2$ |
| **88** | 296,9 | $SiO_2$ | **181** | 81,8 | $Nb_2O_5$ |
| **89** | 34,4 | $Nb_2O_5$ | **182** | 90,6 | $SiO_2$ |
| **90** | 4,6 | $SiO_2$ | **183** | 16,9 | $Nb_2O_5$ |
| **91** | 34,8 | $Nb_2O_5$ | **184** | 6,0 | $SiO_2$ |
| **92** | 12,8 | $SiO_2$ | **185** | 4638,6 | SiC |
| **93** | 150,6 | $Nb_2O_5$ | | | |

Exemple 2 : Performances de réfrigération

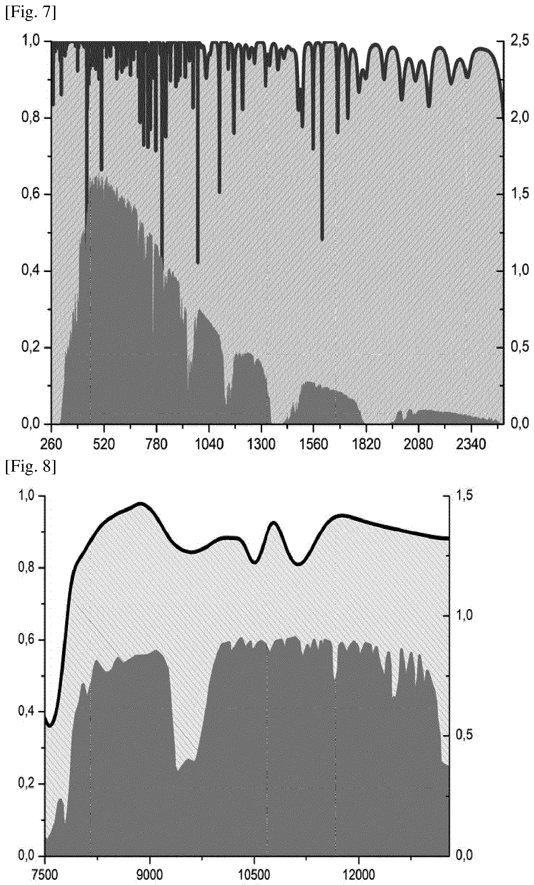

Cet exemple expose les performances théoriques totales de réflexion et d'émissivité et les spectres associés du premier dispositif radiatif diurne réfrigérant déterminé à l'exemple 1. Le spectre de réflexion des longueurs d'ondes de 260 nm à 2500 nm par le dispositif radiatif diurne est représenté à la [Fig.7]. La performance totale pour la réflexion de ces longueurs d'ondes est de 97,25% et est obtenu à l'aide de la formule suivante

[Math 38] :

$$R_{AM1,5} = 100.\frac{\int_{\lambda_{min}}^{\lambda_{max}} R(\lambda) L_{AM1,5}(\lambda) d\lambda}{\int_{\lambda_{min}}^{\lambda_{max}} L_{AM1,5}(\lambda) d\lambda}$$

où $\lambda_{max}$ est 2500 nm

$\lambda_{min}$ est 260 nm
R($\lambda$) est au coefficient de réflexion du dispositif radiatif diurne obtenu pour la longueur d'onde $\lambda$ $L_{AM1,5}(\lambda)d\lambda$ est la luminance énergétique du soleil en fonction de la longueur d'onde $\lambda$.

Le spectre d'émission des longueurs d'ondes de 7500 nm à 13300 nm par le dispositif radiatif diurne est représenté à la [Fig.8]. La performance totale pour l'émissivité de ces longueurs d'ondes est de 89,05% et est obtenu à l'aide de la formule suivante

$$[\text{Math 39}] : \quad \epsilon_{AM1,5} = 100.\frac{\int_{\lambda_{min}}^{\lambda_{max}} A(\lambda)\, T_{atm}(\lambda)\, d\lambda}{\int_{\lambda_{min}}^{\lambda_{max}} T_{atm}(\lambda)\, d\lambda}$$

où $\lambda_{max}$ est 13300 nm

$\lambda_{min}$ est 7500 nm

$A(\lambda)$ est la valeur d'absorptivité pour la longueur d'onde À en considérant qu'avec l'approximation de Kirchhoff à l'équilibre thermique : $\alpha$ (absorptivité) = $\varepsilon$ (émissivité)

$T_{atm}(\lambda)d\lambda$ est la transmittance atmosphérique en fonction de la longueur d'onde $\lambda$.

Le spectre de réflexion et d'émission des longueurs d'ondes de 260 nm à 15000 nm est donné à la [Fig.9]. On remarque de manière intéressante que le dispositif radiatif diurne de l'invention est très performant en termes de réflexion et d'émissivité des longueurs d'ondes dans les gammes considérées du spectre et peu performant, voire très peu performant (proche de 0), pour le reste du spectre. Cette configuration assure un bon échange thermique avec l'espace.

A partir des valeurs d'émissivité et réflexion du dispositif radiatif diurne, les inventeurs ont déterminé la température d'équilibre dudit dispositif dans les conditions idéales d'absence de conduction et de convection et sous un flux solaire de 1000,3 W.m$^{-2}$. Pour une température ambiante de 300K (26,85°C), la température d'équilibre du dispositif radiatif diurne théorique s'établit à 270.99K (-2,16°C), soit un écart de près de 30°C. A la même température ambiante, la valeur absolue de la puissance nette globale théorique dudit dispositif est de 109.7 W.m$^{-2}$. Cette valeur est exceptionnelle et correspond au plus du double de la puissance nette globale théorique (40W.m$^2$) atteinte avec le dispositif décrit dans le document A.P. Raman et al, Nature, 2014, 515, 540-544 cité dans l'introduction.

Exemple 3 : Protocole de fabrication d'un dispositif radiative réfrigérant

Le dépôt des différentes couches des dispositifs radiatifs réfrigérant présentés à l'exemple 1 est réalisé par pulvérisation cathodique magnétron avec suivi optique sur machine de pulvérisation cathodique ELETTRORAVA® (ER-SM800) avec un système Intellemetrics® (IL570) de réflectométrie installé à l'intérieur de la chambre de dépôt. Il est réalisé tout d'abord une simulation numérique du processus de fabrication de la structure à déposer à l'aide du logiciel Film maker de Intellemetrics®. Celle-ci permet de déterminer la configuration de suivi spectrophotométrique des échantillons lors de la croissance. Cette configuration permet d'établir la longueur d'onde à laquelle chaque couche d'un matériau sera contrôlée en réflexion, de prédire les points de retournement « turning point » pendant la croissance du film et de prévoir les conditions d'arrêt de chaque matériau.

Il est réalisé ensuite la préparation du substrat par voie chimique, dans le but de s'affranchir de tous défauts, au départ de la croissance du film mince. Un traitement chimique à base d'acide fluorhydrique de concentration 5% durant 30 secondes est effectué. Le substrat est rincé dans 3 bains d'eau ultra pure durant 1 minute chacun. Puis le substrat est séché sous un flux d'azote pur pour éliminer toutes trace d'eau.

Un substrat de Si est introduit dans la chambre de dépôt ou le vide indiqué est de 2 mTorr (1 mTorr = 0,133322 pascal). L'échantillon (substrat sur son porte substrat) sera placé à une température dont la gamme de mesure sera fixée entre 25°C et 200°C. Cette étape dure pendant une heure à la pression de 20 mtorr sous un flux d'argon de 10 sccm (« centimètre cubique standard par minute »), l'échantillon étant en rotation à 20 tours par minutes. On contrôle le niveau d'intensité lumineuse réfléchie par le substrat sur la gamme de longueurs d'ondes déterminée précédemment.

Il est procédé à l'initialisation d'allumage du plasma. Il est injecté en premier lieu une puissance de travail en plusieurs étapes sur la cathode avec une pression d'argon de 20mTorr. Cette pression est diminuée à 15mTorr puis à 10 mTorr pour finir par une pression de 5 mtorr toujours sous un flux de 10 sccm d'argon. Il est enfin atteint la stabilisation du plasma pour un dépôt de 3 à 5mTorr avec un mélange de gaz à base d'argon pour le premier film. Le mélange de gaz est modifié en fonction du matériau déposé :

- SiC : Argon 100%,
- SiO$_2$ : Argon/O$_2$ avec un ratio 75%/25%, et
- Nb$_2$O$_5$ : Argon/O$_2$ avec un ratio 75%/25%.

La première partie déposée est la partie émettrice en suivant l'alternance établie des matériaux B et C à l'exemple 1. Le suivi optique du film est réalisé en temps réel par une mesure de réflexion aux longueurs d'ondes établies précédemment. Le temps de dépôt est ajusté au cours du dépôt par le système de contrôle de croissance d'épaisseur par réflectométrie *in situ.* Lorsque la condition d'arrêt optique est atteinte pour un matériau B de l'émetteur, le dépôt de celui-ci est arrêté. Le matériau suivant C est démarré jusqu'à la condition d'arrêt de celui-ci. Ceci conduit à l'obtention de la structure émettrice finale.

La partie réflectrice est ensuite déposée sur la partie émettrice en suivant l'alternance établie des matériaux A et B à l'exemple 1. Durant cette étape, il est procédé à une mesure de réflexion aux longueurs d'ondes établies précédemment par le système Intellemetrics. Lorsque la condition d'arrêt optique est atteinte pour un matériau du réflecteur, le dépôt de celui-ci est arrêté. Le matériau suivant est démarré jusqu'à la condition d'arrêt de celui-ci, et ainsi de suite jusqu'au dépôt de l'ensemble des couches et l'obtention de la structure réflectrice.

Exemple 4 : Réalisation et performance d'un dispositif radiative réfrigérant

Dans cet exemple, il a été réalisé un dispositif radiatif diurne constitué d'une partie réflectrice présentant d'excellentes performances de réflexion dans la plage spectrale 250-1500nm et constituée d'une alternance de 72 couches de $SiO_2$ et $Nb_2O_5$. La figure de mérite des performances de réflexion cibles est représentée à la [Fig.18]. Les épaisseurs théoriques (représentées à la [Fig.19]) ont été obtenues par le procédé de détermination de la structure d'une partie réflectrice de l'invention sur la base de la figure de mérite.

Le dépôt des différentes couches a été réalisé avec le même outillage que celui décrit à l'exemple 3. Les étapes d'obtention du substrat et de stabilisation du plasma sont les mêmes que celles décrites dans l'exemple 3. Le substrat de Si avait une épaisseur de 275 $\mu$m.

Il a été utilisé une configuration confocale de cibles de 3 pouces de diamètre en $Nb_2$O5 et $SiO_2$. Les matériaux constitutifs des cibles ($Nb_2O_5$ et $SiO_2$) ont été pulvérisés au moyen d'un plasma Oxygène/Argon de 7/37 sccm respectivement pour les couches de $SiO_2$ et de 12/40 sccm respectivement pour les couches $Nb_2O_3$. La distance entre les cibles et le substrat de dépôt était de 20 cm. Il a été appliqué une puissance de 100W et de 325W respectivement pour la cible en $SiO_2$ et $Nb_2O_5$ ce qui correspond à une densité de puissance sur la cible en $SiO_2$ de 2,2 $W/cm^2$ et sur la cible en $Nb_2O_5$ de 7,7 $W/cm^2$. Les vitesses de dépôt des deux matériaux sont comprises entre 0,01 et 0,1 nm/ s. Enfin, la pression de dépôt était de 2 mtorr et la température du substrat était de 200 °C.

La réflectance spectrale du dispositif obtenu a été mesurée par un spectrophotomètre Lambda 1050 (Perkin Elmer®) muni d'un module « Universal Reflectance Accessy » (URA) avec un angle d'incidence de 8° et de la polarisation transverse électrique (TE). Le résultat obtenu est matérialisé par la [Fig.18] qui représente la réflectance mesurée par le module URA. Cette figure montre que le dispositif obtenu présente une réponse spectrale très proche de la réflectance théorique ciblée.

La [Fig.19] montre pour chaque couche d'une part l'épaisseur cible et d'autre part l'épaisseur expérimentale déterminée par la cinétique de dépôt des couches en tenant compte de la vitesse de dépôt et le temps de dépôt pour chaque couche. Les différences obtenues entre les épaisseurs cibles et les épaisseurs expérimentales étaient faibles avec une différence moyenne de 1,78 $\pm$ 0,85 %.

**Revendications**

1. Dispositif radiatif réfrigérant diurne comprenant une partie réflectrice des longueurs d'ondes de 260 nm à 2500 nm constituée d'une superposition alternée de couches A et de couches B, lesdites couches A étant constituées d'au moins un matériau A choisi parmi $Nb_2O_5$, $TiO_2$ et $Ta_2O_5$, lesdites couches B étant constituées d'au moins un matériau B choisi parmi $SiO_2$ et $Al_2O_3$, ladite partie réflectrice comprenant au moins 71 couches.

2. Dispositif selon la revendication 1, dans lequel chaque couche A et chaque couche B présente une épaisseur respective et indépendante de 1 à 1750 nm.

3. Dispositif selon l'une des revendication 1 ou 2, comprenant en outre une partie émettrice de longueurs d'ondes entre 7500 et 13300 nm comprenant au moins une couche C constituée d'un matériau C choisi parmi $SiO_2$, SiC, $TiO_2$, $Ta_2O_5$ et $Al_2O_3$, le matériau C étant différent du ou des matériaux A et du ou des matériaux B de la partie réflectrice, la partie réflectrice étant disposée sur la partie émettrice.

4. Dispositif selon la revendication 3, dans lequel la partie émettrice comprend au moins une superposition d'au moins une couche C et d'au moins une couche B, le matériau B et le matériau C choisis étant différents.

**5.** Dispositif selon la revendication 3 ou 4, la ou l'ensemble des couches C présente une épaisseur totale d'au moins 1,5 μm.

**6.** Dispositif selon l'une des revendications 1 à 5, dans lequel la structure de la partie réflectrice est déterminée par des moyens automatisés mettant en œuvre les étapes suivantes :

a) fourniture d'une structure de réflexion de base, ladite structure ayant une épaisseur et étant constituée d'au moins une couche A et/ou d'au moins d'une couche B, ladite couche A étant constituée d'un matériau A choisi parmi $Nb_2O_5$, $TiO_2$ et $Ta_2O_5$ et ladite couche B étant constituée d'un matériau B choisi parmi $SiO_2$ et $Al_2O_3$,

b) détermination d'une structure de réflexion améliorée au moyen des sous-étapes suivantes :

i. sélection d'une longueur onde dont la réflexion est à améliorer, ladite longueur d'onde étant sélectionnée parmi une gamme de longueurs d'ondes de réflexion de 260 nm à 2500 nm,

ii. sélection d'un matériau à insérer selon les critères suivants :

- ledit matériau à insérer est choisi parmi ceux du matériau B si la structure de réflexion de base est constituée d'une couche A,
- ledit matériau à insérer est choisi parmi ceux du matériau A si la structure de réflexion de base est constituée d'une couche B,
- ledit matériau à insérer est choisi parmi ceux du matériau A ou parmi ceux du matériau B dans tous les autres cas,

iii. détermination du nombre de nouvelles couches à insérer dans la structure de réflexion de base et de leur position au sein de la structure de réflexion de base, une nouvelle couche étant constituée dudit matériau à insérer et insérée selon l'épaisseur de la structure de réflexion de base,
ledit nombre et ladite position étant déterminés en fonction de la longueur d'onde sélectionnée et du matériau à insérer sélectionné,

iv. détermination de l'épaisseur de la ou de chaque nouvelle couche et obtention d'une structure de réflexion améliorée dans laquelle sont incorporées la ou les nouvelles couches,

c) détermination d'une valeur de performance de réflexion $\chi_R$ de la structure améliorée à l'aide la formule suivante [Math 2] :

$$\chi_R = \frac{1}{\sqrt{N}} \sqrt{\sum_{i=1}^{N} \frac{(R_{SRA}(\lambda_i) - R_{FM}(\lambda_i))^2}{tol^2}}$$

où

$\lambda_i$ est une longueur d'onde dans la gamme de longueurs d'ondes de réflexion,
N est le nombre de longueurs d'ondes spectrales dans la gamme de longueurs d'ondes de réflexion,
$R_{SRA}(\lambda_i)$ est le coefficient de réflexion obtenu pour la structure de réflexion améliorée à la longueur d'onde $\lambda_i$,
$R_{FM}(\lambda_i)$ est le coefficient de réflexion à atteindre à la longueur d'onde $\lambda_i$, et
tol a une valeur de 0,1,

d) si $\chi_R$ a une valeur inférieure ou égale à une valeur de référence $\chi_{Rref}$, détermination de la structure de réflexion améliorée comme correspondant à la partie réflectrice du dispositif radiatif diurne ; ou

si $\chi_R$ a une valeur supérieure à la valeur de référence $\chi_{Rref}$, répétition des étapes b) à d) en choisissant la structure de réflexion de base comme étant la structure de réflexion améliorée déterminée à l'étape b).

**7.** Dispositif selon l'une des revendications 3 à 6, dans lequel la structure de la partie émettrice est déterminée par des moyens automatisés mettant en œuvre les étapes suivantes :

a) fourniture d'une structure d'émissivité de base, ladite structure ayant une épaisseur et étant constituée d'au moins une couche C et/ou d'au moins une couche B, ladite couche C étant constituée d'un matériau C choisi parmi $SiO_2$, SiC, $TiO_2$, $Ta_2O_5$ et $Al_2O_3$ et ladite couche B étant constituée d'un matériau B choisi parmi $SiO_2$ et $Al_2O_3$, le matériau C étant différents du matériau B et différent du ou des matériaux A de la partie réflectrice,

b) détermination d'une structure d'émissivité améliorée au moyen des sous-étapes suivantes :

i. sélection d'une longueur onde dont la réflexion est à améliorer, ladite longueur d'onde étant sélectionnée parmi une gamme de longueurs d'ondes de réflexion de 7500 nm à 13300 nm,
ii. sélection d'un matériau à insérer selon les critères suivants :

- ledit matériau à insérer est choisi parmi ceux du matériau B si la structure d'émissivité de base est constituée d'une couche C,
- ledit matériau à insérer est choisi parmi ceux du matériau C si la structure d'émissivité de base est constituée d'une couche B,
- ledit matériau à insérer est choisi parmi ceux du matériau C ou parmi ceux du matériau B dans tous les autres cas,

iii. détermination du nombre de nouvelles couches à insérer dans la structure d'émission de base et de leur position au sein de la structure d'émissivité de base, une nouvelle couche étant constituée dudit matériau à insérer et insérée selon l'épaisseur de la structure d'émissivité de base,
ledit nombre et ladite position étant déterminés en fonction de la longueur d'onde sélectionnée et du matériau à insérer sélectionné,
iv. détermination de l'épaisseur de la ou de chaque nouvelle couche, et obtention d'une structure d'émissivité améliorée dans laquelle sont incorporées la ou les nouvelles couches,

c) détermination d'une valeur de performance d'absorption $\chi_A$ de la structure améliorée à l'aide la formule suivante [Math 37] :

$$\chi_A = \frac{1}{\sqrt{N}} \sqrt{\sum_{i=1}^{N} \frac{(A_{SEA}(\lambda_i) - A_{FM}(\lambda_i))^2}{tol^2}}$$

où

$\lambda_i$ est une longueur d'onde dans la gamme de longueurs d'ondes d'émission,
N est le nombre de longueurs d'ondes dans la gamme de longueurs d'ondes d'émission,
$A_{SRA}(\lambda_i)$ est le coefficient d'absorption obtenu pour la structure améliorée à la longueur d'onde spectrale $\lambda_i$,
$A_{FM}(\lambda_i)$ est le coefficient d'absorption à atteindre à la longueur d'onde spectrale $\lambda_i$, et
tol a une valeur de 0,1,

d) si $\chi_A$ a une valeur inférieure ou égale à une valeur de référence $\chi_{Aref}$, détermination de la structure d'émissivité améliorée comme correspondant à la partie émettrice du dispositif radiatif diurne ; ou

si $\chi_A$ a une valeur supérieure à la valeur de référence $\chi_{Aref}$, répétition des étapes b) à d) en choisissant la structure d'émissivité de base comme étant la structure d'émissivité améliorée déterminée à l'étape b).

8. Procédé de détermination de la structure de la partie réflectrice d'un dispositif radiatif réfrigérant diurne selon l'une des revendications 1 à 5, dans lequel des moyens automatisés mettent en œuvre les étapes suivantes :

a) fourniture d'une structure de réflexion de base, ladite structure ayant une épaisseur et étant constituée d'au moins une couche A et/ou d'au moins d'une couche B, ladite couche A étant constituée d'un matériau A choisi parmi $Nb_2O_5$, $TiO_2$ et $Ta_2O_5$ et ladite couche B étant constituée d'un matériau B choisi parmi $SiO_2$ et $Al_2O_3$,
b) détermination d'une structure de réflexion améliorée au moyen des sous-étapes suivantes :

i. sélection d'une longueur onde dont la réflexion est à améliorer, ladite longueur d'onde étant sélectionnée parmi une gamme de longueurs d'ondes de réflexion de 260 nm à 2500 nm,
ii. sélection d'un matériau à insérer selon les critères suivants :

- ledit matériau à insérer est choisi parmi ceux du matériau B si la structure de réflexion de base est constituée d'une couche A,
- ledit matériau à insérer est choisi parmi ceux du matériau A si la structure de réflexion de base est constituée d'une couche B,

- ledit matériau à insérer est choisi parmi ceux du matériau A ou parmi ceux du matériau B dans tous les autres cas,

iii. détermination du nombre de nouvelles couches à insérer dans la structure de réflexion de base et de leur position au sein de la structure de réflexion de base, une nouvelle couche étant constituée dudit matériau à insérer et insérée selon l'épaisseur de la structure de réflexion de base, ledit nombre et ladite position étant déterminés en fonction de la longueur d'onde sélectionnée et du matériau à insérer sélectionné,

iv. détermination de l'épaisseur de la ou de chaque nouvelle couche, et obtention d'une structure de réflexion améliorée dans laquelle sont incorporées la ou les nouvelles couches,

c) détermination d'une valeur de performance de réflexion $\chi_R$ de la structure améliorée à l'aide la formule suivante [Math 2] :

$$\chi_R = \frac{1}{\sqrt{N}} \sqrt{\sum_{i=1}^{N} \frac{(R_{SRA}(\lambda_i) - R_{FM}(\lambda_i))^2}{tol^2}}$$

où

$\lambda_i$ est une longueur d'onde dans la gamme de longueurs d'ondes de réflexion,

N est le nombre de longueurs d'ondes spectrales dans la gamme de longueurs d'ondes de réflexion,

$R_{SRA}(\lambda_i)$ est le coefficient de réflexion obtenue pour la structure de réflexion améliorée à la longueur d'onde spectrale $\lambda_i$,

$R_{FM}(\lambda_i)$ est le coefficient de réflexion à atteindre à la longueur d'onde $\lambda_i$, et

tol a une valeur de 0.1,

d) si $\chi_R$ a une valeur inférieure ou égale à une valeur de référence $\chi_{Rref}$, détermination de la structure de réflexion améliorée comme correspondant à la partie réflectrice du dispositif radiatif diurne ; ou

si $\chi_R$ a une valeur supérieure à la valeur de référence $\chi_{Rref}$, répétition des étapes b) à d) en choisissant la structure de réflexion de base comme étant la structure de réflexion améliorée déterminée à l'étape b).

**9.** Procédé de détermination de la partie émettrice d'un dispositif radiatif diurne selon l'une des revendications 3 à 5, dans lequel des moyens automatisés mettant en œuvre les étapes suivantes :

a) fourniture d'une structure d'émissivité de base, ladite structure ayant une épaisseur et étant constituée d'au moins une couche C et/ou d'au moins une couche B, ladite couche C étant constituée d'un matériau C choisi parmi $SiO_2$, SiC, $TiO_2$, $Ta_2O_5$ et $Al_2O_3$ et ladite couche B étant constituée d'un matériau B choisi parmi $SiO_2$ et $Al_2O_3$, le matériau C étant différents du matériau B,

b) détermination d'une structure d'émissivité améliorée au moyen des sous-étapes suivantes :

i. sélection d'une longueur onde dont la réflexion est à améliorer, ladite longueur d'onde étant sélectionnée parmi une gamme de longueurs d'ondes de réflexion de 7500 nm à 13300 nm,

ii. sélection d'un matériau à insérer selon les critères suivants :

- ledit matériau à insérer est choisi parmi ceux du matériau B si la structure d'émissivité de base est constituée d'une couche C,

- ledit matériau à insérer est choisi parmi ceux du matériau C si la structure d'émissivité de base est constituée d'une couche B,

- ledit matériau à insérer est choisi parmi ceux du matériau C ou parmi ceux du matériau B dans tous les autres cas,

iii. détermination du nombre de nouvelles couches à insérer dans la structure d'émission de base et de leur position au sein de la structure d'émissivité de base, une nouvelle couche étant constituée dudit matériau à insérer et insérée selon l'épaisseur de la structure d'émissivité de base,

ledit nombre et ladite position étant déterminés en fonction de la longueur d'onde sélectionnée et du matériau à insérer sélectionné,

iv. détermination de l'épaisseur de la ou de chaque nouvelle couche et obtention d'une structure d'émissivité améliorée dans laquelle sont incorporées la ou les nouvelles couches,

c) détermination d'une valeur de performance d'absorption $\chi_A$ de la structure améliorée à l'aide la formule suivante [Math 37] :

$$\chi_A = \frac{1}{\sqrt{N}} \sqrt{\sum_{i=1}^{N} \frac{(A_{SEA}(\lambda_i) - A_{FM}(\lambda_i))^2}{tol^2}}$$

où

$\lambda_i$ est une longueur d'onde dans la gamme de longueurs d'ondes d'émission,
N est le nombre de longueurs d'ondes dans la gamme de longueurs d'ondes d'émission,
$A_{SRA}(\lambda_i)$ est le coefficient d'absorption obtenu pour la structure améliorée à la longueur d'onde spectrale $\lambda_i$,
$A_{FM}(\lambda_i)$ est le coefficient d'absorption à atteindre à la longueur d'onde spectrale $\lambda_i$, et
tol a une valeur de 0,1,

d) si $\chi_A$ a une valeur inférieure ou égale à une valeur de référence $\chi_{Aref}$, détermination de la structure d'émissivité améliorée comme correspondant à la partie émettrice du dispositif radiatif diurne ; ou

si $\chi_A$ a une valeur supérieure à la valeur de référence $\chi_{Aref}$, répétition des étapes b) à d) en choisissant la structure d'émissivité de base comme étant la structure d'émissivité améliorée déterminée à l'étape b).

## Patentansprüche

1. Tageslicht-Strahlungskühlvorrichtung, die einen reflektierenden Teil der Wellenlängen von 260 nm bis 2500 nm umfasst, der aus einer abwechselnden Überlagerung von Schichten A und Schichten B besteht, wobei die Schichten A aus mindestens einem Material A bestehen, das aus $Nb_2O_5$, $TiO_2$ und $Ta_2O_5$ ausgewählt ist, wobei die Schichten B aus mindestens einem Material B bestehen, das aus $SiO_2$ und $Al_2O_3$ ausgewählt ist, wobei der reflektierende Teil mindestens 71 Schichten umfasst.

2. Vorrichtung nach Anspruch 1, wobei jede Schicht A und jede Schicht B eine jeweilige und unabhängige Dicke von 1 bis 1750 nm aufweist.

3. Vorrichtung nach einem der Ansprüche 1 oder 2, ferner umfassend einen Sendeteil für Wellenlängen zwischen 7500 und 13300 nm, der mindestens eine Schicht C umfasst, die aus einem Material C besteht, das aus $SiO_2$, $SiC$, $TiO_2$, $Ta_2O_5$ und $Al_2O_3$ ausgewählt ist, wobei das Material C sich von dem oder den Materialien A und dem oder den Materialien B des reflektierenden Teils unterscheidet, wobei der reflektierende Teil auf dem Sendeteil angeordnet ist.

4. Vorrichtung nach Anspruch 3, wobei der Sendeteil mindestens eine Überlagerung aus mindestens einer Schicht C und mindestens einer Schicht B umfasst, wobei das Material B und das Material C, die ausgewählt werden, unterschiedlich sind.

5. Vorrichtung nach Anspruch 3 oder 4, wobei die oder alle Schichten C eine Gesamtdicke von mindestens 1,5 $\mu$m aufweisen.

6. Vorrichtung nach einem der Ansprüche 1 bis 5, wobei die Struktur des reflektierenden Teils durch automatisierte Mittel bestimmt wird, die die folgenden Schritte durchführen:

a) Bereitstellen einer Basisreflexionsstruktur, wobei die Struktur eine Dicke aufweist und aus mindestens einer Schicht A und/oder aus mindestens einer Schicht B besteht, wobei die Schicht A aus einem Material A besteht, das aus $Nb_2O_5$, $TiO_2$ und $Ta_2O_5$ ausgewählt ist, und die Schicht B aus einem Material B besteht, das aus $SiO_2$ und $Al_2O_3$ ausgewählt ist,
b) Bestimmen einer verbesserten Reflexionsstruktur durch folgende Unterschritte:

i. Auswählen einer Wellenlänge, deren Reflexion zu verbessern ist, wobei die Wellenlänge aus einem Bereich von Reflexionswellenlängen von 260 nm bis 2500 nm ausgewählt ist,

ii. Auswählen eines einzufügenden Materials nach den folgenden Kriterien:

- das einzufügende Material ist aus denen vom Material B ausgewählt, wenn die Basisreflexionsstruktur aus einer Schicht A besteht,
- das einzufügende Material ist aus denen vom Material A ausgewählt, wenn die Basisreflexionsstruktur aus einer Schicht B besteht,
- das einzufügende Material ist in allen anderen Fällen aus denen vom Material A oder aus denen vom Material B ausgewählt,

iii. Bestimmen der Anzahl neuer Schichten, die in die Basisreflexionsstruktur eingefügt werden sollen, und ihrer Position innerhalb der Basisreflexionsstruktur, wobei eine neue Schicht aus dem einzufügenden Material besteht und entsprechend der Dicke der Basisreflexionsstruktur eingefügt wird, wobei die Anzahl und die Position in Abhängigkeit von der ausgewählten Wellenlänge und dem ausgewählten einzufügenden Material bestimmt werden,

iv. Bestimmen der Dicke der oder jeder neuen Schicht und Erzielen einer verbesserten Reflexionsstruktur, in die die neue(n) Schicht(en) eingearbeitet ist (sind),

c) Bestimmen eines Reflexionsleistungswertes $\chi_R$ der verbesserten Struktur mithilfe der folgenden Formel [Math 2]:

$$\chi_R = \frac{1}{\sqrt{N}} \sqrt{\sum_{i=1}^{N} \frac{\left(R_{SRA}(\lambda_i) - R_{FM}(\lambda_i)\right)^2}{tol^2}}$$

wobei

$\lambda_i$ eine Wellenlänge im Reflexionswellenlängenbereich ist,
N die Anzahl der spektralen Wellenlängen im Reflexionswellenlängenbereich ist,
$R_{SRA}(\lambda_i)$ der Reflexionskoeffizient ist, der für die verbesserte Reflexionsstruktur bei der Wellenlänge $\lambda_i$ ermittelt wurde,
$R_{FM}(\lambda_i)$ der bei der Wellenlänge $\lambda_i$ zu erreichende Reflexionskoeffizient ist, und
tol einen Wert von 0,1 aufweist,

d) wenn $\chi_R$ einen Wert aufweist, der kleiner oder gleich einem Referenzwert $\chi_{Rref}$ ist, Bestimmen der verbesserten Reflexionsstruktur entsprechend dem reflektierenden Teil der Tageslicht-Strahlungsvorrichtung; oder wenn $\chi_R$ einen Wert aufweist, der größer als der Referenzwert $\chi_{Rref}$ ist, Wiederholen der Schritte b) bis d) durch Auswählen der Basisreflexionsstruktur als die in Schritt b) bestimmte verbesserte Reflexionsstruktur.

7. Vorrichtung nach einem der Ansprüche 3 bis 6, wobei die Struktur des Sendeteils durch automatisierte Mittel bestimmt wird, die die folgenden Schritte durchführen:

a) Bereitstellen einer Basisemissivitätsstruktur, wobei die Struktur eine Dicke aufweist und aus mindestens einer Schicht C und/oder aus mindestens einer Schicht B besteht, wobei die Schicht C aus einem Material C besteht, das aus $SiO_2$, SiC, $TiO_2$, $Ta_2O_5$ und $Al_2O_3$ ausgewählt ist, und die Schicht B aus einem Material B besteht, das aus $SiO_2$ und $Al_2O_3$ ausgewählt ist, wobei sich das Material C vom Material B und von dem oder den Materialien A des reflektierenden Teils unterscheidet,
b) Bestimmen einer verbesserten Emissivitätsstruktur durch folgende Unterschritte:

i. Auswählen einer Wellenlänge, deren Reflexion zu verbessern ist, wobei die Wellenlänge aus einem Bereich von Reflexionswellenlängen von 7500 nm bis 13300 nm ausgewählt ist,
ii. Auswählen eines einzufügenden Materials nach den folgenden Kriterien:

- das einzufügende Material ist aus denen vom Material B ausgewählt, wenn die Basisemissivitätsstruktur aus einer Schicht C besteht,
- das einzufügende Material ist aus denen vom Material C ausgewählt, wenn die Basisemissivitätsstruktur aus einer Schicht B besteht,
- das einzufügende Material ist in allen anderen Fällen aus denen vom Material C oder aus denen vom Material B ausgewählt,

iii. Bestimmen der Anzahl der neuen Schichten, die in die Basisemissionsstruktur eingefügt werden sollen, und ihrer Position innerhalb der Basisemissivitätsstruktur, wobei eine neue Schicht aus dem einzufügenden Material besteht und entsprechend der Dicke der Basisemissivitätsstruktur eingefügt wird, wobei die Anzahl und die Position in Abhängigkeit von der ausgewählten Wellenlänge und dem ausgewählten einzufügenden Material bestimmt werden,

iv. Bestimmen der Dicke der oder jeder neuen Schicht und Erzielen einer verbesserten Emissivitätsstruktur, in die die neue(n) Schicht(en) eingearbeitet ist (sind),

c) Bestimmen eines Absorptionsleistungswertes $\chi_A$ der verbesserten Struktur mithilfe der folgenden Formel [Math 37]:

$$\chi_A = \frac{1}{\sqrt{N}}\sqrt{\sum_{i=1}^{N} \frac{\left(A_{SEA}(\lambda_i) - A_{FM}(\lambda_i)\right)^2}{tol^2}}$$

wobei

$\lambda_i$ eine Wellenlänge im Emissionswellenlängenbereich ist,
N die Anzahl der Wellenlängen im Emissionswellenlängenbereich ist,
$A_{SRA}(\lambda_i)$ der Absorptionskoeffizient ist, der für die verbesserte Struktur bei der spektralen Wellenlänge $\lambda_i$ ermittelt wurde,
$A_{FM}(\lambda_i)$ der bei der spektralen Wellenlänge $\lambda_i$ zu erreichende Absorptionskoeffizient ist, und
tol einen Wert von 0,1 aufweist,

d) wenn $\chi_A$ einen Wert aufweist, der kleiner oder gleich einem Referenzwert $\chi_{Aref}$ ist, Bestimmen der verbesserten Emissivitätsstruktur entsprechend dem Sendeteil der Tageslicht-Strahlungsvorrichtung; oder

wenn $\chi_A$ einen Wert aufweist, der größer als der Referenzwert $\chi_{Aref}$ ist, Wiederholen der Schritte b) bis d) durch Auswählen der Basisemissivitätsstruktur als die in Schritt b) bestimmte verbesserte Emissivitätsstruktur.

8. Verfahren zum Bestimmen der Struktur des reflektierenden Teils einer Tageslicht-Strahlungskühlvorrichtung nach einem der Ansprüche 1 bis 5, wobei automatisierte Mittel die folgenden Schritte durchführen:

a) Bereitstellen einer Basisreflexionsstruktur, wobei die Struktur eine Dicke aufweist und aus mindestens einer Schicht A und/oder aus mindestens einer Schicht B besteht, wobei die Schicht A aus einem Material A besteht, das aus $Nb_2O_5$, $TiO_2$ und $Ta_2O$ ausgewählt ist, und die Schicht B aus einem Material B besteht, das aus $SiO_2$ und $Al_2O_3$ ausgewählt ist,

b) Bestimmen einer verbesserten Reflexionsstruktur durch folgende Unterschritte:

i. Auswählen einer Wellenlänge, deren Reflexion zu verbessern ist, wobei die Wellenlänge aus einem Bereich von Reflexionswellenlängen von 260 nm bis 2500 nm ausgewählt ist,

ii. Auswählen eines einzufügenden Materials nach den folgenden Kriterien:

- das einzufügende Material ist aus denen vom Material B ausgewählt, wenn die Basisreflexionsstruktur aus einer Schicht A besteht,
- das einzufügende Material ist aus denen vom Material A ausgewählt, wenn die Basisreflexionsstruktur aus einer Schicht B besteht,
- das einzufügende Material ist in allen anderen Fällen aus denen vom Material A oder aus denen vom Material B ausgewählt,

iii. Bestimmen der Anzahl neuer Schichten, die in die Basisreflexionsstruktur eingefügt werden sollen, und ihrer Position innerhalb der Basisreflexionsstruktur, wobei eine neue Schicht aus dem einzufügenden Material besteht und entsprechend der Dicke der Basisreflexionsstruktur eingefügt wird, wobei die Anzahl und die Position in Abhängigkeit von der ausgewählten Wellenlänge und dem ausgewählten einzufügenden Material bestimmt werden,

iv. Bestimmen der Dicke der oder jeder neuen Schicht und Erzielen einer verbesserten Reflexionsstruktur, in die die neue(n) Schicht(en) eingearbeitet ist (sind),

c) Bestimmen eines Reflexionsleistungswertes $\chi_R$ der verbesserten Struktur mithilfe der folgenden Formel [Math 2]:

$$\chi_R = \frac{1}{\sqrt{N}}\sqrt{\sum_{i=1}^{N} \frac{\left(R_{SRA}(\lambda_i) - R_{FM}(\lambda_i)\right)^2}{tol^2}}$$

wobei

$\lambda_i$ eine Wellenlänge im Reflexionswellenlängenbereich ist,
N die Anzahl der spektralen Wellenlängen im Reflexionswellenlängenbereich ist,
$R_{SRA}(\lambda_i)$ der Reflexionskoeffizient ist, der für die verbesserte Reflexionsstruktur bei der spektralen Wellenlänge $\lambda_i$ ermittelt wurde,
$R_{FM}(\lambda_i)$ der bei der Wellenlänge $\lambda_i$ zu erreichende Reflexionskoeffizient ist,
und
tol einen Wert von 0,1 aufweist,

d) wenn $\chi_R$ einen Wert aufweist, der kleiner oder gleich einem Referenzwert $\chi_{Rref}$ ist, Bestimmen der verbesserten Reflexionsstruktur, die dem reflektierenden Teil der Tageslicht-Strahlungsvorrichtung entspricht; oder

wenn $\chi_R$ einen Wert aufweist, der größer als der Referenzwert $\chi_{Rref}$ ist, Wiederholen der Schritte b) bis d) durch Auswählen der Basisreflexionsstruktur als die in Schritt b) bestimmte verbesserte Reflexionsstruktur.

9. Verfahren zum Bestimmen des Sendeteils einer Tageslicht-Strahlungsvorrichtung nach einem der Ansprüche 3 bis 5, wobei automatisierte Mittel die folgenden Schritte durchführen:

a) Bereitstellen einer Basisemissivitätsstruktur, wobei die Struktur eine Dicke aufweist und aus mindestens einer Schicht C und/oder aus mindestens einer Schicht B besteht, wobei die Schicht C aus einem Material C besteht, das aus $SiO_2$, SiC, $TiO_2$, $Ta_2O_5$ und $Al_2O_3$ ausgewählt ist, und die Schicht B aus einem Material B besteht, das aus $SiO_2$ und $Al_2O_3$ ausgewählt ist, wobei sich das Material C vom Material B unterscheidet,
b) Bestimmen einer verbesserten Emissivitätsstruktur durch folgende Unterschritte:

i. Auswählen einer Wellenlänge, deren Reflexion zu verbessern ist, wobei die Wellenlänge aus einem Bereich von Reflexionswellenlängen von 7500 nm bis 13300 nm ausgewählt ist,
ii. Auswählen eines einzufügenden Materials nach den folgenden Kriterien:

- das einzufügende Material ist aus denen vom Material B ausgewählt, wenn die Basisemissivitätsstruktur aus einer Schicht C besteht,
- das einzufügende Material ist aus denen vom Material C ausgewählt, wenn die Basisemissivitätsstruktur aus einer Schicht B besteht,
- das einzufügende Material ist in allen anderen Fällen aus denen vom Material C oder aus denen vom Material B ausgewählt,

iii. Bestimmen der Anzahl der neuen Schichten, die in die Basisemissionsstruktur eingefügt werden sollen, und ihrer Position innerhalb der Basisemissivitätsstruktur, wobei eine neue Schicht aus dem einzufügenden Material besteht und entsprechend der Dicke der Basisemissivitätsstruktur eingefügt wird, wobei die Anzahl und die Position in Abhängigkeit von der ausgewählten Wellenlänge und dem ausgewählten einzufügenden Material bestimmt werden,
iv. Bestimmen der Dicke der oder jeder neuen Schicht und Erzielen einer verbesserten Emissivitätsstruktur, in die die neue(n) Schicht(en) eingearbeitet ist (sind),

c) Bestimmen eines Absorptionsleistungswertes $\chi_A$ der verbesserten Struktur mithilfe der folgenden Formel [Math 37]:

$$\chi_A = \frac{1}{\sqrt{N}}\sqrt{\sum_{i=1}^{N} \frac{\left(A_{SEA}(\lambda_i) - A_{FM}(\lambda_i)\right)^2}{tol^2}}$$

wobei

$\lambda_i$ eine Wellenlänge im Emissionswellenlängenbereich ist,
N die Anzahl der Wellenlängen im Emissionswellenlängenbereich ist,
$A_{SRA}(\lambda_i)$ der Absorptionskoeffizient ist, der für die verbesserte Struktur bei der spektralen Wellenlänge $\lambda_i$ ermittelt wurde,
$A_{FM}(\lambda_i)$ der bei der spektralen Wellenlänge $\lambda_i$ zu erreichende Absorptionskoeffizient ist, und
tol einen Wert von 0,1 aufweist,

d) wenn $\chi_A$ einen Wert aufweist, der kleiner oder gleich einem Referenzwert $\chi_{Aref}$ ist, Bestimmen der verbesserten Emissivitätsstruktur entsprechend dem Sendeteil der Tageslicht-Strahlungsvorrichtung; oder

wenn $\chi_A$ einen Wert aufweist, der größer als der Referenzwert $\chi_{Aref}$ ist, Wiederholen der Schritte b) bis d) durch Auswählen der Basisemissivitätsstruktur als die in Schritt b) bestimmte verbesserte Emissivitätsstruktur.

## Claims

1. A daytime radiative cooling device comprising a reflective portion for the wavelengths from 260 nm to 2,500 nm consisting of an alternating superposition of layers A and of layers B, said layers A consisting of at least one material A selected from among $Nb_2O_5$, $TiO_2$ and $Ta_2O_5$, said layers B consisting of at least one material B selected from among $SiO_2$ and $Al_2O_3$, said reflective portion comprising at least 71 layers.

2. The device according to claim 1, wherein each layer A and each layer B has a respective and independent thickness from 1 to 1,750 nm.

3. The device according to one of claims 1 to 2, further comprising a emitting portion of wavelengths from 7,500 to 13,300 nm comprising at least one layer C consisting of a material C selected from among $Nb_2O_5$, $SiO_2$, SiC, $TiO_2$, $Ta_2O_5$ and $Al_2O_3$, the material C being different from the material(s) A and the material(s) B of the reflective portion, the reflective portion being arranged on the emitting portion.

4. The device according to Claim 3, wherein the emitting portion comprises at least one superposition of at least one layer C and of at least one layer B, the selected material B and material C being different.

5. The device according to claim 3 or 4, wherein all of the layers C have a total thickness of at least 1.5 $\mu$m.

6. The device according to one of claims 1 to 5, wherein the structure of the reflective portion is determined by automated means implementing the following steps:

a) providing a base reflection structure, said structure having a thickness and consisting of at least one layer A and/or of at least one layer B, said layer A consisting of a material A selected from among $Nb_2O_5$, $TiO_2$ and $Ta_2O_5$ and said layer B consisting of a material B selected from among $SiO_2$ and $Al_2O_3$,
b) determining an improved reflection structure by means of the following substeps:

i. selecting a wavelength whose reflection is to be improved, said wavelength being selected from a range of reflection wavelengths from 260 nm to 2,500 nm,
ii. selecting a material to be inserted according to the following criteria:

- said material to be inserted is selected from among those of the material B if the base reflection structure consists of a layer A,
- said material to be inserted is selected from among those of the material A if the base reflection structure consists of a layer B,
- said material to be inserted is selected from among those of the material A or from those of the material B in all other cases,

iii. determining the number of new layers to be inserted into the base reflection structure and their position within the base reflection structure, a new layer consisting of said material to be inserted and inserted according to the thickness of the base reflection structure,
said number and said position being determined according to the selected wavelength and the selected material to be inserted,
iv. determining the thickness of the or each new layer and obtaining an improved reflection structure in which the new layer(s) is/are incorporated,

c) determining a reflection performance value $\chi_R$ of the improved structure using the following formula

[Math 2]

$$\chi_R = \frac{1}{\sqrt{N}} \sqrt{\sum_{i=1}^{N} \frac{(R_{SRA}(\lambda_i) - R_{FM}(\lambda_i))^2}{tol^2}}$$

where

$\lambda_i$ is a wavelength in the range of reflection wavelengths,
N is the number of spectral wavelengths in the range of reflection wavelengths,
$R_{SRA}(\lambda_i)$ is the coefficient of reflection obtained for the improved reflection structure at the wavelength $\lambda_i$,
$R_{FM}(\lambda_i)$ is the coefficient of reflection to be reached at the wavelength $\lambda_i$, and
tol has a value of 0.1,

d) if $\chi_R$ has a value lower than or equal to a reference value $\chi_{Rref}$, determining the improved reflection structure as corresponding to the reflective portion of the daytime radiative device; or

if $\chi_R$ has a value higher than the reference value $\chi_{Rref}$, repeating steps b) to d) while selecting the base reflection structure as being the improved reflection structure determined in step b).

7. The device according to one of claims 3 to 6, wherein the structure of the emitting portion is determined by automated means implementing the following steps:

a) providing a base emissivity structure, said structure having a thickness and consisting of at least one layer C and/or of at least one layer B, said layer C consisting of a material C selected from among $Nb_2O_5$, $SiO_2$, SiC, $TiO_2$, $Ta_2O_5$ and $Al_2O_3$ and said layer B consisting of a material B selected from among $SiO_2$ and $Al_2O_3$, the material C being different from the material B and different from the material(s) A of the reflective portion,
b) determining an improved emissivity structure by means of the following substeps:

i. selecting a wavelength whose reflection is to be improved, said wavelength being selected from a range of reflection wavelengths from 7,500 nm to 13,300 nm,
ii. selecting a material to be inserted according to the following criteria:

- said material to be inserted is selected from among those of the material B if the base emissivity structure consists of a layer C,
- said material to be inserted is selected from among those of the material C if the base emissivity structure consists of a layer B,
- said material to be inserted is selected from among those of the material C or from those of the material B in all other cases,

iii. determining the number of new layers to be inserted into the base emission structure and their position within the base emissivity structure, a new layer consisting of said material to be inserted and inserted according to the thickness of the base emissivity structure,
said number and said position being determined according to the selected wavelength and the selected material to be inserted,
iv. determining the thickness of the or each new layer, and obtaining an improved emissivity structure in which the new layer(s) is/are incorporated,

c) determining an absorption performance value $\chi_A$ of the improved structure using the following formula

[Math 37]

$$\chi_A = \frac{1}{\sqrt{N}} \sqrt{\sum_{i=1}^{N} \frac{(A_{SEA}(\lambda_i) - A_{FM}(\lambda_i))^2}{tol^2}}$$

where

$\lambda_i$ is a wavelength in the emission wavelength range,
N is the number of wavelengths in the emission wavelength range,
$A_{SRA}(\lambda_i)$ is the coefficient of absorption obtained for the improved structure at the spectral wavelength $\lambda_i$,
$A_{FM}(\lambda_i)$ is the coefficient of absorption to be reached at the spectral wavelength $\lambda_i$, and
tol has a value of 0.1,

d) if $\chi_A$ has a value lower than or equal to a reference value $\chi_{Aref}$, determining the improved emissivity structure as corresponding to the emitting portion of the daytime radiative device; or

if $\chi_A$ has a value higher than the reference value $\chi_{Aref}$, repeating steps b) to d) while selecting the base emissivity structure as being the improved emissivity structure determined in step b).

8. A method for determining the structure of the reflective portion of a daytime radiative cooling device according to one of claims 1 to 5, wherein automated means implement the following steps:

a) providing a base reflection structure, said structure having a thickness and consisting of at least one layer A and/or of at least one layer B, said layer A consisting of a material A selected from among $Nb_2O_5$, $TiO_2$ and $Ta_2O_5$ and said layer B consisting of a material B selected from among $SiO_2$ and $Al_2O_3$,
b) determining an improved reflection structure by means of the following substeps:

i. selecting a wavelength whose reflection is to be improved, said wavelength being selected from a range of reflection wavelengths from 260 nm to 2,500 nm,
ii. selecting a material to be inserted according to the following criteria:

- said material to be inserted is selected from among those of the material B if the base reflection structure consists of a layer A,
- said material to be inserted is selected from among those of the material A if the base reflection structure consists of a layer B,
- said material to be inserted is selected from among those of the material A or from those of the material B in all other cases,

iii. determining the number of new layers to be inserted into the base reflection structure and their position within the base reflection structure, a new layer consisting of said material to be inserted and inserted according to the thickness of the base reflection structure,
said number and said position being determined according to the selected wavelength and the selected material to be inserted,
iv. determining the thickness of the or each new layer, and obtaining an improved reflection structure in which the new layer(s) is/are incorporated,

c) determining a reflection performance value $\chi_R$ of the improved structure using the following formula

[Math 2]

$$\chi_R = \frac{1}{\sqrt{N}} \sqrt{\sum_{i=1}^{N} \frac{(R_{SRA}(\lambda_i) - R_{FM}(\lambda_i))^2}{tol^2}}$$

where

$\lambda_i$ is a wavelength in the range of reflection wavelengths,

N is the number of spectral wavelengths in the range of reflection wavelengths,

$R_{SRA}(\lambda_i)$ is the coefficient of reflection obtained for the improved reflection structure at the spectral wavelength $\lambda_i$,

$R_{FM}(\lambda_i)$ is the coefficient of reflection to be reached at the wavelength $\lambda_i$, and

tol has a value of 0.1,

d) if $\chi_R$ has a value lower than or equal to a reference value $\chi_{Rref}$, determining the improved reflection structure as corresponding to the reflective portion of the daytime radiative device; or

if $\chi_R$ has a value higher than the reference value $\chi_{Rref}$, repeating steps b) to d) while selecting the base reflection structure as being the improved reflection structure determined in step b).

9. A method for determining the emitting portion of a daytime radiative device according to one of claims 3 to 5, wherein automated means implementing the following steps:

a) providing a base emissivity structure, said structure having a thickness and consisting of at least one layer C and/or of at least one layer B, said layer C consisting of a material C selected from among $Nb_2O_5$, $SiO_2$, SiC, $TiO_2$, $Ta_2O_5$ and $Al_2O_3$ and said layer B consisting of a material B selected from among $SiO_2$ and $Al_2O_3$, the material C being different from the material B,

b) determining an improved emissivity structure by means of the following substeps:

i. selecting a wavelength whose reflection is to be improved, said wavelength being selected from a range of reflection wavelengths from 7,500 nm to 13,300 nm,

ii. selecting a material to be inserted according to the following criteria:

- said material to be inserted is selected from among those of the material B if the base emissivity structure consists of a layer C,

- said material to be inserted is selected from among those of the material C if the base emissivity structure consists of a layer B,

- said material to be inserted is selected from among those of the material C or from those of the material B in all other cases,

iii. determining the number of new layers to be inserted into the base emission structure and their position within the base emissivity structure, a new layer consisting of said material to be inserted and inserted according to the thickness of the base emissivity structure,

said number and said position being determined according to the selected wavelength and the selected material to be inserted,

iv. determining the thickness of the or each new layer and obtaining an improved emissivity structure in which the new layer(s) is/are incorporated,

c) determining an absorption performance value $\chi_A$ of the improved structure using the following formula [Math 37]:

$$\chi_A = \frac{1}{\sqrt{N}}\sqrt{\sum_{i=1}^{N}\frac{(A_{SEA}(\lambda_i)-A_{FM}(\lambda_i))^2}{tol^2}}$$

where

$\lambda_i$ is a wavelength in the emission wavelength range, N is the number of wavelengths in the emission wavelength range,
$A_{SRA}(\lambda_i)$ is the coefficient of absorption obtained for the improved structure at the spectral wavelength $\lambda_i$,
$A_{FM}(\lambda_i)$ is the coefficient of absorption to be reached at the spectral wavelength $\lambda_i$, and
tol has a value of 0.1,

d) if $\chi_A$ has a value lower than or equal to a reference value $\chi_{Aref}$, determining the improved emissivity structure as corresponding to the emitting portion of the daytime radiative device; or

if $\chi_A$ has a value higher than the reference value $\chi_{Aref}$, repeating steps b) to d) while selecting the base emissivity structure as being the improved emissivity structure determined in step b).

[Fig. 1]

[Fig. 2]

[Fig. 3]

[Fig. 4]

[Fig. 5]

[Fig. 6]

[Fig. 7]

[Fig. 8]

[Fig. 9]

[Fig. 10]

[Fig. 11]

[Fig. 12a]

[Fig. 12b]

[Fig. 13a]

[Fig. 13b]

[Fig. 14a]

[Fig. 14b]

[Fig. 15a]

[Fig. 15b]

[Fig. 16]

[Fig. 17]

[Fig. 18]

[Fig. 19]

**EP 4 347 522 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- CN 110274326 B
- US 2015338175 A1
- WO 2019130199 A1

### Littérature non-brevet citée dans la description

- **A.P. RAMAN et al.** *Nature*, 2014, vol. 515, 540-544
- **GENTLE et al.** *Nano Lett.*, 2010, vol. 10, 373-379
- **ZHAI et al.** *Science*, 2017, vol. 355, 1062-1066
- **POCHI YEH**. Optical Waves in Layered Media. Wiley, 2005
- **A. V. TIKHONRAVOV**. Astronomiya. Vestn. Mosk. Univ. Fiz., 1982, vol. 23, 91-93
- **K. DEB** ; **R. B. AGRAWAL**. *Academic*, 1995, 115-148
- **MOURAD SEFRIOUI**. PhD thesis. Université Pierre et Marie Curie, April 1998
- **R. NUMICO** ; **A. KELLER** ; **O. ATABEK**. *Phys. Rev. A*, 1995, vol. 52, 1298
- Numerical Recipes in Fortran. W.H. Press, vol. 77, 402-406
- *Numerical recipes in fortran*, vol. 77